(19) Europäisches Patentamt
European Patent Office
Office européen des brevets

(11) EP 3 203 541 B1

(12) **EUROPEAN PATENT SPECIFICATION**

(45) Date of publication and mention of the grant of the patent:
**06.07.2022 Bulletin 2022/27**

(21) Application number: **15847747.1**

(22) Date of filing: **31.08.2015**

(51) International Patent Classification (IPC):
***H01L 51/30*** $^{(2006.01)}$ ***H01L 51/40*** $^{(2006.01)}$

(52) Cooperative Patent Classification (CPC):
**H01L 51/0071; C09D 11/322; C09D 11/52; H01L 51/0007; H01L 51/0068; H01L 51/0074;** H01L 51/0558

(86) International application number:
**PCT/JP2015/074801**

(87) International publication number:
**WO 2016/052056 (07.04.2016 Gazette 2016/14)**

(54) **ORGANIC SEMICONDUCTOR COMPOSITION**

ORGANISCHE HALBLEITERZUSAMMENSETZUNG

COMPOSITION SEMICONDUCTRICE ORGANIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **29.09.2014 JP 2014198914**

(43) Date of publication of application:
**09.08.2017 Bulletin 2017/32**

(73) Proprietor: **FUJIFILM Corporation**
**Tokyo 106-8620 (JP)**

(72) Inventors:
- **SHIGENOI Yuta**
**Kanagawa 258-8577 (JP)**
- **MASUI Kensuke**
**Kanagawa 258-8577 (JP)**

(74) Representative: **Hoffmann Eitle**
**Patent- und Rechtsanwälte PartmbB**
**Arabellastraße 30**
**81925 München (DE)**

(56) References cited:
**WO-A1-2011/076325**
**WO-A1-2014/034392**
**WO-A1-2014/061465**
**WO-A1-2014/119713**
**WO-A1-2014/123214**
**WO-A1-2014/123215**
**WO-A1-2014/136436**
**JP-A- 2013 533 606**
**JP-A- 2015 029 020**
**US-A1- 2013 069 020**

- **Anonymous: "N-Methyl-2-Pyrrolidone (NMP) | TDS | Eastman Chemical Company", , 16 August 2017 (2017-08-16), XP055399134, Retrieved from the Internet: URL:http://ws.eastman.com/ProductCatalogApps/PageControllers/ProdDatasheet_PC.aspx?product=71103627 [retrieved on 2017-08-16]**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 203 541 B1

## Description

The present invention relates to an organic semiconductor composition.

2. Description of the Related Art

An organic transistor having an organic semiconductor film (organic semiconductor layer) is used in a field effect transistor (FET) used in a liquid crystal display or an organic EL display, a Radio Frequency Identifier (RFID, RF tag), because the use of the organic transistor makes it possible to achieve lightening of weight and cost reduction and to achieve flexibilization.

As an organic semiconductor composition, for example, the composition described in JP2005-514726A is known.

Relevant prior art is as follows: WO 2014/136436 A1 discloses an organic thin film transistor wherein: a channel section is provided between a source electrode and a drain electrode, said channel section being configured from an organic semiconductor layer containing an organic semiconductor material; the channel section contains a planar organic semiconductor crystal having an average surface roughness (Ra) of 2 nm or less per 5 square μm; and the film thickness of the planar organic semiconductor crystal is 40 nm or less.

An object of the present invention is to provide an organic semiconductor composition from which an organic semiconductor having excellent mobility and temporal stability is obtained.

According to the present invention, it is possible to provide an organic semiconductor composition from which an organic semiconductor having excellent mobility and temporal stability is obtained.

BRIEF DESCRIPTION OF THE DRAWINGS

Fig. 1 is a schematic cross-sectional view of an aspect of an organic semiconductor element of the present invention.
Fig. 2 is a schematic cross-sectional view of another aspect of the organic semiconductor element of the present invention.

Hereinafter, the contents of the present invention will be specifically described. The constituents in the following description will be explained based on typical embodiments of the present invention, but the present invention is not limited to the embodiments. In the specification of the present application, "to" is used to mean that the numerical values listed before and after "to" are a lower limit and an upper limit respectively. Furthermore, in the present invention, an organic EL element refers to an organic electroluminescence element.

In the present specification, in a case where there is no description regarding whether a group (atomic group) is substituted or unsubstituted, the group includes both of a group having a substituent and a group not having a substituent. For example, an "alkyl group" includes not only an alkyl group not having a substituent (unsubstituted alkyl group) but also an alkyl group having a substituent (substituted alkyl group).

In the present specification, in some cases, a chemical structural formula is described as a simplified structural formula in which a hydrogen atom is omitted.

In the present invention, "mobility" refers to "carrier mobility" and means either of both of electron mobility and hole mobility.

In the present invention, "% by mass" and "% by weight" have the same definition, and "part by mass" and "part by weight" have the same definition.

In the present invention, a combination of two or more preferred aspects is a more preferred aspect.

(Organic semiconductor composition)

An organic semiconductor composition (hereinafter, simply referred to as a "composition" as well) of the present invention has a condensed polycyclic aromatic group, in which the number of rings in the condensed polycyclic aromatic group is equal to or greater than 4, at least two rings in the condensed polycyclic aromatic group contain at least one atom selected from the group consisting of a sulfur atom, a nitrogen atom, a selenium atom, and an oxygen atom, and the condensed polycyclic aromatic group contains, as a partial structure, an organic semiconductor having at least any one structure selected from the group consisting of a benzene ring, a naphthalene ring, and a phenanthrene ring, an organic solvent A, an organic solvent B, a surfactant having an organic siloxane moiety represented by $-O-SiR^1R^2$, and in a case where an SP value of the organic solvent A is denoted by SP(A) and an SP value of the organic solvent B is denoted by SP(B), $SP(B) - SP(A) \geq 2\ MPa^{1/2}$ is satisfied, and wherein a content of the surfactant is 0.1 to 10 parts by

mass with respect to a content of 100 parts by mass of the organic semiconductor.

Here, $R^1$ and $R^2$ each independently represent a monovalent hydrocarbon group not containing an ether bond.

As a result of repeating intensive examination, the inventors of the present invention found that, if the composition contains the aforementioned organic semiconductor, two kinds of specific organic solvents, and the aforementioned surfactant, an organic semiconductor having excellent mobility and temporal stability is obtained, and achieved the present invention.

The detailed mechanism that brings about the aforementioned effect is unclear, but is assumed to be as below. Presumably, when forming a layer or a film of the organic semiconductor, the two kinds of specific solvents and the surfactant may cooperate with each other in a certain way, an organic semiconductor having excellent mobility and temporal stability may be obtained.

Hereinafter, each of the components of the organic semiconductor composition of the present invention will be specifically described.

<Organic solvent A and organic solvent B>

The organic semiconductor composition of the present invention contains an organic solvent A and an organic solvent B. In a case where an SP value of the organic solvent A is denoted by SP(A), and an SP value of the organic solvent B is denoted by SP(B), SP(B) - SP(A) $\geq$ 2 $MPa^{1/2}$ is satisfied. In the present invention, "$MPa^{1/2}$" as the unit of the SP value has the same definition as "$(MPa)^{1/2}$.

The SP value of the organic solvent B is greater than the SP value of the organic solvent A, and a difference in the SP value between the organic solvent A and the organic solvent B (SP(B) - SP(A), $\Delta$SP) is equal to or greater than 2, preferably 2.0 to 5.0 $MPa^{1/2}$, more preferably 2.0 to 4.0 $MPa^{1/2}$, and even more preferably 2.5 to 3.5 $MPa^{1/2}$. If the difference within the above range, the mobility of the obtained organic semiconductor is further improved.

The SP value is calculated by the following method.

By using Hansen solubility parameters determined by the equation explained in A User's Handbook, Second Edition, C. M. Hansen (2007), Taylor and Francis Group, LLC (HSPiP manual) and "Hansen Solubility Parameter in Practice, HSPiP, 3rd edition" (software version 4.0.05), an SP value (unit: $MPa^{1/2}$) is calculated by the following equation.

$$(\text{SP value})^2 = (\delta\text{Hd})^2 + (\delta\text{Hp})^2 + (\delta\text{Hh})^2$$

$H_d$: dispersion contribution
$H_p$: polar contribution
$H_h$: hydrogen bonding contribution

The organic solvent A is preferably a hydrocarbon-based solvent and an aromatic hydrocarbon-based solvent is more preferable.

Specific examples of the organic solvent A preferably include hexane, heptane, octane, nonane, decane, cyclohexane, propylcyclohexane, toluene, xylene, mesitylene, ethylbenzene, propylbenzene, decalin, tetralin, or amylbenzene (n-pentylbenzene), more preferably include decalin, xylene, mesitylene, ethylbenzene, decalin, tetralin, or amylbenzene, even more preferably include cis-decalin, tetralin, or amylbenzene, and particularly preferably include amylbenzene.

Among the above organic solvent, cis-decalin has an SP value of 16.8 $MPa^{1/2}$ and a boiling point of 196°C, tetralin has an SP value of 18.9 $MPa^{1/2}$ and a boiling point of 208°C, and amylbenzene has an

SP value of 17.5 $MPa^{1/2}$ and a boiling point of 205°C. In the present invention, unless otherwise specified, the boiling point is a standard boiling point under 1 atm.

The SP value of the organic solvent A is preferably 12 to 25 $MPa^{1/2}$, more preferably 15 to 20 $MPa^{1/2}$, and even more preferably 16 to 19 $MPa^{1/2}$.

The boiling point of the organic solvent is preferably 150°C to 250°C, more preferably 180°C to 230°C, and even more preferably 195°C to 215°C.

The organic solvent B is preferably a halogenated hydrocarbon-based solvent or an ether-based solvent, more preferably a halogenated aromatic hydrocarbon-based solvent or an aromatic ether-based solvent, even more preferably a halogenated aromatic hydrocarbon-based solvent, and particularly preferably a fluorinated aromatic hydrocarbon-based solvent.

Specific examples of the organic solvent B preferably include dichloromethane, chloroform, tetrachloromethane, dichloroethane, trichloroethane, tetrachloroethane, chlorobenzene, dichlorobenzene, chlorotoluene, chloronaphthalene, fluoronaphthalene, difluoronaphthalene, dibutylether, tetrahydrofuran, dioxane, anisole, ter-butylanisole, or 2-methoxynaphthalene, more preferably include chlorobenzene, dichlorobenzene, chlorotoluene, fluoronaphthalene, difluoronaphthalene, anisole, or 2-methoxynaphthalene, even more preferably include 1,2-dichlorobenzene, 1-fluoronaphthalene, or anisole, and particularly preferably include 1-fluoronaphthalene.

Among the above organic solvents, 1,2-dichlorobenzene has an SP value of 20.5 $MPa^{1/2}$ and a boiling point of 181°C, 1-fluoronaphthalene has an SP value of 20.3 $MPa^{1/2}$ and a boiling point of 215°C, and anisole has an SP value of 19.6 $MPa^{1/2}$ and a boiling point of 154°C.

The SP value of the organic solvent B is preferably 14 to 27 $MPa^{1/2}$, more preferably 17 to 22 $MPa^{1/2}$, and even more preferably 18 to 21 $MPa^{1/2}$.

The boiling point of the organic solvent is preferably 150°C to 250°C, more preferably 180°C to 240°C, and even more preferably 200°C to 230°C.

It is preferable that a boiling point pb(A) of the organic solvent A and a boiling point bp(B) of the organic solvent B satisfy bp(A) < bp(B). If bp(A) and bp(B) are within the above range, the mobility of the obtained organic semiconductor is further improved.

A content of the organic solvent A in the organic semiconductor composition of the present invention is, with respect to a content of 100% by volume of the organic solvent B, preferably 20% to 100% by volume and more preferably 40% to 80% by volume. If the content is within the above range, the mobility of the obtained organic semiconductor is further improved.

The total content of the organic solvent A and the organic solvent B in the organic semiconductor composition of the present invention is, with respect to the total mass of the organic semiconductor composition, preferably equal to or greater than 50% by mass, more preferably equal to or greater than 80% by mass, even more preferably 90% to 99.9% by mass, and particularly preferably 95% to 99.9% by mass.

The organic semiconductor composition of the present invention may contain an organic solvent other than the organic solvent A and the organic solvent B. The proportion of the organic solvent A and the organic solvent B in all of the organic solvents is preferably 90% to 100% by mass, more preferably 95% to 100% by mass, even more preferably 98% to 100% by mass, and particularly preferably 100% by mass. That is, it is particularly preferable that the organic semiconductor composition of the present invention contains only the organic solvent A and the organic solvent B as organic solvents.

The viscosity of the organic semiconductor composition of the present invention is not particularly limited. In view of further improving coating properties, the viscosity is preferably 3 to 100 mPa·s, more preferably 5 to 50 mPa·s, and even more preferably 9 to 40 mPa·s. In the present invention, the viscosity is a viscosity at 25°C.

The method for measuring viscosity is preferably the measurement method based on JIS Z8803.

<Surfactant>

The organic semiconductor composition of the present invention contains a surfactant (hereinafter, referred to as a "specific surfactant" as well) having an organic siloxane moiety represented by $-O-SiR^1R^2-$.

Here, $R^1$ and $R^2$ each independently represent a monovalent hydrocarbon group not containing an ether bond.

The monovalent hydrocarbon group may have a substituent.

Examples of the substituent preferably include a halogen atom, an alkyl group, an alkenyl group, an alkynyl group, and an aryl group, and more preferably include a fluorine atom, an alkyl group, an alkenyl group, and an aryl group. These substituents may further have the aforementioned substituents.

The number of carbon atoms of the monovalent hydrocarbon group is preferably 1 to 32, more preferably 1 to 24, and even more preferably 1 to 18.

Examples of the monovalent hydrocarbon group preferably include an alkyl group, an alkenyl group, an alkynyl group, or an aryl group.

In the specific surfactant, at least one of $R^1$ or $R^2$ is preferably a linear, branched, or cyclic alkyl group having 2 to 18 carbon atoms or a linear, branched, or cyclic alkenyl group having 2 to 18 carbon atoms. The alkyl group and the alkenyl group may have a fluorine atom and/or an aryl group as a substituent. Furthermore, at least one of $R^1$ or $R^2$ is more preferably a linear or branched alkyl group having 2 to 18 carbon atoms or a linear or branched aralkyl group having 7 to 18 carbon atoms.

If the aforementioned aspect is adopted, the mobility and the temporal stability of the obtained organic semiconductor are further improved.

The specific surfactant is preferably a polyorganosiloxane compound having a repeating unit represented by $-O-SiR^1R^2-$, and more preferably a linear polyorganosiloxane compound having a repeating unit represented by $-O-SiR^1R^2-$. At least one of $R^1$ or $R^2$ in each constituent repeating unit is preferably a methyl group.

The specific surfactant is preferably a compound represented by the following Formula S.

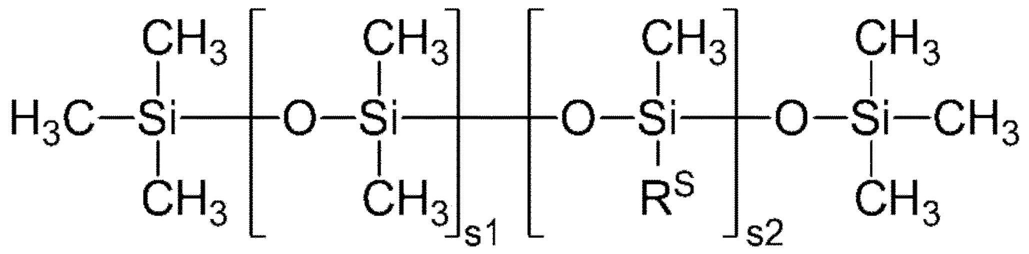

( S )

In Formula S, $R^S$ each independently represents a monovalent hydrocarbon group not containing an ether bond, and s1 and s2 each independently represent any integer.

The repeating unit represented by $-O-Si(CH_3)_2-$ and the repeating unit represented by $-O-Si(CH_3)(R^S)$ in Formula S can form a silicone chain not only in the order described above but also in any order. The aforementioned two kinds of repeating units may be bonded to each other randomly or bonded to each other by forming a block.

RS is preferably an alkyl group having 2 to 32 carbon atoms or an aralkyl group having 7 to 32 carbon atoms, more preferably a linear alkyl group having 8 to 18 carbon atoms or an aralkyl group having 7 to 18 carbon atoms, and even more preferably a linear alkyl group having 12 to 18 carbon atoms or $-CH_2-CH(CH_3)-C_6H_5$. If the aforementioned aspect is adopted, the mobility and the temporal stability of the obtained organic semiconductor are further improved.

The specific surfactant is a polymer surfactant having a weight-average molecular weight (Mw) of equal to or greater than 1,000, more preferably a polymer surfactant having a weight-average molecular weight of 1,000 to 500,000, and even more preferably a polymer surfactant having a weight-average molecular weight of 10,000 to 100,000.

As the specific surfactant, commercially available products may be used.

Examples of the commercially available products include KF-410, KF-412, and KF-96 manufactured by Shin-Etsu Chemical Co., Ltd., BYK-320 and BYK-323 manufactured by BYK Additives & Instruments, DOW CORNING 56 manufactured by Dow Corning Toray Co., Ltd..

The organic semiconductor composition may contain one kind of the specific surfactant singly or two or more kinds thereof.

The content of the specific surfactant in the organic semiconductor composition of the present invention is, with respect to a content of 100 parts by mass of the organic semiconductor, 0.1 to 10 parts by mass, and even more preferably 1 to 10 parts by mass. If the aforementioned aspect is adopted, the mobility and the temporal stability of the obtained organic semiconductor are further improved.

The content of the specific surfactant in the organic semiconductor composition of the present invention is, with respect to the total mass of the organic semiconductor composition, preferably 0.0001% to 2% by mass, more preferably 0.0005% to 1% by mass, and even more preferably 0.001% to 0.1% by mass.

<Organic semiconductor>

The organic semiconductor composition of the present invention has a condensed polycyclic aromatic group, in which the number of rings in the condensed polycyclic aromatic group is equal to or greater than 4, at least two rings in the condensed polycyclic aromatic group contain at least 1 atom selected from the group consisting of a sulfur atom, a nitrogen atom, a selenium atom, and an oxygen atom, and the condensed polycyclic aromatic group has, as a partial structure, an organic semiconductor (hereinafter, referred to as a "specific organic semiconductor" as well) containing at least any one structure selected from the group consisting of a benzene ring, a naphthalene ring, and a phenanthrene ring.

Here, the partial structure in the condensed polycyclic aromatic group in the specific organic semiconductor does not contain an anthracene ring. In a case where the partial structure contains an anthracene ring, both of the mobility and the temporal stability of the obtained organic semiconductor film deteriorate, although the reason is unclear.

The condensed polycyclic aromatic group is a group obtained by the condensation of a plurality of aromatic rings.

Examples of the aromatic ring include an aromatic hydrocarbon ring (for example, a benzene ring) and an aromatic heterocyclic ring (for example, a thiophene ring, a furan ring, a pyrrole ring, a selenophene ring, or an imidazole ring).

The specific organic semiconductor contains a condensed polycyclic aromatic group (condensed polycyclic aromatic structure), and it is preferable that this group is contained as a main component. Herein, being a main component means that a content of the condensed polycyclic aromatic group based on a molecular weight is equal to or greater than 30% of a total molecular weight of the specific organic semiconductor. The content is preferably equal to or greater than 40%. The upper limit of the content is not particularly limited. In view of solubility, the upper limit is preferably equal to or less than 80%.

The condensed polycyclic aromatic group is a cyclic structure formed by the condensation of a plurality of rings and exhibits aromaticity.

The number of rings in the condensed polycyclic aromatic group in the specific organic semiconductor is equal to or greater than 4. From the viewpoint of the mobility organic semiconductor, the number of rings is preferably 4 to 9, more preferably 4 to 7, and even more preferably 5 or 6.

At least two rings in the condensed polycyclic aromatic group contain at least one kind of atom selected from the group consisting of a sulfur atom, a nitrogen atom, a selenium atom, and an oxygen atom. From the viewpoint of mobility thereof as an organic semiconductor, the number of rings containing the aforementioned atom is preferably 2 to 6, and more preferably 2 to 4.

From the viewpoint of mobility thereof as an organic semiconductor, the condensed polycyclic aromatic group preferably contains at least two heterocyclic rings, and the heterocyclic rings preferably each have one heteroatom. The type of the heteroatom is not particularly limited, and examples thereof include an O atom (oxygen atom), a S atom (sulfur atom), a N atom (nitrogen atom), a Se atom (selenium atom).

The condensed polycyclic aromatic group in the specific organic semiconductor contains, as a partial structure, at least one structure selected from the group consisting of a benzene ring, a naphthalene ring, and a phenanthrene ring. The condensed polycyclic aromatic group does not contain an anthracene ring as the partial structure.

From the viewpoint of the mobility thereof as an organic semiconductor, the specific organic semiconductor preferably has at least a thiophene ring structure and/or a selenophene ring structure, and more preferably has at least a thiophene ring structure. It is even more preferable that all of the heterocyclic structures that the specific organic semiconductor has are thiophene ring structures.

From the viewpoint of mobility thereof as an organic semiconductor, the condensed polycyclic aromatic group is preferably a condensed polycyclic aromatic group which contains, as a partial structure, at least any one structure selected from the group consisting of a benzene ring, a naphthalene ring, and a phenanthrene ring, contains two or more thiophene rings, and has four or more rings. Particularly, the condensed polycyclic aromatic group is more preferably a condensed polycyclic aromatic group which contains a benzene ring as a partial structure and two or more thiophene rings and has four or more rings.

From the viewpoint of mobility thereof as an organic semiconductor, the number of thiophene rings in the condensed polycyclic aromatic group is preferably equal to or greater than 3, more preferably 3 to 5, even more preferably 3 or 4, and particularly preferably 3.

From the viewpoint of mobility thereof as an organic semiconductor, the number of rings in the condensed polycyclic aromatic group is preferably 4 to 6, more preferably 5 or 6, and even more preferably 5. The condensed polycyclic aromatic group is particularly preferably a condensed polycyclic aromatic group which contains two benzene rings and three thiophene rings and has 5 rings.

Preferred examples of the condensed polycyclic aromatic group include a group in which a ring (heterocyclic ring, preferably, a thiophene ring) containing at least one kind of atom selected from the group consisting of a sulfur atom, a nitrogen atom, a selenium atom, and an oxygen atom and a benzene ring are alternately condensed (fused) with each other (a group which is obtained by the alternate condensation of the aforementioned heterocyclic ring and a benzene ring).

From the viewpoint of the mobility thereof as an organic semiconductor, the specific organic semiconductor preferably contains at least one kind of compound represented by any one of Formulae 1 to 16. The specific organic semiconductor is more preferably one or more kinds of compound represented by any one of Formulae 1 to 16.

The composition of the present invention may contain only one kind of the specific organic semiconductor or two or more kinds of the specific organic semiconductor.

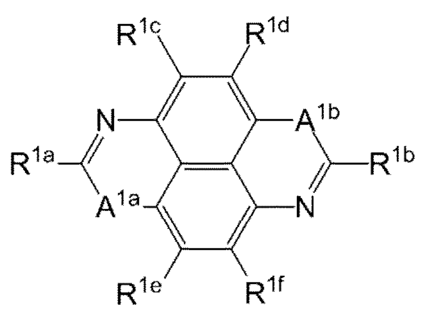

(1)

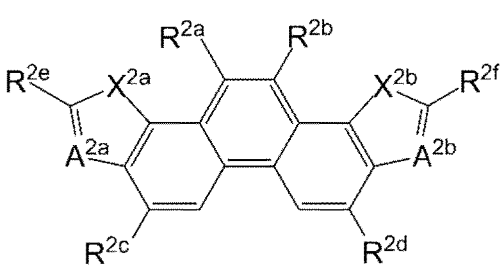

(2)

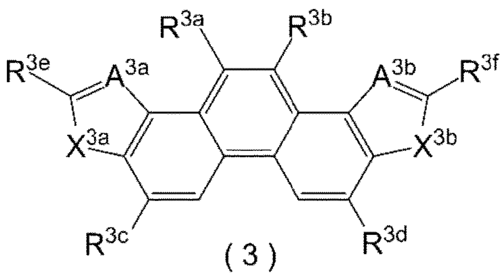

(3)

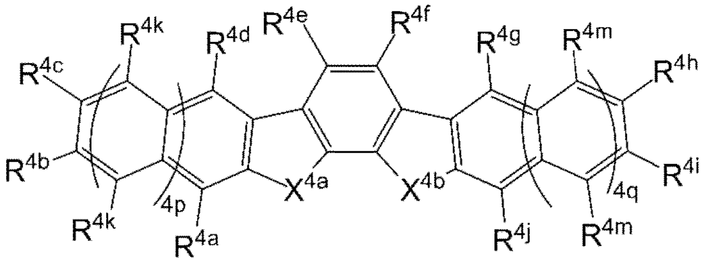

(4)

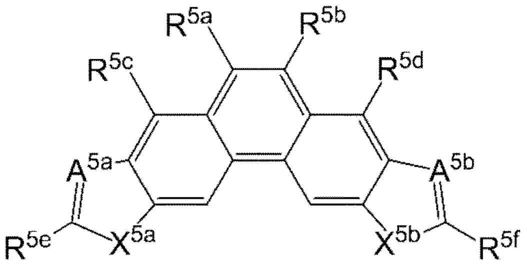

(5)

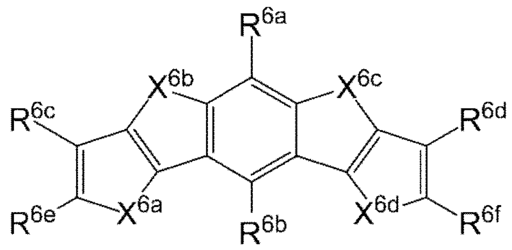

(6)

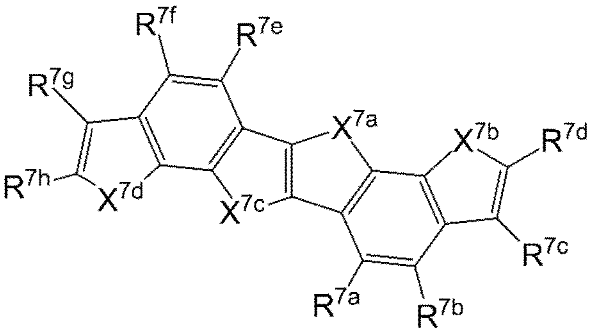

(7)

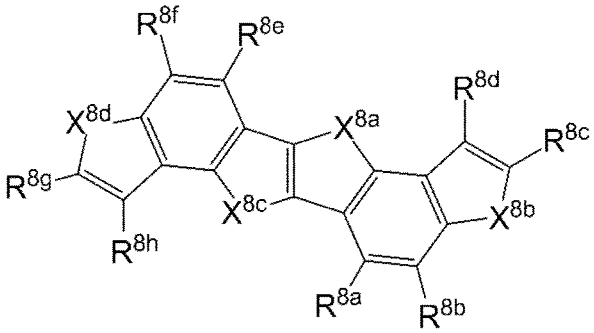

(8)

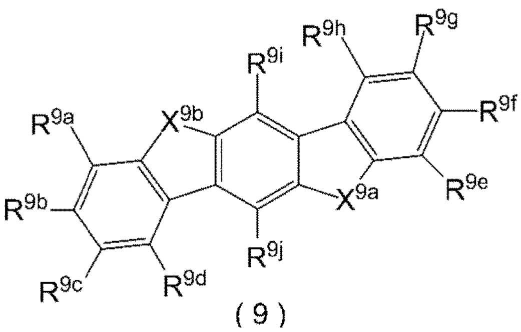

(9)

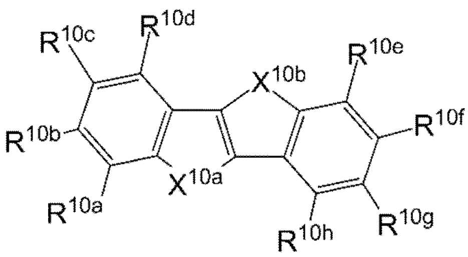

(10)

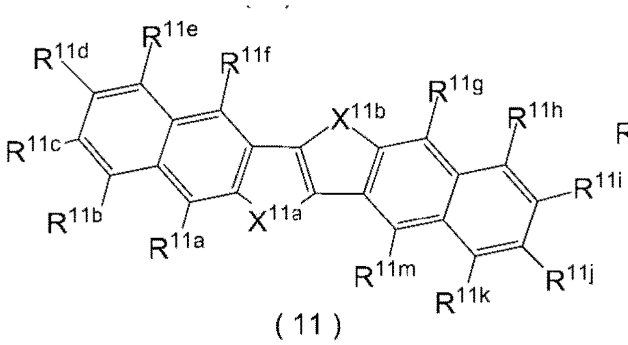

( 11 )

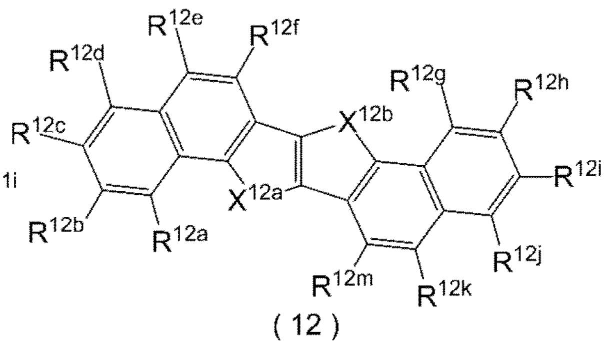

( 12 )

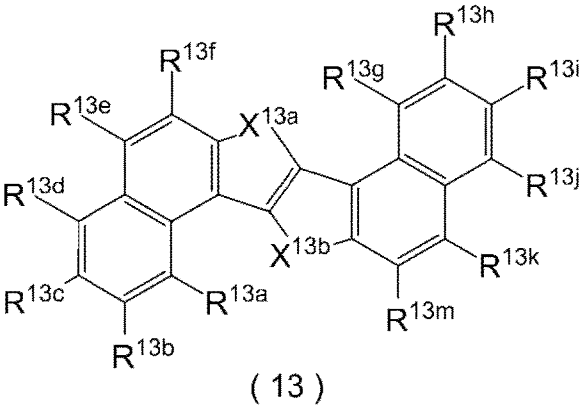

( 13 )

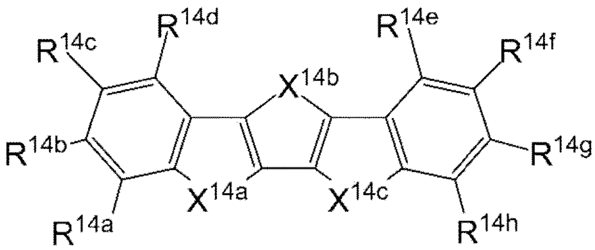

( 14 )

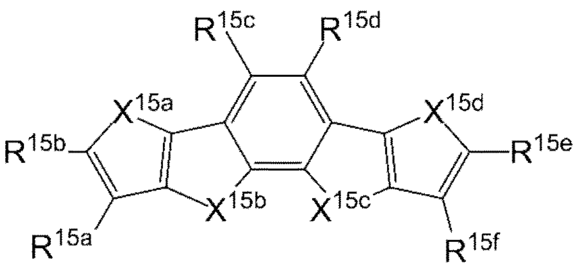

( 15 )

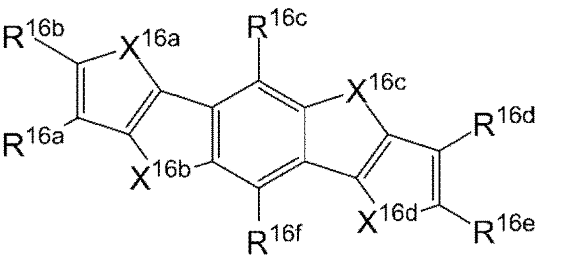

( 16 )

In Formula 1, $A^{1a}$ and $A^{1b}$ each independently represent a S atom, an O atom, or a Se atom, $R^{1a}$ to $R^{1f}$ each independently represent a hydrogen atom or a substituent, and at least one of $R^{1a}$, $R^{1b}$, $R^{1c}$, $R^{1d}$, $R^{1e}$, or $R^{1f}$ is a group represented by the following Formula W.

$-L^W-R^W$ (W)

In Formula W, $L^W$ represents a divalent linking group which is represented by any one of the following Formulae L-1 to L-25 or a divalent linking group in which two or more divalent linking groups represented by any one of the following Formulae L-1 to L-25 are bonded to each other, and $R^W$ represents an alkyl group, a cyano group, a vinyl group, an ethynyl group, an oxyethylene group, an oligo-oxyethylene group in which a repetition number v of an oxyethylene unit is equal to or greater than 2, a siloxane group, an oligosiloxane group having two or more silicon atoms, or a trialkylsilyl group.

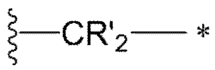 (L-1)

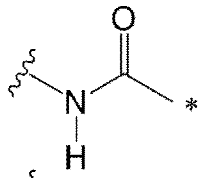 (L-11)

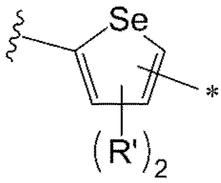 (L-19)

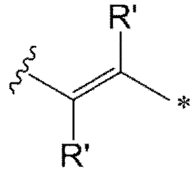 (L-2)

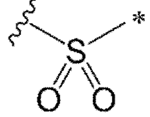 (L-12)

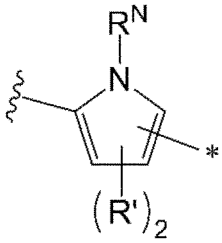 (L-20)

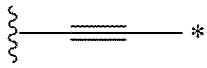 (L-3)

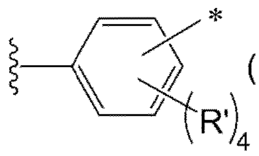 (L-13)

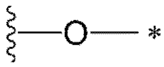 (L-4)

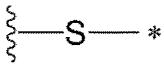 (L-5)

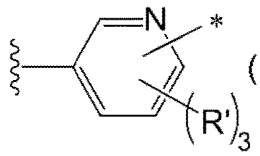 (L-14)

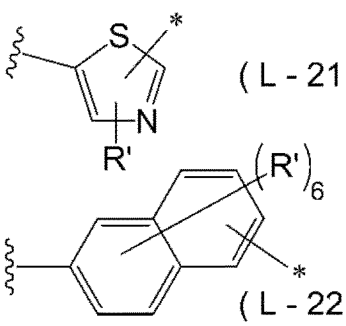 (L-21)

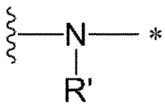 (L-6)

(L-22)

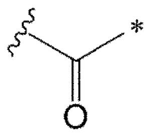 (L-7)

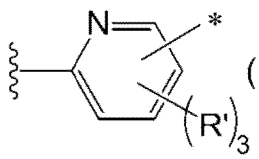 (L-15)

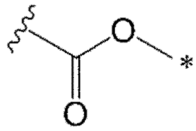 (L-8)

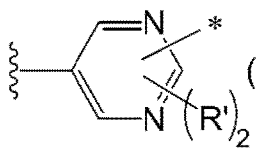 (L-16)

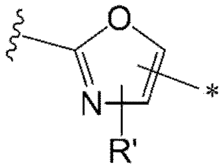 (L-23)

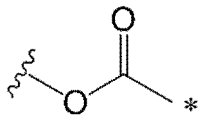 (L-9)

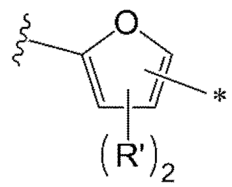 (L-17)

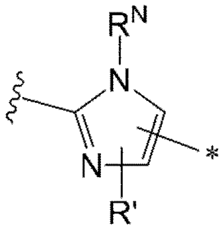 (L-24)

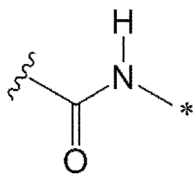 (L-10)

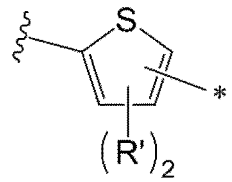 (L-18)

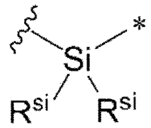 (L-25)

In Formulae L-1 to L-25, * represents a bonding position for $R^W$, the portion of a wavy line represents the other bonding position, R' in Formulae L-1, L-2, L-6, and L-13 to L-24 each independently represents a hydrogen atom or a substituent, $R^N$ in Formulae L-20 and L-24 represents a hydrogen atom or a substituent, and $R^{si}$ in Formula L-25 each independently represents a hydrogen atom, an alkyl group, an alkenyl group, or an alkynyl group.

In Formula 2, $X^{2a}$ and $X^{2b}$ each independently represent $NR^{2i}$, an O atom, or a S atom, $A^{2a}$ represents $CR^{2g}$ or a N atom, $A^{2b}$ represents $CR^{2h}$ or a N atom, $R^{2i}$ represents a hydrogen atom, an alkyl group, an alkenyl group, an alkynyl group, or an acyl group, $R^{2a}$ to $R^{2h}$ each independently represent a hydrogen atom or a substituent, and at least one of $R^{2a}$, $R^{2b}$, $R^{2c}$, $R^{2d}$, $R^{2e}$, $R^{2f}$, $R^{2g}$, or $R^{2h}$ is a group represented by Formula W.

In Formula 3, $X^{3a}$ and $X^{3b}$ each independently represent a S atom, an O atom, or $NR^{3g}$, and $A^{3a}$ and $A^{3b}$ each independently represent $CR^{3h}$ or a N atom. $R^{3a}$ to $R^{3h}$ each independently represent a hydrogen atom or a substituent, and at least one of $R^{3a}$, $R^{3b}$, $R^{3c}$, $R^{3d}$, $R^{3e}$, $R^{3f}$, $R^{3g}$, or $R^{3h}$ is a group represented by Formula W.

In Formula 4, $X^{4a}$ and $X^{4b}$ each independently represent an O atom, a S atom, or a Se atom, 4p and 4q each independently represent an integer of 0 to 2, $R^{4a}$ to $R^{4j}$, $R^{4k}$, and $R^{4m}$ each independently represent a hydrogen atom,

a halogen atom, or a group represented by Formula W, at least one of $R^{4a}$, $R^{4b}$, $R^{4c}$, $R^{4d}$, $R^{4e}$, $R^{4f}$, $R^{4g}$, $R^{4h}$, $R^{4i}$, $R^{4j}$, $R^{4k}$, or $R^{4m}$ is a group represented by Formula W. Here, in a case where at least one of $R^{4e}$ or $R^{4f}$ is a group represented by Formula W, $L^{W}$ in Formula W represented by $R^{4e}$ and $R^{4f}$ is a divalent linking group represented by Formula L-2 or L-3.

In Formula 5, $X^{5a}$ and $X^{5b}$ each independently represent $NR^{5i}$, an O atom, or a S atom, $A^{5a}$ represents $CR^{5g}$ or a N atom, $A^{5b}$ represents $CR^{5h}$ or a N atom, $R^{5i}$ represents a hydrogen atom, an alkyl group, an alkenyl group, an alkynyl group, an acyl group, an aryl group, or a heteroaryl group, $R^{5a}$ to $R^{5h}$ each independently represent a hydrogen atom or a substituent, and at least one of $R^{5a}$, $R^{5b}$, $R^{5c}$, $R^{5d}$, $R^{5e}$, $R^{5f}$, $R^{5g}$, or $R^{5h}$ is a group represented by Formula W.

In Formula 6, $X^{6a}$ to $X^{6d}$ each independently represent $NR^{6g}$, an O atom, or a S atom, $R^{6g}$ represents a hydrogen atom, an alkyl group, an alkenyl group, an alkynyl group, an acyl group, an aryl group, or a heteroaryl group, $R^{6a}$ to $R^{6f}$ each independently represent a hydrogen atom or a substituent, and at least one of $R^{6a}$, $R^{6b}$, $R^{6c}$, $R^{6d}$, $R^{6e}$, or $R^{6f}$ is a group represented by Formula W.

In Formula 7, $X^{7a}$ and $X^{7c}$ each independently represent a S atom, an O atom, a Se atom, or $NR^{7i}$, $X^{7b}$ and $X^{7d}$ each independently represent a S atom, an O atom, or a Se atom, $R^{7a}$ to $R^{7i}$ each independently represent a hydrogen atom or a substituent, and at least one of $R^{7a}$, $R^{7b}$, $R^{7c}$, $R^{7d}$, $R^{7e}$, $R^{7f}$, $R^{7g}$, $R^{7h}$, or $R^{7i}$ is a group represented by Formula W.

In Formula 8, $x^{8a}$ and $X^{8c}$ each independently represent a S atom, an O atom, a Se atom, or $NR^{8i}$, $X^{8b}$ and $X^{8d}$ each independently represent a S atom, an O atom, or a Se atom, $R^{8a}$ to $R^{8i}$ each independently represent a hydrogen atom or a substituent, and at least one of $R^{8a}$, $R^{8b}$, $R^{8c}$, $R^{8d}$, $R^{8e}$, $R^{8f}$, $R^{8g}$, $R^{8h}$, or $R^{8i}$ is a group represented by Formula W.

In Formula 9, $X^{9a}$ and $X^{9b}$ each independently represent an O atom, a S atom, or a Se atom, $R^{9c}$, $R^{9d}$, and $R^{9g}$ to $R^{9j}$ each independently represent a hydrogen atom, a halogen atom, or a group represented by Formula W, and $R^{9a}$, $R^{9b}$, $R^{9e}$, and $R^{9f}$ each independently represent a hydrogen atom or a substituent.

In Formula 10, $R^{10a}$ to $R^{10h}$ each independently represent a hydrogen atom or a substituent, at least one of $R^{10a}$, $R^{10b}$, $R^{10c}$, $R^{10d}$, $R^{10e}$, $R^{10f}$, $R^{10g}$, or $R^{10h}$ represents a substituent represented by Formula W, $X^{10a}$ and $X^{10b}$ each independently represent a S atom, an O atom, a Se atom, or $NR^{10i}$, and $R^{10i}$ each independently represents a hydrogen atom or a group represented by Formula W.

In Formula 11, $X^{11a}$ and $X^{11b}$ each independently represent a S atom, an O atom, a Se atom, or $NR^{11n}$, $R^{11a}$ to $R^{11k}$, $R^{11m}$, and $R^{11n}$ each independently represent a hydrogen atom or a substituent, and at least one of $R^{11a}$, $R^{11b}$, $R^{11c}$, $R^{11d}$, $R^{11e}$, $R^{11f}$, $R^{11g}$, $R^{11h}$, $R^{11i}$, $R^{11j}$ , $R^{11k}$ , $R^{11m}$, or $R^{11n}$ is a group represented by Formula W.

In Formula 12, $X^{12a}$ and $X^{12b}$ each independently represent a S atom, an O atom, a Se atom, or $NR^{12n}$, $R^{12a}$ to $R^{12k}$, $R^{12m}$, and $R^{12n}$ each independently represent a hydrogen atom or a substituent, and at least one of $R^{12a}$, $R^{12b}$, $R^{12c}$, $R^{12d}$, $R^{12e}$, $R^{12f}$, $R^{12g}$, $R^{12h}$, $R^{12i}$, $R^{12j}$, $R^{12k}$, $R^{12m}$, or $R^{12n}$ is a group represented by Formula W.

In Formula 13, $X^{13a}$ and $X^{13b}$ each independently represent a S atom, an O atom, a Se atom, or $NR^{13n}$, $R^{13a}$ to $R^{13k}$, $R^{13m}$, and $R^{13n}$ each independently represent a hydrogen atom or a substituent, and at least one of $R^{1a}$, $R^{3b}$, $R^{13c}$, $R^{13d}$, $R^{13e}$, $R^{13f}$, $R^{13g}$, $R^{13h}$, $R^{13i}$, $R^{13j}$, $R^{13k}$, $R^{13m}$, or $R^{13n}$ is a group represented by Formula W.

In Formula 14, $X^{14a}$ to $X^{14c}$ each independently represent a S atom, an O atom, a Se atom, or $NR^{14i}$, $R^{14a}$ to $R^{14i}$ each independently represent a hydrogen atom or a substituent, and at least one of $R^{14a}$, $R^{14b}$, $R^{14c}$, $R^{14d}$, $R^{14e}$, $R^{14f}$, $R^{14g}$, $R^{14h}$, or $R^{14i}$ is a group represented by Formula W.

In Formula 15, $X^{15a}$ to $X^{15d}$ each independently represent a S atom, an O atom, a Se atom, or $NR^{15g}$, $R^{15a}$ to $R^{15g}$ each independently represent a hydrogen atom or a substituent, and at least one of $R^{15a}$, $R^{15b}$, $R^{15c}$, $R^{15d}$, $R^{15e}$, $R^{15f}$, or $R^{15g}$ is a group represented by Formula W.

In Formula 16, $X^{16a}$ to $X^{16d}$ each independently represent a S atom, an O atom, a Se atom, or $NR^{16g}$, $R^{16a}$ to $R^{16g}$ each independently represent a hydrogen atom or a substituent, and at least one of $R^{16a}$, $R^{16b}$, $R^{16c}$, $R^{16d}$, $R^{16e}$, $R^{16f,}$ or $R^{16g}$ is a group represented by Formula W.

-Compound represented by Formula 1-

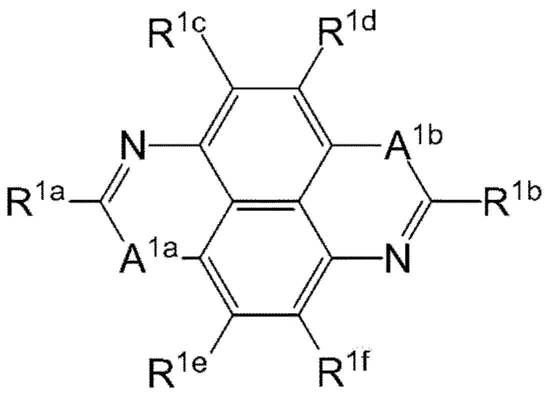

(1)

In Formula 1, $A^{1a}$ and $A^{1b}$ each independently represent a S atom (sulfur atom), an O atom (oxygen atom), or a Se atom (selenium atom). Each of $A^{1a}$ and $A^{1b}$ is preferably a S atom or an O atom. $A^{1a}$ and $A^{1b}$ may be the same as or different from each other, but it is preferable that they are the same as each other.

In Formula 1, $R^{1a}$ to $R^{1f}$ each independently represent a hydrogen atom or a substituent. Here, at least one of $R^{1a}$, $R^{1b}$, $R^{1c}$, $R^{1d}$, $R^{1e}$, or $R^{1f}$ is a group represented by Formula W which will be described later.

The compound represented by Formula 1 may have substituents other than a group represented by Formula W which will be described later.

The type of the substituents which can be adopted as $R^{1a}$ to $R^{1f}$ in Formula 1 is not particularly limited, and examples thereof include a substituent X described below. Examples of the substituent X include a group represented by Formula W which will be described later, a halogen atom, an alkyl group (including a cycloalkyl group, a bicycloalkyl group, and a tricycloalkyl group), an alkenyl group (including a cycloalkenyl group and a bicycloalkenyl group), an alkynyl group, an aryl group, a heterocyclic group (may be referred to as a hetero ring group as well), a cyano group, a hydroxyl group, a nitro group, a carboxy group, an alkoxy group, an aryloxy group, a silyloxy group, a heterocyclic oxy group, an acyloxy group, a carbamoyloxy group, an alkoxycarbonyloxy group, an aryloxycarbonyloxy group, an amino group (inclding an anilino group), an ammonio group, an acylamino group, an aminocarbonylamino group, alkoxycarbonylamino group, an aryloxycarbonylamino group, a sulfamoylamino group, alkyl- and arylsulfonylamino groups, a mercapto group, an alkylthio group, an arylthio group, a heterocyclic thio group, a sulfamoyl group, a sulfo group, alkyl- and arylsulfinyl groups, alkyl- and arylsulfonyl groups, an acyl group, an aryloxycarbonyl group, an alkoxycarbonyl group, a carbamoyl group, aryl- and heterocyclic azo groups, an imide group, a phosphino group, a phosphinyl group, a phosphinyloxy group, a phosphinylamino group, a phosphono group, a silyl group, a hydrazino group, a ureido group, a boronic acid group ($-B(OH)_2$), a phosphato group ($-OPO(OH)_2$), a sulfato group ($-OSO_3H$), and other known substituents. In Formulae 1 to 16 of the present specification, preferred examples of a "substituent" nicludes the aforementioned substituent X.

Among these, the groups other than a group represented by Formula W which will be described later are preferably a halogen atom, an alkyl group, an alkynyl group, an alkenyl group, an alkoxy group group, an alkylthio group, and an aryl group, more preferably a fluorine atom, a substituted or unsubstituted alkyl group having 1 to 3 carbon atoms, a substituted or unsubstituted alkynyl group having 2 or 3 carbon atoms, a substituted or unsubstituted alkenyl group having 2 or 3 carbon atoms, a substituted or unsubstituted alkoxy group group having one or two carbon atoms, a substituted or unsubstituted methylthio group, and a phenyl group, and particularly preferably a fluorine atom, a substituted or unsubstituted alkyl group having 1 to 3 carbon atoms, a substituted or unsubstituted alkynyl group having 2 or 3 carbon atoms, a substituted or unsubstituted alkenyl group having 2 or 3 carbon atoms, a substituted or unsubstituted alkoxy group group having one or two carbon atoms, and a substituted or unsubstituted methylthio group.

In the compound represented by Formula 1, among $R^{1a}$ to $R^{1f}$, the number of substituents other than a group represented by Formula W is preferably 0 to 4, more preferably 0 to 2, and particularly preferably 0.

These substituents may further have the above substituents.

Among the above substituents, $R^{1c}$ to $R^{1f}$ each independently preferably represent a hydrogen atom, a fluorine atom, a substituted or unsubstituted alkyl group having 1 to 3 carbon atoms, a substituted or unsubstituted alkynyl group having 2 or 3 carbon atoms, a substituted or unsubstituted alkenyl group having two or three carbon atoms, a substituted or unsubstituted alkoxy group group having one or two carbon atoms, or a substituted or unsubstituted methylthio group.

Next, a group represented by Formula W will be described.

$-L^W-R^W$ (W)

In Formula W, $L^W$ represents a divalent linking group which is represented by any one of the following Formulae L-1 to L-25 or a divalent linking group in which two or more divalent linking groups represented by any one of the following Formulae L-1 to L-25 are bonded to each other.

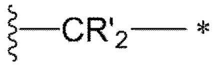 ( L - 1 )

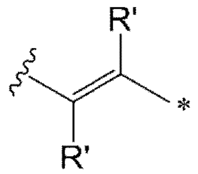 ( L - 2 )

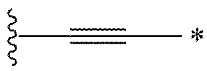 ( L - 3 )

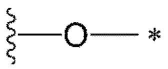 ( L - 4 )

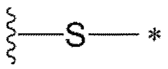 ( L - 5 )

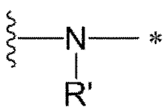 ( L - 6 )

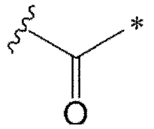 ( L - 7 )

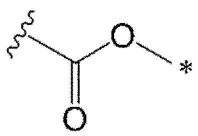 ( L - 8 )

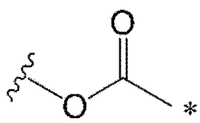 ( L - 9 )

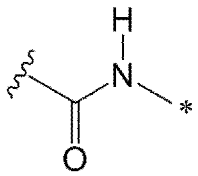 ( L - 10 )

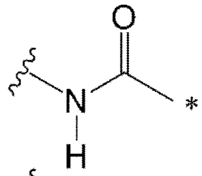 ( L - 11 )

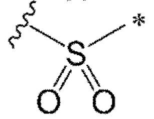 ( L - 12 )

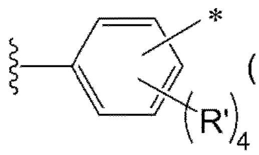 ( L - 13 )

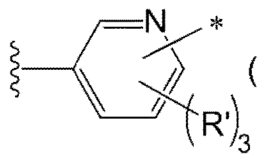 ( L - 14 )

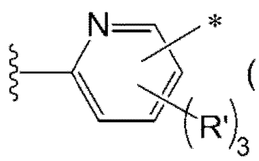 ( L - 15 )

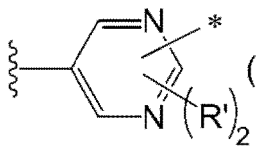 ( L - 16 )

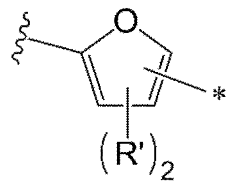 ( L - 17 )

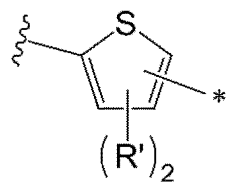 ( L - 18 )

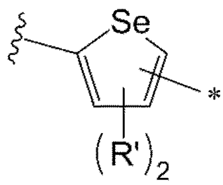 ( L - 19 )

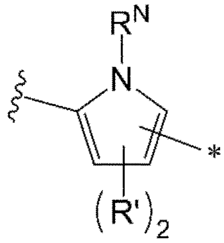 ( L - 20 )

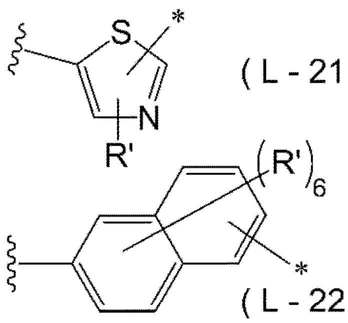 ( L - 21 )

( L - 22 )

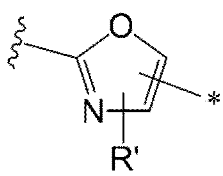 ( L - 23 )

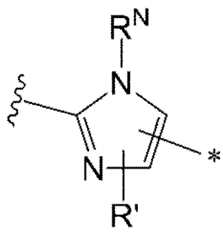 ( L - 24 )

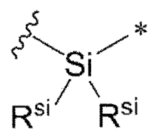 ( L - 25 )

In Formulae L-1 to L-25, * represents a bonding position for $R^W$, and the portion of a wavy line represents the other bonding position. More specifically, for example, in the compound represented by Formula 1, the portion of a wavy line is bonded to a ring forming a skeleton represented by Formula 1. As will be described later, in a case where Formula W is contained in other compounds, the portion of a wavy line is bonded to a ring forming a skeleton of each of the compounds.

In a case where $L^W$ represents a divalent linking group in which two or more divalent linking groups represented by any one of Formulae L-1 to L-25 are bonded to each other, * of one linking group is bonded to the portion of a wavy line of the other linking group.

In Formulae L-13 to L-24, as the bonding position of R' and the bonding position * for $R^W$, any position on an aromatic ring or a heterocyclic aromatic ring can be adopted.

R' in Formulae L-1, L-2, L-6, and L-13 to L-24 each independently represents a hydrogen atom or a substituent. $R^N$ in Formulae L-20 and L-24 represents a hydrogen atom or a substituent. $R^{si}$ in Formula L-25 each independently represents a hydrogen atom, an alkyl group, an alkenyl group, or an alkynyl group.

Each R' in Formulae L-1 and L-2 may form a fused ring by being bonded to $R^W$ adjacent to $L^W$.

Among these, the divalent linking group represented by any one of Formulae L-17 to L-21, L-23, and L-24 is more preferably a divalent linking group represented by one of the following Formulae L-17Ato L-21A, L-23A, and L-24A.

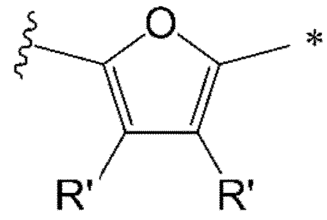
( L - 17A )

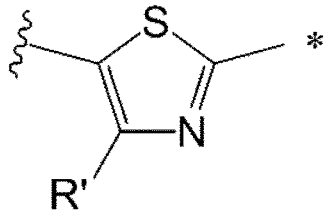
( L - 21A )

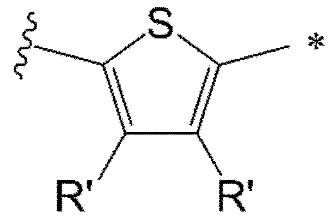
( L - 18A )

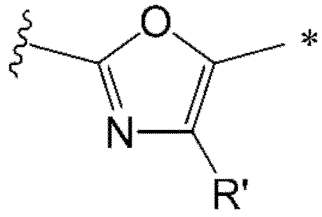
( L - 23A )

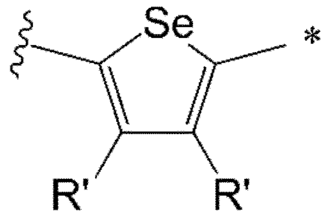
( L - 19A )

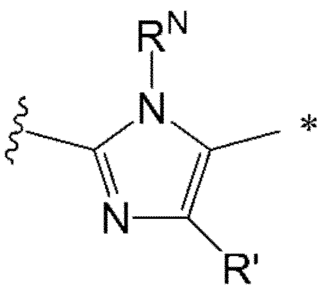
( L - 24A )

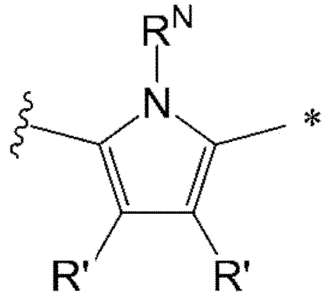
( L - 20A )

In a case where a substituted or unsubstituted alkyl group, an oxyethylene group, an oligo-oxyethylene group in which a repetition number v of an oxyethylene unit is equal to or greater than 2, a siloxane group, an oligosiloxane group having two or more silicon atoms, or a substituted or unsubstituted trialkylsilyl group is present on the terminal of a substituent, the substituent can be interpreted as a substituent consisting only of $-R^W$ in Formula W or a substituent consisting of $-L^W-R^W$ in Formula W.

In the present invention, in a case where a substituted or unsubstituted alkyl group having a main chain consisting of N carbon atoms is present on the terminal of a substituent, the substituent is interpreted as $-L^W-R^W$ in Formula W including as many linking groups as possible from the terminal of the substituent. Specifically, the substituent is interpreted as a substituent in which "one group represented by Formula L-1 corresponding to $L^W$ in Formula W" and "a substituted or unsubstituted alkyl group which corresponds to $R^W$ in Formula W and has a main chain consisting of (N - 1) carbon atoms" are bonded to each other. For example, in a case where a n-octyl group which is an alkyl group having eight carbon atoms is present on the terminal of a substituent, the substituent is interpreted as a substituent in which one

group represented by Formula L-1, in which two R's represent hydrogen atoms, and a n-pentyl group having 7 carbon atoms are bonded to each other.

In contrast, in the present invention, in a case where an oxyethylene group, an oligo-oxyethylene group in which a repetition number v of an oxyethylene unit is equal to or greater than 2, a siloxane group, an oligosiloxane group having two or more silicon atoms, or a substituted or unsubstituted trialkylsilyl group is present on the terminal of a substituent, the substituent is interpreted as a substituent consisting only of $R^W$ in Formula W including as many linking groups as possible from the terminal of the substituent. For example, in a case where a $-(OCH_2CH_2)-(OCH_2CH_2)-(OCH_2CH_2)-OCH_3$ group is present on the terminal of a substituent, the substituent is interpreted as a substituent consisting only of an oligo-oxyethylene group in which a repetition number v of an oxyethylene unit is 3.

In a case where $L^W$ forms a linking group in which divalent linking groups represented by any one of Formulae L-1 to L-25 are bonded to each other, the number of bonded divalent linking groups represented by any one of Formulae L-1 to L-25 is preferably 2 to 4, and more preferably 2 or 3.

Examples of the substituent R' in Formulae L-1, L-2, L-6, and L-13 to L-24 include those exemplified as substituents that can be adopted as $R^{1a}$ to $R^{1f}$ in Formula 1. The substituent R' in Formula L-6 among the above formulae is preferably an alkyl group. In a case where R' in Formula L-6 is an alkyl group, the number of carbon atoms of the alkyl group is preferably 1 to 9, more preferably 4 to 9 from the viewpoint of chemical stability and cariier transport properites, and even more preferably 5 to 9. In a case where R' in Formula L-6 is an alkyl group, the alkyl group is preferably a linear alkyl group, because then the carrier mobility can be improved.

$R^N$ in Formulae L-20 and L-24 represents a hydrogen atom or a substituent. Examples of $R^N$ include those exemplified as substituents that can be adopted as $R^{1a}$ to $R^{1f}$ in Formula 1. $R^N$ is preferably a hydrogen atom or a methyl group among the substituents.

$R^{si}$ in Formula L-25 each independently represents a hydrogen atom, an alkyl group, an alkenyl group, or an alkynyl group, and preferably represents an alkyl group. The alkyl group that can be adopted as $R^{si}$ is not particularly limited. A preferred range of the alkyl group that can be adopted as $R^{si}$ is the same as a preferred range of an alkyl group that can be adopted in a trialkylsilyl group in a case where R represents a trialkylsilyl group. The alkenyl group that can be adopted as $R^{si}$ is not particularly limited. The alkenyl group is preferably a substituted or unsubstituted alkenyl group and more preferably a branched alkenyl group, and the alkenyl group preferably has 2 or 3 carbon atoms. The alkynyl group that can be adopted as $R^{si}$ is not particularly limited. The alkynyl group is preferably a substituted or unsubstituted alkynyl group and more preferably a branched alkynyl group, and the alkynyl group preferably has 2 or 3 carbon atoms.

$L^W$ is preferably a divalent linking group which is represented by any one of Formulae L-1 to L-5, L-13, L-17, and L-18 or a divalent linking group in which two or more divalent linking groups represented by any one of Formulae L-1 to L-5, L-13, L-17, and L-18 are bonded to each other, more preferably a divalent linking group which is represented by any one of Formulae L-1, L-3, L-13, and L-18 or a divalent linking group in which two or more divalent linking groups represented by any one of Formulae L-1, L-3, L-13, and L-18 are bonded to each other, and particularly preferably a divalent linking group which is represented by any one of Formulae L-1, L-3, L-13, and L-18 or a divalent linking group in which a divalent linking group represented by any one of Formulae L-3, L-13, and L-18 and a divalent linking group represented by Formula L-1 are bonded to each other.

Regarding the divalent linking group, in which a divalent linking group represented by any one of Formulae L-3, L-13, and L-18 and a divalent linking group represented by Formula L-1 are bonded to each other, it is preferable that the divalent linking group represented by Formula L-1 is bonded to the $R^W$ side.

From the viewpoint of the chemical stability and the carrier transport properties, $L^W$ is particularly preferably a divalent linking group containing a divalent linking group represented by Formula L-1, and more particularly preferably a divalent linking group represented by Formula L-1. It is the most preferable that $L^W$ is a divalent linking group represented by Formula L-1 and $R^W$ is a substituted or unsubstituted alkyl group.

In Formula W, $R^W$ represents a substituted or unsubstituted alkyl group, a cyano group, a vinyl group, an ethynyl group, an oxyethylene group, an oligo-oxyethylene group in which a repetition number v of an oxyethylene unit is equal to or greater than 2, a siloxane group, an oligosiloxane group having two or more silicon atoms, or a substituted or unsubstituted trialkylsilyl group.

In Formula W, in a case where $L^W$ adjacent to $R^W$ is a divalent linking group which is represented by Formula L-1, $R^W$ is preferably a substituted or unsubstituted alkyl group, an oxyethylene group, an oligo-oxyethylene group in which a repetition number v of an oxyethylene unit is equal to or greater than 2, a siloxane group, or an oligosiloxane group having two or more silicon atoms, and more preferably a substituted or unsubstituted alkyl group.

In Formula W, in a case where $L^W$ adjacent to $R^W$ is a divalent linking group which is represented by any one of Formula L-2 and Formulae L-4 to L-25, $R^W$ is more preferably a substituted or unsubstituted alkyl group.

In Formula W, in a case where $L^W$ adjacent to $R^W$ is a divalent linking group which is represented by Formula L-3, $R^W$ is preferably a substituted or unsubstituted alkyl group or a substituted or unsubstituted trialkylsilyl group.

In a case where $R^W$ is a substituted or unsubstituted alkyl group, the number of carbon atoms thereof is

preferably 4 to 17, more preferably 6 to 14 from the viewpoint of chemical stability and carrier transport properties, and even more preferably 6 to 12. It is preferable that R is a long-chain alkyl group having carbon atoms within the above range, particularly, a long-chain linear alkyl group, because then linearity of the molecule is improved, and hence mobility can be improved.

In a case where $R^W$ represents an alkyl group, the alkyl group may be linear, branched, or cyclic. It is preferable that the alkyl group is a linear alkyl group, because then linearity of the molecule is improved, and hence the carrier mobility can be improved.

Particularly, from the viewpoint of improving the carrier mobility, $R^W$ and $L^W$ in Formula W preferably form a combination in which $L^W$ in Formula 1 is a divalent linking group represented by Formula L-1 and $R^W$ is a linear alkyl group having 7 to 17 carbon atoms or a combination in which $L^W$ is a divalent linking group, in which a divalent linking group represented by any one of Formulae L-3, L-13, and L-18 and a divalent linking group represented by Formula L-1 are bonded to each other, and $R^W$ is a linear alkyl group.

In a case where $L^W$ is a divalent linking group represented by Formula L-1 and $R^W$ is a linear alkyl group having 7 to 17 carbon atoms, $R^W$ is more preferably a linear alkyl group having 7 to 14 carbon atoms from the viewpoint of improving the carrier mobility, and particularly preferably a linear alkyl group having 7 to 12 carbon atoms.

In a case where $L^W$ is a divalent linking group, in which a divalent linking group represented by any one of Formulae L-3, L-13, and L-18 and a divalent linking group represented by Formula L-1 are bonded to each other, and $R^W$ is a linear alkyl group, $R^W$ is more preferably a linear alkyl group having 4 to 17 carbon atoms, even more preferably a linear alkyl group having 6 to 14 carbon atoms from the viewpoint of the chemical stability and the carrier transport properties, and particularly preferably a linear alkyl group having 6 to 12 carbon atoms from the viewpoint of improving the carrier mobility.

In contrast, from the viewpoint of improving the solubility in an organic solvent, $R^W$ is preferably a branched alkyl group.

In a case where $R^W$ is an alkyl group having a substituent, examples of the substituent include a halogen atom, and the halogen atom is preferably a fluorine atom. In a case where $R^W$ is an alkyl group having a fluorine atom, all of the hydrogen atoms of the alkyl group may be substituted with fluorine atoms such that a perfluoroalkyl group is formed. Here, $R^W$ is preferably an unsubstituted alkyl group.

In the present specification, in a case where $R^W$ is an oligo-oxyethylene group in which a repetition number v of an oxyethylene group is equal to or greater than 2, the "oligo-oxyethylene group" represented by $R^W$ refers to a group represented by $-(OCH_2CH_2)_v-OY$ (the repetition number v of an oxyethylene unit represents an integer of equal to or greater than 2, and Y on the terminal represents a hydrogen atom or a substituent). In a case where Y on the terminal of the oligo-oxyethylene group is a hydrogen atom, the terminal becomes a hydroxyl group. The repetition number v of the oxyethylene unit is preferably 2 to 4, and more preferably 2 or 3.

It is preferable that the hydroxyl group on the terminal of the oligo-oxyethylene group is sealed. That is, it is preferable that Y represents a substituent. In this case, the hydroxyl group is preferably sealed with an alkyl group having 1 to 3 carbon atoms. That is, Y is preferably an alkyl group having 1 to 3 carbon atoms, more preferably a methyl group or an ethyl group, and particularly preferably a methyl group.

In a case where $R^W$ is a siloxane group or an oligosiloxane group having two or more silicon atoms, a repetition number of the siloxane unit is preferably 2 to 4, and more preferably 2 or 3. Furthermore, it is preferable that a hydrogen atom or an alkyl group is bonded to each silicon atom (Si atom). In a case where an alkyl group is bonded to the silicon atom, the number of carbon atoms of the alkyl group is preferably 1 to 3. For example, it is preferable that a methyl group or an ethyl group is bonded to the silicon atom. The same alkyl groups may be bonded to the silicon atoms, or different alkyl groups or hydrogen atoms may be bonded to the silicon atoms. All of the siloxane units constituting the oligosiloxane group may be the same as or different from each other, but it is preferable that all of them are the same as each other.

In a case where $L^W$ adjacent to $R^W$ is a divalent linking group represented by Formula L-3, $R^W$ is a substituted or unsubstituted trialkylsilyl group. In a case where $R^W$ is a substituted or unsubstituted trialkylsilyl group, a substituent of the silyl group in the trialkylsilyl group is not particularly limited as long as the substituent is a substituted or unsubstituted alkyl group, but the substituent is more preferably a branched alkyl group. The number of carbon atoms of the alkyl group bonded to each silicon atom is preferably 1 to 3. For example, it is preferable that a methyl group, an ethyl group, or an isopropyl group is bonded to the silicon atoms. The same alkyl groups or different alkyl groups may be bonded to the silicon atom. In a case where $R^W$ is a trialkylsilyl group further having a substituent on an alkyl group, the substituent is not particularly limited.

In Formula W, the total number of carbon atoms contained in $L^W$ and $R^W$ is preferably 5 to 18. If the total number of carbon atoms contained in $L^W$ and $R^W$ is equal to or greater than the lower limit of the above range, the carrier mobility is improved, and the driving voltage is lowered. If the total number of the carbon atoms contained in $L^W$ and $R^W$ is equal to or less than the upper limit of the above range, the solubility in an organic solvent is improved.

The total number of carbon atoms contained in $L^W$ and $R^W$ is preferably 5 to 14, more preferably 6 to 14, even

more preferably 6 to 12, and particularly preferably 8 to 12.

In the compound represented by Formula 1, among $R^{1a}$ to $R^{1f}$, the number of groups represented by Formula W is preferably 1 to 4, more preferably 1 or 2, and particularly preferably 2.

In the present invention, at least one of $R^{1a}$ or $R^{1b}$ in Formula 1 is preferably a group represented by Formula W. It is considered that from the viewpoint of excellent chemical stability of the compound, the highest occupied molecular orbital (HOMO) level, and packing in a film of molecules, the positions of $R^{1a}$ and $R^{1b}$ are suitable as substitution positions in Formula 1. Particularly, in Formula 1, if a substituent is on the two sites of $R^{1a}$ and $R^{1b}$, high carrier density can be obtained.

In Formula 1, $R^{1c}$ to $R^{1f}$ each independently preferably represent a hydrogen atom, a fluorine atom, a substituted or unsubstituted alkyl group having 1 to 3 carbon atoms, a substituted or unsubstituted alkynyl group having two or three carbon atoms, a substituted or unsubstituted alkenyl group having two or three carbon atoms, a substituted or unsubstituted alkoxy group having one or two carbon atoms, or a substituted or unsubstituted methylthio group.

-Compound represented by Formula 2-

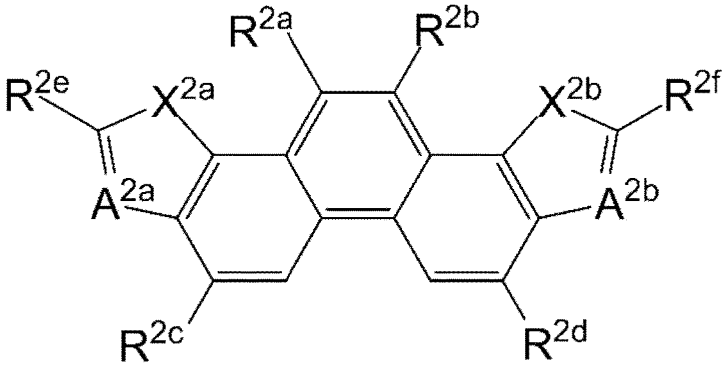

(2)

In Formula 2, $X^{2a}$ and $X^{2b}$ each independently represent $NR^{2i}$ (>N-$R^{2i}$), an O atom, or a S atom. From the viewpoint of ease of synthesis, $X^{2a}$ and $X^{2b}$ each independently preferably represent an O atom or a S atom. In contrast, from the viewpoint of improving the carrier mobility, at least one of $X^{2a}$ or $X^{2b}$ preferably represents a S atom.

$X^{2a}$ and $X^{2b}$ are preferably the same linking groups. It is more preferable that both of $X^{2a}$ and $X^{2b}$ are S atoms.

$R^{2i}$ represents a hydrogen atom, an alkyl group, an alkenyl group, an alkynyl group, or an acyl group. $R^{2i}$ is preferably a hydrogen atom or an alkyl group, more preferably an alkyl group having 1 to 14 carbon atoms, and particularly preferably an alkyl group having 1 to 4 carbon atoms.

In a case where $R^{2i}$ represents an alkyl group, the alkyl group may be linear, branched, or cyclic. It is preferable that the alkyl group is a linear alkyl group, because then the linearity of the molecule is improved, and hence the carrier mobility can be improved.

In Formula 2, $A^{2a}$ represents $CR^{2g}$ or a N atom, $A^{2b}$ represents $CR^{2h}$ or a N atom, and $R^{2g}$ and $R^{2h}$ each independently represent a hydrogen atom or a substituent. It is preferable that $A^{2a}$ represents $CR^{2g}$, or $A^{2b}$ represents $CR^{2h}$. It is more preferable that $A^{2a}$ represents $CR^{2g}$, and $A^{2b}$ represents $CR^{2h}$. $A^{2a}$ and $A^{2b}$ may be the same as or different from each other, but it is preferable that they are the same as each other.

In Formula 2, $R^{2e}$ and $R^{2g}$ may or may not for a ring by being bonded to each other, but it is preferable that they do not form a ring by being bonded to each other.

In Formula 2, $R^{2f}$ and $R^{2h}$ may or may not for a ring by being bonded to each other, but it is preferable that they do not form a ring by being bonded to each other.

In Formula 2, $R^{2a}$ to $R^{2h}$ each independently represent a hydrogen atom or a substituent, and at least one of $R^{2a}$, $R^{2b}$, $R^{2c}$, $R^{2d}$, $R^{2e}$, $R^{2f}$, $R^{2g}$, or $R^{2h}$ represents a substituent represented by Formula W.

Examples of the substituent that $R^{2a}$ to $R^{2h}$ can each independently adopt include the substituent X described above. The definition of the substituent represented by Formula W is as described above.

The substituent that $R^{2a}$ to $R^{2h}$ can each independently adopt is preferably an alkyl group, an aryl group, an alkenyl group, an alkynyl group, a heterocyclic group, an alkoxy group, an alkylthio group, or a substituent represented by Formula W, more preferably an alkyl group having 1 to 12 carbon atoms, an aryl group having 6 to 20 carbon atoms, an alkenyl group having 2 to 12 carbon atoms, an alkynyl group having 2 to 12 carbon atoms, an alkoxy group having

1 to 11 carbon atoms, a heterocyclic group having 5 to 12 carbon atoms, an alkylthio group having 1 to 12 carbon atoms, or a group represented by Formula W, particularly preferably a group having a chain length of a linking group, which will be described later, of equal to or less than 3.7 Å or a group represented by Formula W, and more particularly preferably a group represented by Formula W.

In the compound represented by Formula 2, among $R^{2a}$ to $R^{2h}$, the number of groups represented by Formula W is preferably 1 to 4 from the viewpoint of improving the carrier mobility and improving the solubility in an organic solvent, more preferably 1 or 2, and particularly preferably 2.

A group represented by Formula W can be positioned in any of $R^{2a}$ to $R^{2h}$ without particular limitation. From the viewpoint of improving the carrier mobility and improving the solubility in an organic solvent, the group represented by Formula W is preferably positoined in $R^{2e}$ or $R^{2f}$.

Among $R^{2a}$ to $R^{2h}$, the number of substituents other than a group represented by Formula W is preferably 0 to 4, more preferably 0 to 2, even more preferably 0 or 1, and particularly preferably 0.

In a case where $R^{2a}$ to $R^{2h}$ each represent a substituent other than a group represented by W, the substituent is preferably a group having a chain length of a linking group of equal to or less than 3.7 Å (= 0.37 nm), more preferably a group having a chain length of a linking group of 1.0 to 3.7 Å, and even more preferably a group having a chain length of a linking group of 1.0 to 2.1 Å.

The chain length of a linking group refers to a length from a C atom to the terminal of a substituent R in a C (carbon atom)-R bond. The calculation for structural optimization can be performed using a density functional method (Gaussian 03 (Gaussian, Inc)/basis function: 6-31G*, exchange-correlation functional: B3LYP/LANL2DZ). Regarding a molecular length of typical substituents, a propyl group has a molecular length of 4.6 Å, a pyrrole group has a molecular length of 4.6 Å, a propynyl group has a molecular length of 4.5 Å, a propenyl group has a molecular length of 4.6 Å, an ethoxy group has a molecular length of 4.5 Å, a methylthio group has a molecular length of 3.7 Å, an ethenyl group has a molecular length of 3.4 Å, an ethyl group has a molecular length of 3.5 Å, an ethynyl group has a molecular length of 3.6 Å, a methoxy group has a molecular length of 3.3 Å, a methyl group has a molecular length of 2.1 Å, and a hydrogen atom has a molecular length of 1.0 Å.

In a case where $R^{2a}$ to $R^{2h}$ represent substituents other than a group represented by Formula W, the substituents each independently preferably represent a substituted or unsubstituted alkyl group having two or less carbon atoms, a substituted or unsubstituted alkynyl group having two or less carbon atoms, a substituted or unsubstituted alkenyl group having two or less carbon atoms, or a substituted or unsubstituted acyl group having two or less carbon atoms, and more preferably represent a substituted or unsubstituted alkyl group having two or less carbon atoms.

In a case where $R^{2a}$ to $R^{2h}$ represent substituents other than a group represented by Formula W, and the substituents each independently represent a substituted alkyl group having two or less carbon atoms, examples of substituents that the alkyl group can have include a cyano group, a fluorine atom, a deuterium atom. Among these, a cyano group is preferable. In a case where $R^{2a}$ to $R^{2h}$ represent substituents other than a group represented by Formula W, the substituted or unsubstituted alkyl group having two or less carbon atoms that is represented by each of the substituents is preferably a methyl group, an ethyl group, or a methyl group substituted with a cyano group, more preferably a methyl group or a methyl group substitued with a cyano group, and particularly preferably a methyl group substituted with a cyano group.

In a case where $R^{2a}$ to $R^{2h}$ represent substituents other than a group represented by Formula W, and the substituents each independently represent a substitued alkynyl group having two or less carbon atoms, examples of substituents that the alkynyl group can have include a deuterium atom and the like. In a case where $R^{2a}$ to $R^{2h}$ represent substituents other than a group represented by Formula W, examples of the substituted or unsubstituted alkynyl group having two or less carbon atoms that is represented by each of the substituents include an ethynyl group and an acetylene group substitued with a deuterium atom. Between these, an ethynyl group is preferable.

In a case where $R^{2a}$ to $R^{2h}$ represent substituents other than a group represented by Formula W, and the substituents each independently represent a substituted alkenyl group having two or less carbon atoms, examples of substituents that the alkenyl group can have include a deuterium atom and the like. In a case where $R^{2a}$ to $R^{2h}$ represent substituents other than a group represented by Formula W, examples of the substituted or unsubstituted alkenyl group having two or less carbon atoms that is represented by each of the substituents include an ethenyl group and an ethenyl group substituted with a deuterium atom. Between these, an ethenyl group is preferable.

In a case where $R^{2a}$ to $R^{2h}$ represent substituents other than a group represented by Formula W, and the substituents each independently represent a substituted acyl group having two or less carbon atoms, examples of substituents that the acyl group can have include a fluorine atom and the like. In a case where $R^{2a}$ to $R^{2h}$ represent substituents other than a group represented by Formula W, examples of the substituted or unsubstituted acyl group having two or less carbon atoms that is represented by each of the substituents include a formyl group, an acetyl group, and an acetyl group substitued with fluorine. Among these, a formyl group is preferable.

-Compound represented by Formula 3-

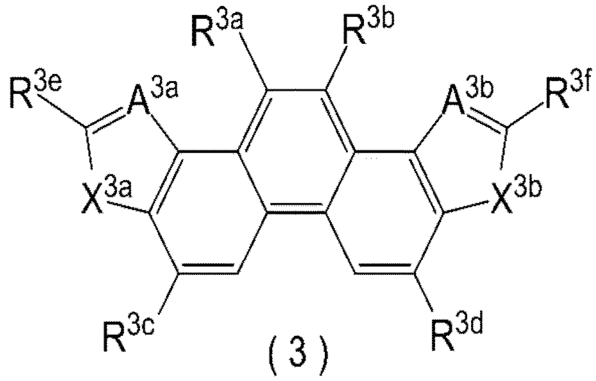

(3)

In Formula 3, $R^{3a}$ to $R^{3f}$ and $R^{3g}$ and $R^{3h}$, which will be described later, each independently represent a hydrogen atom or a substituent. Here, at least one of $R^{3a}$, $R^{3b}$, $R^{3c}$, $R^{3d}$, $R^{3e}$, $R^{3f}$, $R^{3g}$, or $R^{3h}$ represents a group represented by Formula W.

Examples of the substituent represented by $R^{3a}$ to $R^{3h}$ include the substituent X described above. The definition of a group represented by Formula W is as described above.

The substituent that $R^{3a}$ to $R^{3f}$ can each independently adppt is preferably an alkyl group, an aryl group, an alkenyl group, an alkynyl group, a heterocyclic group, an alkoxy group, an alkylthio group, or a substituent represented by Formula W, and more preferably an alkyl group having 1 to 12 carbon atoms, an aryl group having 6 to 20 carbon atoms, an alkenyl group having 2 to 12 carbon atoms, an alkynyl group having 2 to 12 carbon atoms, an alkoxy group having 1 to 11 carbon atoms, a heterocyclic group having 5 to 12 carbon atoms, an alkylthio group having 1 to 12 carbon atoms, or a group represented by Formula W.

In Formula 3, $X^{3a}$ and $X^{3b}$ each independently represent a S atom, an O atom, or $NR^{3g}$ ($>N-R^{3g}$), and $R^{3g}$ represents a hydrogen atom or a substituent. X is preferably a S atom or an O atom. In Formula 3, $X^{3a}$ and $X^{3b}$ are preferably the same as each other.

$R^{3g}$ is preferably a hydrogen atom, an alkyl group, or an aryl group, more preferably an alkyl group having 1 to 14 carbon atoms, and particularly preferably an alkyl group having 4 to 12 carbon atoms. It is preferable that $R^{3g}$ is a long-chain alkyl group having carbon atoms within the above range, particularly, a long-chain linear alkyl group, because then the linearity of the molecule is improved, and hence the carrier mobility can be improved.

In a case where $R^{3g}$ is an alkyl group, the alkyl group may be linear, branched, or cyclic. It is preferable that the alkyl group is a linear alkyl group, because then the linearity of the molecule is improved, and hence the carrier mobility can be improved.

In Formula 3, $A^{3a}$ and $A^{3b}$ each independently represent $CR^{3h}$ or a N atom. It is preferable that $A^{3a}$ and $A^{3b}$ each independently represent $CR^{3h}$. In Formula 3, $A^{3a}$ and $A^{3b}$ may be the same as or different from each other, but it is preferable that they are the same as each other.

$R^{3h}$ is a group having a chain length of a linking group of equal to or less than 3.7 Å, more preferably a group having a chain length of a linking group of 1.0 to 3.7 Å, and even more preferably a group having a chain length of a linking group of 1.0 to 2.1 Å. The definition of a chain length of a linking group is as described above.

$R^{3h}$ is preferably a hydrogen atom, a substituted or unsubstituted alkyl group having two or less carbon atoms, a substituted or unsubstituted alkynyl group having two or less carbon atoms, a substituted or unsubstituted alkenyl group having two or less carbon atoms, or a substituted or unsubstituted acyl group having two or less carbon atoms, more preferably a hydrogen atom or a substituted or unsubstituted alkyl group having two or less carbon atoms, and particularly preferably a hydrogen atom.

In a case where $R^{3h}$ represents a substituted alkyl group having two or less carbon atoms, examples of substituents that the alkyl group can have include a cyano group, a fluorine atom, a deuterium atom, and the like. Among these, a cyano group is preferable. The substituted or unsubstituted alkyl group having two or less carbon atoms that is represented by $R^{3h}$ is preferably a methyl group, an ethyl group, or a methyl group substituted with a cyano group, more preferably a methyl group or a methyl group substituted with a cyano group, and particularly preferably a methyl group substituted with a cyano group.

In a case where $R^{3h}$ represents a substituted alkynyl group having two or less carbon atoms, examples of substituents that the alkynyl group can have include a deuterium atom and the like. Examples of the substituted or

unsubstituted alkynyl group having two or less carbon atoms that is represented by $R^{3h}$ include an ethynyl group and an acetylene group substituted with a deuterium atom. Between these, an ethynyl group is preferable.

In a case where $R^{3h}$ represents a substituted alkenyl group having two or less carbon atoms, examples of substituents that the alkenyl group can have include a deuterium atom and the like. Examples of the substituted or unsubstituted alkenyl group having two or less carbon atoms that is represented by $R^{3h}$ include an ethenyl group and an ethenyl group substituted with a deuterium atom. Between these, an ethenyl group is preferable.

In a case where $R^{3h}$ represents a substituted acyl group having two or less carbon atoms, examples of substituents that the acyl group can have include a fluorine atom and the like. Examples of the substituted or unsubstituted acyl group having two or less carbon atoms that is represented by $R^{3h}$ include a formyl group, an acetyl group, and an acetyl group substituted with a fluorine atom. Among these, a formyl group is preferable.

-Compound represented by Formula 4-

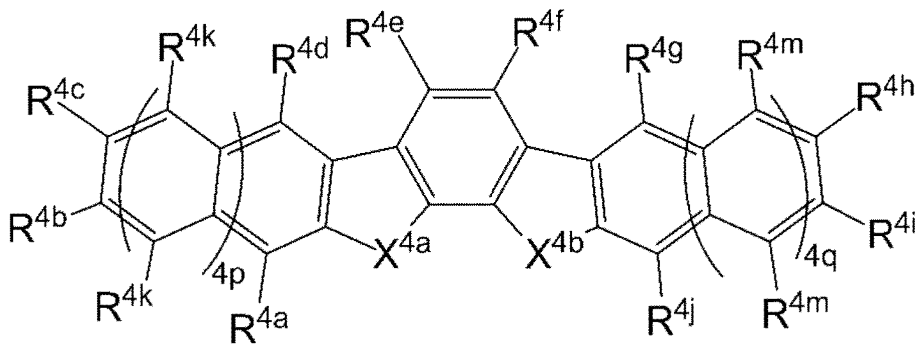

(4)

In Formula 4, $X^{4a}$ and $X^{4b}$ each independently represent an O atom, a S atom, or a Se atom.

It is preferable that $X^{4a}$ and $X^{4b}$ each independently represent an O atom or a S atom. From the viewpoint of improving the carrier mobility, it is more preferable that at least one of $X^{4a}$ or $X^{4b}$ is a S atom. It is preferable that $X^{4a}$ and $X^{4b}$ are the same linking groups. It is particularly preferable that both of $X^{4a}$ and $X^{4b}$ are S atoms.

In Formula (4), 4p and 4q each independently represent an integer of 0 to 2. It is preferable that 4p and 4q each independently represent 0 or 1, because then mobility and solubility can be achieved at the same time. It is more preferable that 4p = 4q = 0 or 4p = 4q = 1.

In Formula 4, $R^{4a}$ to $R^{4k}$ and $R^{4m}$ each independently represent a hydrogen atom, a halogen atom, or a group represented by Formula W, and at least one of $R^{4a}$, $R^{4b}$, $R^{4c}$, $R^{4d}$, $R^{4e}$, $R^{4f}$, $R^{4g}$, $R^{4h}$, $R^{4i}$, $R^{4j}$, $R^{4k}$, or $R^{4m}$ is a group represented by Formula W. Here, in a case where at least one of $R^{4e}$ or $R^{4f}$ is a group represented by Formula W, in W represented by $R^{4e}$ and $R^{4f}$, $L^W$ is a divalent linking group represented by Formula L-2 or L-3. The definition of a group represented by Formula W is as described above.

The case where at least one of $R^{4e}$ or $R^{4f}$ is a group represented by Formula W corresponds to a case where none of $R^{4e}$ and $R^{4f}$ are a hydrogen atom or a halogen atom.

In a case where at least one of $R^{4e}$ or $R^{4f}$ is a group represented by Formula W, in W represented by $R^{4e}$ or $R^{4f}$, $L^W$ is preferably a divalent linking group represented by Formula L-3.

In a case where at least one of $R^{4e}$ or $R^{4f}$ is a group represented by Formula W, both of $R^{4e}$ and $R^{4f}$ preferably represent a group represented by Formula W.

In a case where both of $R^{4e}$ and $R^{4f}$ represent a hydrogen atom or a halogen atom, $R^{4a}$ to $R^{4d}$, $R^{4g}$ to $R^{4k}$, and $R^{4m}$ each independently represent a hydrogen atom, a halogen atom, or a group represented by Formula W, and at least one or more out of $R^{4a}$, $R^{4b}$, $R^{4c}$, $R^{4d}$, $R^{4g}$, $R^{4h}$, $R^{4i}$, $R^{4j}$, $R^{4k}$, or $R^{4m}$ is a group represented by Formula W.

Examples of the halogen atom represented by $R^{4a}$ to $R^{4k}$ and $R^{4m}$ in Formula 4 include a fluorine atom, a chlorine atom, a bromine atom, and an iodine atom. The halogen atom is preferably a fluorine atom, a chlorine atom, or a bromine atom, more preferably a fluorine atom or a chlorine atom, and particularly preferably a fluorine atom.

In $R^{4a}$ to $R^{4k}$ and $R^{4m}$ in the compound represented by Formula 4, the number of halogen atoms is preferably 0 to 4, more preferably 0 to 2, even more preferably 0 or 1, and particularly preferably 0.

In the compound represented by Formula 4, among $R^{4a}$ to $R^{4k}$ and $R^{4m}$, the number of groups represented by Formula W is preferably 1 to 4 from the viewpoint of improving the carrier mobility and improving the solubility in an organic solvent, more preferably 1 or 2, and particularly preferably 2.

A group represented by Formula W can be positioned in any of $R^{4a}$ to $R^{4k}$ and $R^{4m}$ without particular limitation. In the present invention, from the viewpoint of improving the carrier mobility and improving the solubility in an organic

solvent, it is preferable that, in Formula 4, $R^{4a}$, $R^{4d}$ to $R^{4g}$, $R^{4j}$, $R^{4k}$, and $R^{4m}$ each independently represent a hydrogen atom or a halogen atom, $R^{4b}$, $R^{4c}$, $R^{4h}$, and $R^{4i}$ each independently represent a hydrogen atom, a halogen atom, or a group represented by Formula W, and at least one of $R^{4b}$, $R^{4c}$, $R^{4h}$, or $R^{4i}$ is a group represented by Formula W.

In the present invention, it is more preferable that $R^{4a}$, $R^{4c}$ to $R^{4h}$, and $R^{4j}$ each independently represent a hydrogen atom or a halogen atom, $R^{4b}$ and $R^{4i}$ each independently represent a hydrogen atom, a halogen atom, or a group represented by Formula W, and at least one of $R^{4b}$ or $R^{4i}$ is a group represented by Formula W.

In the present invention, it is even more preferable that both of $R^{4b}$ and $R^{4i}$ represent a group represented by Formula W, both of $R^{4c}$ and $R^{4h}$ represent a hydrogen atom or a halogen atom, or both of $R^{4c}$ and $R^{4h}$ represent a group represented by Formula W, and both of $R^{4b}$ and $R^{4i}$ represent a hydrogen atom or a halogen atom.

In the present invention, it is particularly preferable that both of $R^{4b}$ and $R^{4i}$ represent a group represented by Formula W and both of $R^{4c}$ and $R^{4h}$ represent a hydrogen atom or a halogen atom, or both of $R^{4c}$ and $R^{4h}$ represent a group represented by Formula W and both of $R^{4b}$ and $R^{4i}$ represent a hydrogen atom and a halogen atom.

In Formula 4, two or more groups among $R^{4a}$ to $R^{4k}$ and $R^{4m}$ may or may not form a ring by being bonded to each other, but it is preferable that they do not form a ring by being bonded to each other.

-Compound represented by Formula 5-

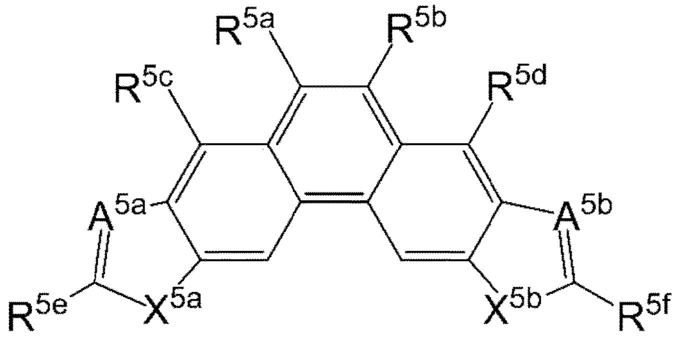

(5)

In Formula 5, $X^{5a}$ and $X^{5b}$ each independently represent $NR^{5i}$, an O atom, or a S atom. From the viewpoint of ease of synthesis, it is preferable that $X^{5a}$ and $X^{5b}$ each independently represent an O atom or a S atom. In contrast, from the viewpoint of improving the carrier mobility, it is preferable that at least one of $X^{5a}$ or $X^{5b}$ is a S atom. It is preferable that $X^{5a}$ and $X^{5b}$ are the same linking groups. It is more preferable that both of $X^{5a}$ and $X^{5b}$ are S atoms.

$R^{5i}$ represents a hydrogen atom, an alkyl group, an alkenyl group, an alkynyl group, an acyl group, an aryl group, or a heteroaryl group. $R^{5i}$ is preferably a hydrogen atom, an alkyl group, an alkenyl group, an alkynyl group, or an acyl group, more preferably a hydrogen atom or an alkyl group, even more preferably an alkyl group having 1 to 14 carbon atoms, and preferably an alkyl group having 1 to 4 carbon atoms.

In a case where $R^{5i}$ is an alkyl group, the alkyl group may be linear, branched, or cyclic. It is preferable that $R^{5i}$ is a linear alkyl group, because then the linearity of the molecule is improved, and hence the carrier mobility can be improved.

In Formula 5, $A^{5a}$ represents $CR^{5g}$ or a N atom, $A^{5b}$ represents $CR^{5h}$ or a N atom, and $R^{5g}$ and $R^{5h}$ each independently represent a hydrogen atom or a substituent. It is preferable that $A^{5a}$ represents $CR^{5g}$ or $A^{5b}$ represents $CR^{5h}$. It is more preferable that $A^{5a}$ represents $CR^{5g}$ and $A^{5b}$ represents $CR^{5h}$. $A^{5a}$ and $A^{5b}$ may be the same as or different from each other, but it is preferable that they are the same as each other.

In Formula 5, $R^{5e}$ and $R^{5g}$ may or may not form a ring by being bonded to each other, but it is preferable that they do not form a ring by being bonded to each other.

In Formula 5, $R^{5e}$ and $R^{5i}$ may or may not form a ring by being bonded to each other, but it is preferable that they do not form a ring by being bonded to each other.

In Formula 5, $R^{5f}$ and $R^{5h}$ may or may not form a ring by being bonded to each other, but it is preferable that they do not form a ring by being bonded to each other.

In Formula 5, $R^{5f}$ and $R^{5i}$ may or may not form a ring by being bonded to each other, but it is preferable that they do not form a ring by being bonded to each other.

In Formula 5, $R^{5a}$ to $R^{5h}$ each independently represent a hydrogen atom or a substituent, and at least one of $R^{5a}$, $R^{5b}$, $R^{5c}$, $R^{5d}$, $R^{5e}$, $R^{5f}$, $R^{5g}$, or $R^{5h}$ is a group represented by Formula W.

Examples of the substituent represented by $R^{5a}$ to $R^{5h}$ include the substituent X described above. The definition of a group represented by Formula W is as described above.

In the compound represented by Formula 5, among $R^{5a}$ to $R^{5h}$, the number of groups represented by Formula W is preferably 1 to 4 from the viewpoint of improving the carrier mobility and improving the solubility in an organic solvent, more preferably 1 or 2, and particularly preferably 2.

A group represented by Formula W can be positioned in any of $R^{5a}$ to $R^{5h}$ without particular limitation. From the viewpoint of improving mobility and improving solubility in an organic solvent, the group represented by Formula W is preferably positioned in $R^{5e}$ or $R^{5f}$.

Among $R^{5a}$ to $R^{5h}$, the number of substituents other than a group represented by Formula W is preferably 0 to 4, more preferably 0 to 2, particularly preferably 0 or 1, and more particularly preferably 0.

In a case where $R^{5a}$ to $R^{5h}$ represent substituents other than a group represented by Formula W, each of the substituents is preferably a group having a chain length of a linking group of equal to or less than 3.7 Å, more preferably a group having a chain length of a linking group of 1.0 to 3.7 Å, even more preferably a group having a chain length of a linking group of 1.0 to 2.1 Å. The definition of a chain length of a linking group is as described above.

In a case where $R^{5a}$ to $R^{5h}$ represent substituents other than a group represented by Formula W, the substituents each independently preferably represent a substituted or unsubstituted alkyl group having two or less carbon atoms, a substituted or unsubstituted alkynyl group having two or less carbon atoms, a substituted or unsubstituted alkenyl group having two or less carbon atoms, or a substituted or unsubstituted acyl group having two or less carbon atoms, and more preferably represent a substituted or unsubstituted alkyl group having two or less carbon atoms.

In a case where $R^{5a}$ to $R^{5h}$ represent substituents other than a group represented by Formula W, and the substituents each independently represent a substituted alkyl group having two or less carbon atoms, examples of substituents that the alkyl group can have include a cyano group, a fluorine atom, a deuterium atom, and the like. Among these, a cyano group is preferable. In a case where $R^{5a}$ to $R^{5h}$ represent substituents other than a group represented by Formula W, the substituted or unsubstituted alkyl group having two or less carbon atoms that is represented by each of the substituents is preferably a methyl group, an ethyl group, or a methyl group substituted with a cyano group, more preferably a methyl group or a methyl group substituted with a cyano group, and particularly preferably a methyl group substituted with a cyano group.

In a case where $R^{5a}$ to $R^{5h}$ represent substituents other than a group represented by Formula W, and the substituents each independently represent a substituted alkynyl group having two or less carbon atoms, examples of substituents that the alkynyl group can have include a deuterium atom and the like. In a case where $R^{5a}$ to $R^{5h}$ represent substituents other than a substituent represented by Formula W, examples of the substituted or unsubstituted alkynyl group having two or less carbon atoms that is represented by each of the substituents include an ethynyl group or an acetylene group substituted with a deuterium atom. Between these, an ethynyl group is preferable.

In a case where $R^{5a}$ to $R^{5h}$ represent substituents other than a group represented by Formula W, and the substituents each independently represent a substituted alkenyl group having two or less carbon atoms, examples of substituents that the alkenyl group can have include deuterium atom and the like. In a case where $R^{5a}$ to $R^{5h}$ represent substituents other than a group represented by Formula W, examples of the substituted or unsubstituted alkenyl group having two or less carbon atoms that is represented by each of the substituents include an ethenyl group and an ethenyl group substituted with a deuterium atom. Between these, an ethenyl group is preferable.

In a case where $R^{5a}$ to $R^{5h}$ represent substituents other than a group represented by Formula W, and the substituents each independently represent a substituted acyl group having two or less carbon atoms, examples of substituents that the acyl group can have include a fluorine atom and the like. In a case where $R^{5a}$ to $R^{5h}$ represent substituents other than a group represented by Formula W, examples of the substituted or unsubstituted acyl group having two or less carbon atoms that is represented by each of the substituents include a formyl group, an acetyl group, and an acetyl group substituted with a fluorine atom. Among these, a formyl group is preferable.

-Compound represented by Formula 6-

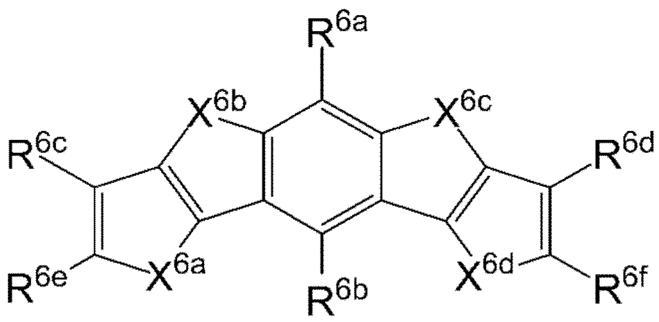

(6)

In Formula 6, $X^{6a}$ to $X^{6d}$ each independently represent $NR^{6g}$, an O atom, or a S atom, and $R^{6g}$ represents a hydrogen atom, an alkyl group, an alkenyl group, an alkynyl group, an acyl group, an aryl group, or a heteroaryl group.

From the viewpoint of ease of synthesis, it is preferable that $X^{6a}$ to $X^{6d}$ each independently represent an O atom or a S atom. In contrast, from the viewpoint of improving the carrier mobility, at least one of $X^{6a}$, $X^{6b}$, $X^{6c}$, or $X^{6d}$ is a S atom. It is preferable that $X^{6a}$ to $X^{6d}$ are the same linking groups. It is more preferable that all of $X^{6a}$ to $X^{6d}$ are S atoms.

$R^{6g}$ represents a hydrogen atom, an alkyl group, an alkenyl group, an alkynyl group, an acyl group, an aryl group, or a heteroaryl group. $R^{6g}$ is preferably a hydrogen atom, an alkyl group, an alkenyl group, an alkynyl group, or an acyl group, more preferably a hydrogen atom or an alkyl group, even more preferably an alkyl group having 1 to 14 carbon atoms, and particularly preferably an alkyl group having 1 to 4 carbon atoms.

In a case where $R^{6g}$ represents an alkyl group, the alkyl group may be linear, branched, or cyclic. However, it is preferable that $R^{6g}$ is a linear alkyl group, because then the linearity of the molecule is improved, and hence the carier mobility can be improved.

In Formula 6, $R^{6a}$ to $R^{6f}$ each independently represent a hydrogen atom or a substituent, and at least one of $R^{6a}$, $R^{6b}$, $R^{6c}$, $R^{6d}$, $R^{6e}$, or $R^{6f}$ represents a group represented by Formula W.

Examples of the substituents represented by $R^{6a}$ to $R^{6f}$ include the substituent X described above. The definition of a group represented by Formula W is as described above.

Among the substituents, the substituent that $R^{6a}$ to $R^{6f}$ can each independently adopt is preferably an alkyl group, an aryl group, an alkenyl group, an alkynyl group, a heterocyclic group, an alkoxy group, an alkylthio group, or a group represented by Formula W, more preferably an alkyl group having 1 to 12 carbon atoms, an aryl group having 6 to 20 carbon atoms, an alkenyl group having 2 to 12 carbon atoms, an alkynyl group having 2 to 12 carbon atoms, an alkoxy group having 1 to 11 carbon atoms, a heterocyclic group having 5 to 12 carbon atoms, an alkylthio group having 1 to 12 carbon atoms, or a group represented by Formula W, even more preferably a group, which will be described later, having a chain length of a linking group of equal to or less than 3.7 Å or a group represented by Formula W, and particularly preferably a group represented by Formula W.

In the compound represented by Formula 6, among $R^{6a}$ to $R^{6f}$, the number of groups represented by Formula W is preferably 1 to 4 from the viewpoint of improving the carrier mobility and improving the solubility in an organic solvent, more preferably 1 or 2, and particularly preferably 2.

A group represented by Formula W can be positioned in any of $R^{6a}$ to $R^{6f}$ without particular limitation, but the group represented by Formula W is preferably positioned in $R^{6c}$ to $R^{6f}$. From the viewpoint of improving the carrier mobility and improving the solubility in an organic solvent, the group represented by Formula W is more preferably positioned in $R^{6e}$ or $R^{6f}$.

Among $R^{6a}$ to $R^{6f}$, the number of substituents other than a group represented by Formula W is preferably 0 to 4, more preferably 0 to 2, even more preferably 0 or 1, and particularly preferably 0.

In a case where $R^{6a}$ to $R^{6f}$ represent substituents other than a group represented by Formula W, each of the substituents is preferably a group having a chain length of a linking group of equal to or less than 3.7 Å, more preferably a group having a chain length of a linking group of 1.0 to 3.7 Å, and even more preferably a group having a chain length of a linking group of 1.0 to 2.1 Å. The definition of a chain length of a linking group is as described above.

In a case where $R^{6a}$ to $R^{6f}$ represent substituents other than a group represented by Formula W, the substituents each independently preferably represent a substituted or unsubstituted alkyl group having two or less carbon atoms, a substituted or unsubstituted alkynyl group having two or less carbon atoms, a substituted or unsubstituted alkenyl group having two or less carbon atoms, or a substituted or unsubstituted acyl group having two or less carbon atoms, and more preferably a substituted or unsubstituted alkyl group having two or less carbon atoms.

In a case where $R^{6a}$ to $R^{6f}$ represent substituents other than a group represented by Formula W, and the substituents each independently represent a substituted alkyl group having two or less carbon atoms, examples of

substituents that the alkyl group can have include a cyano group, a fluorine atom, a deuterium atom, and the like. Among these, a cyano group is preferable. In a case where $R^{6a}$ to $R^{6f}$ represent substituents other than a group represented by Formula W, the substituted or unsubstituted alkyl group having two or less carbon atoms that is represented by each of the substituents is preferably a methyl group, an ethyl group, or a methyl group substituted with a cyano group, more preferably a methyl group or a methyl group substituted with a cyano group, and particularly preferably a methyl group substituted with a cyano group.

In a case where $R^{6a}$ to $R^{6f}$ represent substituents other than a group represented by Formula W, and the substituents each independently represent a substituted alkynyl group having two or less carbon atoms, examples of substituents that the alkynyl group can have include a deuterium atom and the like. In a case where $R^{6a}$ to $R^{6f}$ represent substituents other than a group represented by Formula W, examples of the substituted or unsubstituted alkynyl group having two or less carbon atoms that is represented by each of the substituents include an ethynyl group and an acetylene group substituted with a deuterium atom. Between these, an ethynyl group is preferable.

In a case where $R^{6a}$ to $R^{6f}$ represent substituents other than a group represented by Formula W, and the substituents each independently represent a substituted alkenyl group having two or less carbon atoms, examples of substituents that the alkenyl group can have include a deuterium atom and the like. In a case where $R^{6a}$ to $R^{6f}$ represent substituents other than a group represented by Formula W, examples of the substituted or unsubstituted alkenyl group having two or less carbon atoms that is represented by each of the substituents include ethenyl group and an ethenyl group substituted with a deuterium atom. Among these, an ethenyl group is preferable.

In a case where $R^{6a}$ to $R^{6f}$ represent substituents other than a group represented by Formula W, and the substituents each independently represent a substituted acyl group having two or less carbon atoms, examples of substituents that the acyl group can have include a fluorine atom and the like. In a case where $R^{6a}$ to $R^{6f}$ represent substituents other than a group represented by Formula W, examples of the substituted or unsubstituted acyl group having two or less carbon atoms that is represented by each of the substituents include a formyl group, an acetyl group, and an acetyl group substituted with a fluorine atom. Among these, a formyl group is preferable.

-Compound represented by Formula 7-

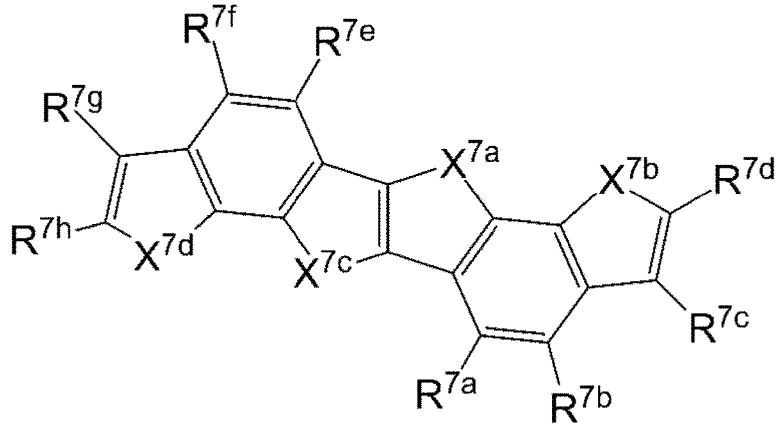

(7)

In Formula 7, $X^{7a}$ and $X^{7c}$ each independently represent a S atom, an O atom, a Se atom, or $NR^{7i}$ (>N-$R^{7i}$), and $X^{7b}$ and $X^{7d}$ each independently represent a S atom, an O atom, or a Se atom. From the viewpoint of ease of synthesis, it is preferable that $X^{7a}$ to $X^{7d}$ each independently represent an O atom or a S atom. In contrast, from the viewpoint of improving the carrier mobility, it is preferable that at least one of $X^{7a}$, $X^{7b}$, $X^{7c}$, or $X^{7d}$ is a S atom. It is preferable that $X^{7a}$ to $X^{7d}$ are the same linking groups. It is more preferable that all of $X^{7a}$ to $X^{7d}$ are S atoms.

In Formula 7, $R^{7a}$ to $R^{7i}$ each independently represent a hydrogen atom or a substituent, and at least one of $R^{7a}$, $R^{7b}$, $R^{7c}$, $R^{7d}$, $R^{7e}$, $R^{7f}$, $R^{7g}$, $R^{7h}$, or $R^{7i}$ is a group represented by Formula W.

Examples of the substituent represented by $R^{7a}$ to $R^{7i}$ include the substituent X described above. The definition of a group represented by Formula W is as described above.

$R^{7i}$ is preferably a hydrogen atom or an alkyl group, more preferably an alkyl group having 5 to 12 carbon atoms, and particularly preferably an alkyl group having 8 to 10 carbon atoms.

In a case where $R^{7i}$ represents an alkyl group, the alkyl group may be linear, branched, or cyclic. However,

from the viewpoint of overlapping of HOMO, it is preferable that $R^{7i}$ is a linear alkyl group.

In $R^{7a}$ to $R^{7i}$ in the compound represented by Formula 7, the number of substituents represented by Formula W is preferably 1 to 4 from the viewpoint of improving the carrier mobility and improving the solubility in an organic solvent, more preferably 1 or 2, and particularly preferably 2.

A group represented by Formula W can be positioned in any of $R^{7a}$ to $R^{7i}$ without particular limitation. The group represented by Formula W is preferably positioned in $R^{7d}$ or $R^{7h}$ from the viewpoint of improving the carrier mobility and improving the solubility in an organic solvent, and more preferably positioned in $R^{7d}$ and $R^{7h}$.

Among $R^{7a}$ to $R^{7i}$ of Formula 7, the number of substituents other than a group represented by Formula W is preferably 0 to 4, more preferably 0 to 2, even more preferably 0 or 1, and particularly preferably 0.

In a case where $R^{7a}$ to $R^{7i}$ are substituents other than a group represented by Formula W, each of the substituents is preferably a group having a chain length of a linking group of equal to or less than 3.7 Å, more preferably a group having a chain length of a linking group of 1.0 to 3.7 Å, and even more preferably a group having a chain length of a linking group of 1.0 to 2.1 Å. The definition of a chain length of a linking group is as described above.

In a case where $R^{7a}$ to $R^{7i}$ are substituents other than a group represented by Formula W, the substituents each independently preferably represent a substituted or unsubstituted alkyl group having two or less carbon atoms, a substituted or unsubstituted alkynyl group having two or less carbon atoms, a substituted or unsubstituted alkenyl group having two or less carbon atoms, or a substituted or unsubstituted acyl group having two or less carbon atoms, and more preferably represent a substituted or unsubstituted alkyl group having two or less carbon atoms.

In a case where $R^{7a}$ to $R^{7i}$ are substituents other than a group represented by Formula W, and the substituents each independently represent a substituted alkyl group having two or less carbon atoms, examples of substituents that the alkyl group can have include a cyano group, a fluorine atom, a deuterium atom, and the like. Among these, a cyano group is preferable. In a case where $R^{7a}$ to $R^{7i}$ are substituents other than a group represented by Formula W, the substituted or unsubstituted alkyl group having two or less carbon atoms that is represented by each of the substituents is preferably a methyl group, an ethyl group, or a methyl group substituted with a cyano group, more preferably a methyl group or a methyl group substituted with a cyano group, and particularly preferably a methyl group substituted with a cyano group.

In a case where $R^{7a}$ to $R^{7i}$ are substituents other than a group represented by Formula W, and the substituents each independently represent a substituted alkynyl group having two or less carbon atoms, examples of substituents that the alkynyl group can have include a deuterium atom and the like. In a case where $R^{7a}$ to $R^{7i}$ are substituents other than a substituent represented by Formula W, examples of the substituted or unsubstituted alkynyl group having two or less carbon atoms that is represented by each of the substituents include an ethynyl group and an acetylene group substituted with a deuterium atom. Between these, an ethynyl group is preferable.

In a case where $R^{7a}$ to $R^{7i}$ are substituents other than a group represented by Formula W, and the substituents each independently represent a substituted alkenyl group having two or less carbon atoms, examples of substituents that the alkenyl group can have include a deuterium atom and the like. In a case where $R^{7a}$ to $R^{7i}$ are substituents other than a substituent represented by Formula W, examples of the substituted or unsubstituted alkenyl group having two or less carbon atoms that is represented by each of the substituents include an ethenyl group and an ethenyl group substituted with a deuterium atom. Between these, an ethenyl group is preferable.

In a case where $R^{7a}$ to $R^{7i}$ are substituents other than a group represented by Formula W, and the substituents each independently represent a substituted acyl group having two or less carbon atoms, examples of substituents that the acyl group can have include a fluorine atom and the like. In a case where $R^{7a}$ to $R^{7i}$ are substituents other than a substituent represented by Formula W, examples of the substituted or unsubstituted acyl group having two or less carbon atoms that is represented by each of the substituents include a formyl group, an acetyl group, and an acetyl group substituted with a fluorine atom. Among these, a formyl group is preferable.

-Compound represented by Formula 8-

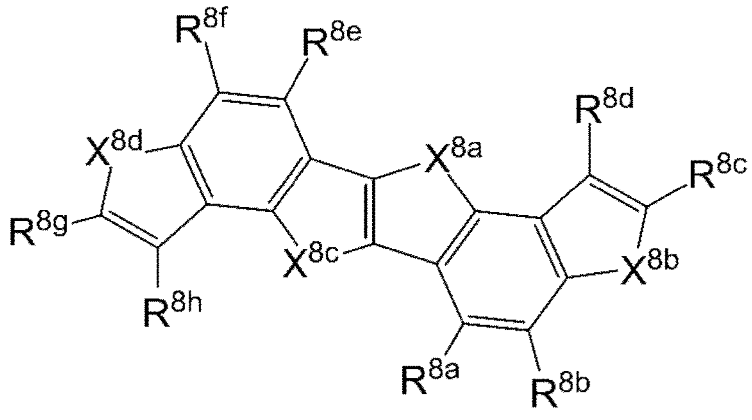

(8)

In Formula 8, $X^{8a}$ and $X^{8c}$ each independently represent a S atom, an O atom, a Se atom, or $NR^{8i}$, and $X^{8b}$ and $X^{8d}$ each independently represent a S atom, an O atom, or a Se atom. From the viewpoint of ease of synthesis, it is preferable that $X^{8a}$ to $X^{8d}$ each independently represent an O atom or a S atom. In contrast, from the viewpoint of improving the carrier mobility, it is preferable that at least one of $X^{8a}$, $X^{8b}$, $X^{8c}$, or $X^{8d}$ is a S atom. It is preferable that $X^{8a}$ to $X^{8d}$ are the same linking groups. It is more preferable that all of $X^{8a}$ to $X^{8d}$ are S atoms.

In Formula 8, $R^{8a}$ to $R^{8i}$ each independently represent a hydrogen atom or a substituent, and at least one of $R^{8a}$, $R^{8b}$, $R^{8c}$, $R^{8d}$, $R^{8e}$, $R^{8f}$, $R^{8g}$, $R^{8h}$, or $R^{8i}$ is a group represented by Formula W.

Examples of the substituent represented by $R^{8a}$ to $R^{8i}$ include the substituent X described above. The definition of a group represented by Formula W is as described above.

$R^{8i}$ is preferably a hydrogen atom or an alkyl group, more preferably an alkyl group having 5 to 12 carbon atoms, and particularly preferably an alkyl group having 8 to 10 carbon atoms.

In a case where $R^{8i}$ is an alkyl group, the alkyl group may be linear, branched, or cyclic. From the viewpoint of the overlapping of HOMO, $R^{8i}$ is preferably a linear alkyl group.

In the compound represented by Formula 8, among $R^{8a}$ to $R^{8i}$, the number of substituents represented by Formula W is preferably 1 to 4 from the viewpoint of improving mobility and improving solubility in an organic solvent, more preferably 1 or 2, and particularly preferably 2.

A group represented by Formula W can be positioned in any of $R^{8a}$ to $R^{8i}$ without particular limitation. The group represented by Formula W is preferably positioned in $R^{8c}$ or $R^{8g}$ from the viewpoint of improving the carrier mobility and improving the solubility in an organic solvent, and more preferably positioned in $R^{8c}$ and $R^{8g}$.

Among $R^{8a}$ to $R^{8i}$ of Formula 8, the number of substituents other than a group represented by Formula W is preferably 0 to 4, more preferably 0 to 2, even more preferably 0 or 1, and particularly preferably 0.

In a case where $R^{8a}$ to $R^{8i}$ are substituents other than a group represented by Formula W, each of the substituents is preferably a group having a chain length of a linking group of equal to or less than 3.7 Å, more preferably a group having a chain length of a linking group of 1.0 to 3.7 Å, and even more preferably a group having a chain length of a linking group of 1.0 to 2.1 Å. The definition of a chain length of a linking group is as described above.

In a case where $R^{8a}$ to $R^{8i}$ are substituents other than a group represented by Formula W, the substituents each independently preferably represent a substituted or unsubstituted alkyl group having two or less carbon atoms, a substituted or unsubstituted alkynyl group having two or less carbon atoms, a substituted or unsubstituted alkenyl group having two or less carbon atoms, or a substituted or unsubstituted acyl group having two or less carbon atoms, and more preferably represent a substituted or unsubstituted alkyl group having two or less carbon atoms.

In a case where $R^{8a}$ to $R^{8i}$ are substituents other than a group represented by Formula W, and the substituents each independently represent a substituted alkyl group having two or less carbon atoms, examples of substituents that the alkyl group can have include a cyano group, a fluorine atom, a deuterium atom, and the like. Among these, a cyano group is preferable. In a case where $R^{8a}$ to $R^{8i}$ are substituents other than a group represented by Formula W, the substituted or unsubstituted alkyl group having two or less carbon atoms that is represented by each of the substituents is preferably methyl group, an ethyl group, or a methyl group substituted with a cyano group, more preferably a methyl group or a methyl group substituted with a cyano group, and particularly preferably a methyl group substituted with a cyano group.

In a case where $R^{8a}$ to $R^{8i}$ are substituents other than a group represented by Formula W, and the substituents each independently represent a substituted alkynyl group having two or less carbon atoms, examples of substituents that the alkynyl group can have include a deuterium atom and the like. In a case where $R^{8a}$ to $R^{8i}$ are substituents other than a group represented by Formula W, examples of the substituted or unsubstituted alkynyl group having two or less

carbon atoms that is represented by each of the substituents include an ethynyl group and an acetylene group substituted with a deuterium atom. Between these, an ethynyl group is preferable.

In a case where $R^{8a}$ to $R^{8i}$ are substituents other than a group represented by Formula W, and the substituents each independently represent a substituted alkenyl group having two or less carbon atoms, examples of substituents that the alkenyl group can have include a deuterium atom and the like. In a case where $R^{8a}$ to $R^{8i}$ are substituents other than a group represented by Formula W, examples of the substituted or unsubstituted alkenyl group having two or less carbon atoms that is represented by each of the substituents include an ethenyl group and an ethenyl group substituted with a deuterium atom. Between these, an ethenyl group is preferable.

In a case where $R^{8a}$ to $R^{8i}$ are substituents other than a group represented by Formula W, and the substituents each independently represent a substituted acyl group having two or less carbon atoms, examples of substituents that the acyl group can have include a fluorine atom and the like. In a case where $R^{8a}$ to $R^{8i}$ are substituents other than a group represented by Formula W, examples of the substituted or unsubstituted acyl group having two or less carbon atoms that is represented by each of the substituents include a formyl group, an acetyl group, and an acetyl group substituted with a fluorine atom. Among these, a formyl group is preferable.

-Compound represented by Formula 9-

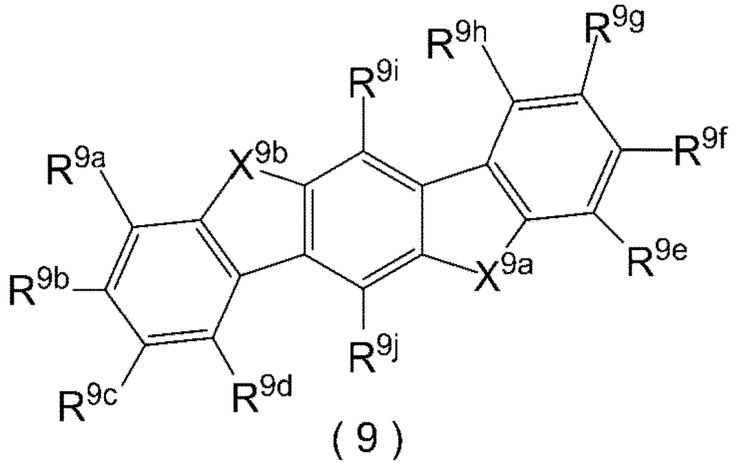

(9)

In Formula 9, $X^{9a}$ and $X^{9b}$ each independently represent an O atom, a S atom, or a Se atom. Among these, a S atom is preferable.

$R^{9c}$, $R^{9d}$, and $R^{9g}$ to $R^{9j}$ each independently represent a hydrogen atom, a halogen atom, or a substituent represented by Formula W. The definition of a group represented by Formula W is as described above.

$R^{9a}$, $R^{9b}$, $R^{9e}$, and $R^{9f}$ each independently represent a hydrogen atom or a substituent. Examples of the substituent represented by $R^{9a}$, $R^{9b}$, $R^{9e}$, and $R^{9f}$ include the substituent X described above.

It is preferable that $R^{9c}$, $R^{9d}$, and $R^{9g}$ to $R^{9j}$ each independently represent a hydrogen atom, a halogen atom, or a group represented by Formula W (here, $L^w$ is a group represented by any one of Formulae L-3, L-5, L-7 to L-9, and L-12 to L-24). Among these, $R^{9c}$, $R^{9d}$, and $R^{9g}$ to $R^{9j}$ are more preferably represent a hydrogen atom.

$L^w$ is preferably a group represented by any one of Formulae L-3, L-5, L-13, L-17, and L-18.

It is preferable that at least one of $R^{9a}$, $R^{9b}$, $R^{9c}$, $R^{9d}$, $R^{9e}$, $R^{9f}$, $R^{9g}$, $R^{9h}$, or $R^{9i}$ is a group represented by Formula W.

In the compound represented by Formula 9, among $R^{9a}$ to $R^{9i}$, the number of substituents represented by Formula W is preferably 1 to 4 from the viewpoint of improving the carrier mobility and improving the solubility in an organic solvent, more preferably 1 or 2, and particularly preferably 2.

A group represented by Formula W can be positioned in any of $R^{9a}$ to $R^{9i}$ without particular limitation. The group represented by Formula W is preferably positioned in $R^{9b}$ or $R^{9f}$ from the viewpoint of improving the carrier mobility and improving the solubility in an organic solvent, and more preferably positioned in $R^{9b}$ and $R^{9f}$.

Among $R^{9a}$ to $R^{9i}$ of Formula 9, the number of substituents other than a group represented by Formula W is preferably 0 to 4, more preferably 0 to 2, particularly preferably 0 or 1, and more particularly preferably 0.

-Compound represented by Formula 10-

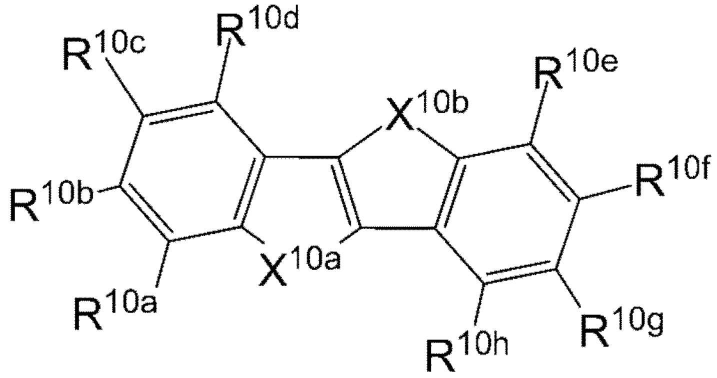

( 10 )

In Formula 10, $R^{10a}$ to $R^{10h}$ each independently represent a hydrogen atom or a substituent, and at least one of $R^{10a}$, $R^{10b}$, $R^{10c}$, $R^{10d}$, $R^{10e}$, $R^{10f}$, $R^{10g}$, or $R^{10h}$ represents a group represented by Formula W. Examples of the substituent represented by $R^{10a}$ to $R^{10h}$ include the substituent X described above. The definition of a substituent represented by Formula W is as described above.

It is preferable that $R^{10a}$ to $R^{10h}$ each independently represent a hydrogen atom, a halogen atom, or a substituent, and at least one of $R^{10a}$, $R^{10b}$, $R^{10c}$, $R^{10d}$, $R^{10e}$, $R^{10f}$, $R^{10g}$, or $R^{10h}$ is a substituted or unsubstituted arylthio group, a substituted or unsubstituted heteroarylthio group, a substituted or unsubstituted alkyloxycarbonyl group, a substituted or unsubstituted aryloxycarbonyl group, or a substituted or unsubstituted alkylamino group.

Among $R^{10a}$ to $R^{10h}$ of Formula 10, at least one of $R^{10b}$ or $R^{10f}$ is preferably a substituted or unsubstituted arylthio group, a substituted or unsubstituted heteroarylthio group, a substituted or unsubstituted alkyloxycarbonyl group, a substituted or unsubstituted aryloxycarbonyl group, or a substituted or unsubstituted alkylamino group, and more preferably a substituted or unsubstituted arylthio group or a substituted or unsubstituted heteroaryl group. It is even more preferable that both of $R^{10b}$ and $R^{10f}$ represent a substituted or unsubstituted arylthio group or a substituted or unsubstituted heteroarylthio group. It is particularly preferable that both of $R^{10b}$ and $R^{10f}$ represent a substituted or unsubstituted phenylthio group or a heteroarylthio group selected from the following group A. It is the most preferable that both of $R^{10b}$ and $R^{10f}$ represent a substituted or unsubstituted phenylthio group or a heteroarylthio group represented by the following Formula A-17, A-18, or A-20.

The arylthio group is preferably a group in which a sulfur atom is linked to an aryl group having 6 to 20 carbon atoms, more preferably a naphthylthio group or a phenylthio group, and particularly preferably a phenylthio group.

The heteroarylthio group is preferably a group in which a sulfur atom is linked to a 3-to 10-membered heteroaryl group, more preferably a group in which a sulfur atom is linked to a 5- or 6-membered heteroaryl group, and particularly preferably the following group A.

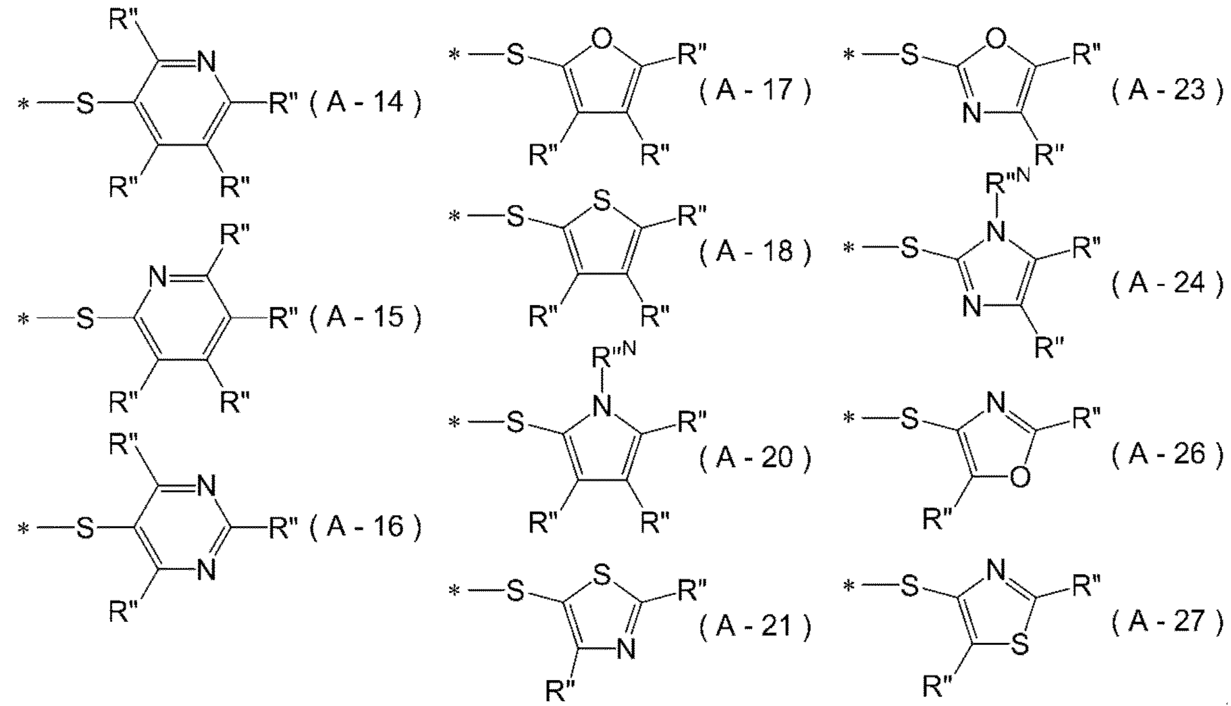

(A - 14) (A - 15) (A - 16) (A - 17) (A - 18) (A - 20) (A - 21) (A - 23) (A - 24) (A - 26) (A - 27)

In the group A, $R''$ and $R''^{N}$ each independently represent a hydrogen atom or a substituent.

It is preferable that $R'$ in the group A each independently represents a hydrogen atom or a group represented by Formula W.

$R''^{N}$ in the group A preferably represents a substituent, more preferably represents an alkyl group, an aryl group, or a heteroaryl group, even more preferably represents an alkyl group, an aryl group substituted with an alkyl group, or a heteroaryl group substituted with an alkyl group, and particularly preferably represents an alkyl group having 1 to 4 carbon atoms, a phenyl group substituted with an alkyl group having 1 to 4 carbon atoms, or a 5-membered heteroaryl group substituted with an alkyl group having 1 to 4 carbon atoms.

As the alkyloxycarbonyl group, a group in which a carbonyl group is linked to an alkyl group having 1 to 20 carbon atoms is preferable. The number of carbon atoms of the alkyl group is more preferably 2 to 15, and particularly preferably 5 to 10.

As the aryloxycarbonyl group, a group in which a carbonyl group is linked to an aryl group having 6 to 20 carbon atoms is preferable. The number of carbon atoms of the aryl group is more preferably 6 to 15, and particularly preferably 8 to 12.

As the alkylamino group, a group in which an amino group is linked to an alkyl group having 1 to 20 carbon atoms is preferable. The number of carbon atoms of the alkyl group is more preferably 2 to 15, and particularly preferably 5 to 10.

Among $R^{10a}$ to $R^{10h}$, the number of substituents (hereinafter, referred to as other substituents as well) other than a substituted or unsubstituted arylthio group, a substituted or unsubstituted heteroarylthio group, a substituted or unsubstituted alkyloxycarbonyl group, a substituted or unsubstituted aryloxycarbonyl group, or a substituted or unsubstituted alkylamino group is preferably 0 to 4, more preferably 0 to 2, particularly preferably 0 or 1, and more particularly preferably 0.

$X^{10a}$ and $X^{10b}$ each independently represent a S atom, an O atom, a Se atom, or $NR^x$ (>N-$R^x$). From the viewpoint of improving mobility, it is preferable that at least one of $X^{10a}$ or $X^{10b}$ is a S atom. It is preferable that $X^{10a}$ and $X^{10b}$ are the same linking groups. It is more preferable that both of $X^{10a}$ and $X^{10b}$ are S atoms.

$R^X$ each independently represents a hydrogen atom or a group represented by Formula W. The definition of a group represented by Formula W is as described above.

-Compound represented by Formula 11-

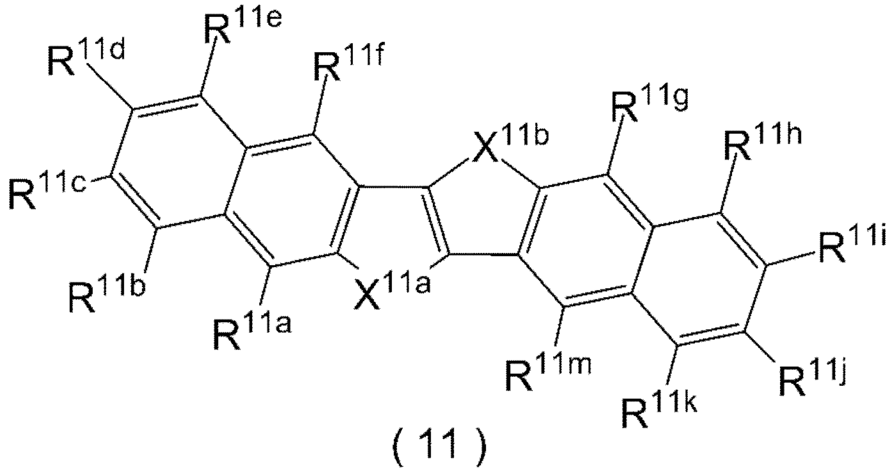

(11)

In Formula 11, $X^{11a}$ and $X^{11b}$ each independently represent a S atom, an O atom, a Se atom, or $NR^{11n}$, $R^{11a}$ to $R^{11k}$, $R^{11m}$, and $R^{11n}$ each independently represent a hydrogen atom or a substituent, and at least one of $R^{11a}$, $R^{11b}$, $R^{11c}$, $R^{11d}$, $R^{11e}$, $R^{11f}$, $R^{11g}$, $R^{11h}$, $R^{11i}$, $R^{11j}$, $R^{11k}$, $R^{11m}$, or $R^{11n}$ represents a group represented by Formula W. Examples of the substituent include the substituent X described above. The definition of a substituent represented by Formula W is as described above.

In Formula 11, from the viewpoint of improving the carrier mobility, at least one of $X^{11a}$ or $X^{11b}$ is a S atom. It is preferable that $X^{11a}$ and $X^{11b}$ are the same linking groups. It is more preferable that both of $X^{11a}$ and $X^{11b}$ are S atoms.

Among $R^{11a}$ to $R^{11k}$ and $R^{11m}$ of Formula 11, at least one of $R^{11c}$ or $R^{11i}$ is preferably a substituted or unsubstituted alkyl group, a substituted or unsubstituted arylthio group, a substituted or unsubstituted heteroarylthio group, a substituted or unsubstituted alkyloxycarbonyl group, a substituted or unsubstituted aryloxycarbonyl group, or a substituted or unsubstituted alkylamino group and more preferably a substituted or unsubstituted alkyl group. It is even more preferable that both of $R^{11c}$ and $R^{11i}$ represent a substituted or unsubstituted alkyl group.

-Compound represented by Formula 12-

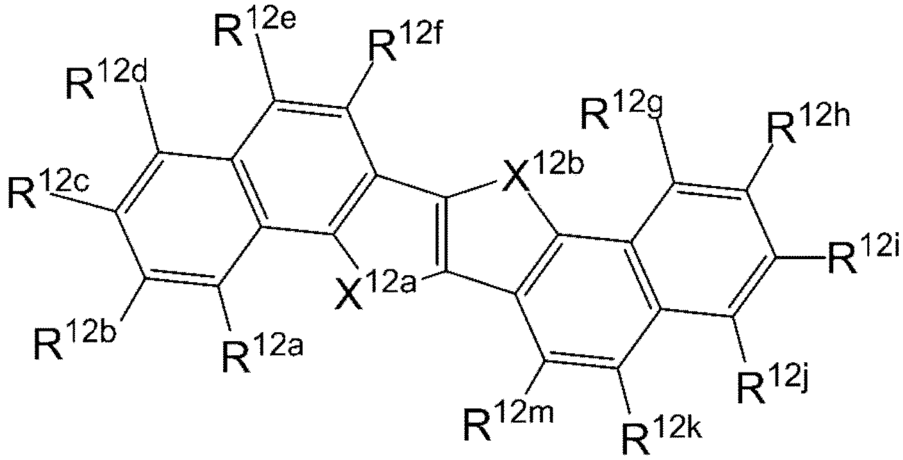

(12)

In Formula 12, $X^{12a}$ and $X^{12b}$ each independently represent a S atom, an O atom,a Se atom, or $NR^{12n}$, $R^{12a}$ to $R^{12k}$, $R^{12m}$ and $R^{12n}$ each independently represent a hydrogen atom or a substituent, and at least one of $R^{12a}$, $R^{12b}$, $R^{12c}$, $R^{12d}$, $R^{12e}$, $R^{12f}$, $R^{12g}$, $R^{12h}$, $R^{12i}$, $R^{12j}$, $R^{12k}$, $R^{12m}$, or $R^{12n}$ represents a group represented by Formula W. Examples of the substituent include the substituent X described above. The definition of a substituent represented by Formula W is as described above.

In Formula 12, from the viewpoint of improving the carrier mobility, at least one of $X^{12a}$ or $X^{12b}$ is preferably a

S atom. It is preferable that $X^{12a}$ and $X^{12b}$ are the same linking groups. It is more preferable that both of $X^{12a}$ and $X^{12b}$ are S atoms.

Among $R^{12a}$ to $R^{12k}$ and $R^{12m}$ of Formula 12, at least one of $R^{12c}$ or $R^{12i}$ is preferably a substituted or unsubstituted alkyl group, a substituted or unsubstituted arylthio group, a substituted or unsubstituted heteroarylthio group, a substituted or unsubstituted alkyloxycarbonyl group, a substituted or unsubstituted aryloxycarbonyl group, or a substituted or unsubstituted alkylamino group, and more preferably a substituted or unsubstituted alkyl group. It is even more preferable that both of $R^{12c}$ and $R^{12i}$ represent a substituted or unsubstituted alkyl group.

-Compound represented by Formula 13-

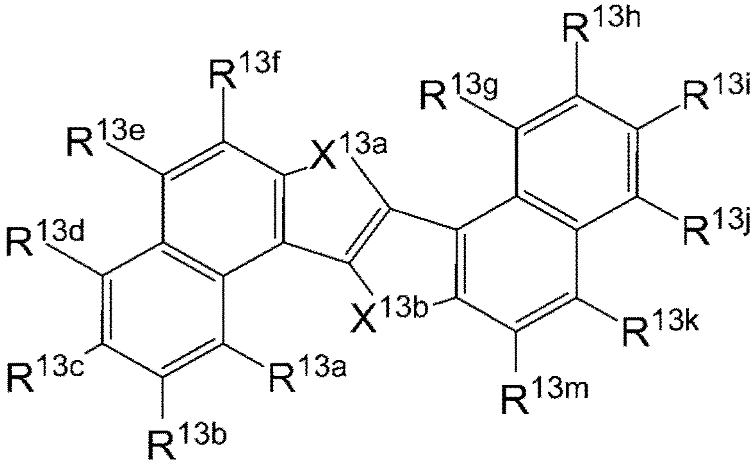

( 13 )

In Formula 13, $X^{13a}$ and $X^{13b}$ each independently represent a S atom, an O atom, a Se atom, or $NR^{13n}$, $R^{13a}$ to $R^{13k}$, $R^{13m}$, and $R^{13n}$ each independently represent a hydrogen atom or a substituent, and at least one of $R^{13a}$, $R^{13b}$, $R^{13c}$, $R^{13d}$, $R^{13e}$, $R^{13f}$, $R^{13g}$, $R^{13h}$ , $R^{13i}$ , $R^{13j}$, $R^{13k}$, $R^{13m}$, or $R^{13n}$ represents a group represented by Formula W. Examples of the substituent include the substituent X described above. The definition of a group represented by Formula W is as described above.

In Formula 13, from the viewpoint of improving the carrier mobility, at least one of $X^{13a}$ or $X^{13b}$ is preferably a S atom. It is preferable that $X^{13a}$ and $X^{13b}$ are the same linking groups. It is more preferable that both of $X^{13a}$ and $X^{13b}$ are S atoms.

Among $R^{13a}$ to $R^{13k}$ and $R^{13m}$ of Formula 13, at least one of $R^{13c}$ or $R^{13i}$ is preferably a substituted or unsubstituted alkyl group, a substituted or unsubstituted arylthio group, a substituted or unsubstituted heteroarylthio group, a substituted or unsubstituted alkyloxycarbonyl group, a substituted or unsubstituted aryloxycarbonyl group, or a substituted or unsubstituted alkylamino group, and more preferably a substituted or unsubstituted alkyl group. It is even more preferable that both of $R^{13c}$ and $R^{13i}$ represent a substituted or unsubstituted alkyl group.

-Compound represented by Formula 14-

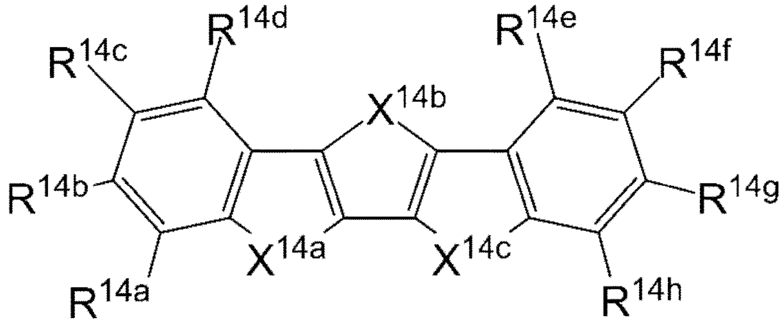

( 14 )

In Formula 14, $X^{14a}$ to $X^{14c}$ each independently represent a S atom, an O atom, a Se atom, or $NR^{14i}$, $R^{14a}$ to $R^{14i}$ each independently represent a hydrogen atom or a substituent, and at least one of $R^{14a}$, $R^{14b}$, $R^{14c}$, $R^{14d}$, $R^{14e}$, $R^{14f}$, $R^{14g}$, $R^{14h}$, or $R^{14i}$ represents a group represented by Formula W. Examples of the substituent include the substituent X described above. The definition of a group represented by Formula W is as described above.

In a case where at least one of $R^{14a}$, $R^{14b}$, $R^{14c}$, $R^{14d}$, $R^{14e}$, $R^{14f}$, $R^{14g}$, or $R^{14h}$ is a group represented by Formula W, and $R^w$ is an alkyl group, $L^w$ is preferably a group represented by any one of Formulae L-2 to L-25.

In Formula 14, from the viewpoint of improving the carrier mobility, it is preferable that at least one of $X^{14a}$, $X^{14b}$, or $X^{14c}$ is a S atom. It is preferable that $X^{14a}$ to $X^{14c}$ are the same linking groups. It is more preferable that all of $X^{14a}$ to $X^{14c}$ are S atoms.

In a case where $R^w$ is an alkyl group, $L^w$ is preferably a group represented by any one of Formulae L-2 to L-5, L-13, L-17, and L-18, and more preferably a group represented by any one of Formulae L-3, L-13, and L-18.

Among $R^{14a}$ to $R^{14h}$ of Formula 14, at least one of $R^{14b}$ or $R^{14g}$ is preferably a group represented by Formula W. It is more preferable that both of $R^{14b}$ and $R^{14g}$ represent a group represented by Formula W.

-Compound represented by Formula 15-

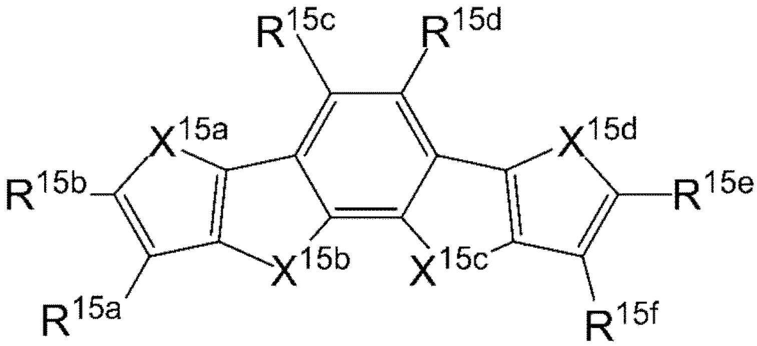

( 15 )

In Formula 15, $X^{15a}$ to $X^{15d}$ each independently represent a S atom, an O atom, a Se atom, or $NR^{15g}$, $R^{15a}$ to $R^{15g}$ each independently represent a hydrogen atom or a substituent, and at least one of $R^{15a}$, $R^{15b}$, $R^{15c}$, $R^{15d}$, $R^{15e}$, $R^{15f}$, or $R^{15g}$ represents a group represented by Formula W. Examples of the substituent include the substituent X described above. The definition of a group represented by Formula W is as described above.

In Formula 15, from the viewpoint of improving the carrier mobility, at least one of $X^{15a}$, $X^{15b}$, $X^{15c}$, or $X^{15d}$ is preferably a S atom. It is preferable that $X^{15a}$ to $X^{15d}$ are the same linking groups. It is more preferable that all of $X^{15a}$ to $X^{15d}$ are S atoms.

Among $R^{15a}$ to $R^{15f}$ of Formula 15, at least one of $R^{15b}$ or $R^{15e}$ is preferably a group represented by Formula W. It is more preferable that both of $R^{15b}$ and $R^{15e}$ represent a group represented by Formula W.

-Compound represented by Formula 16-

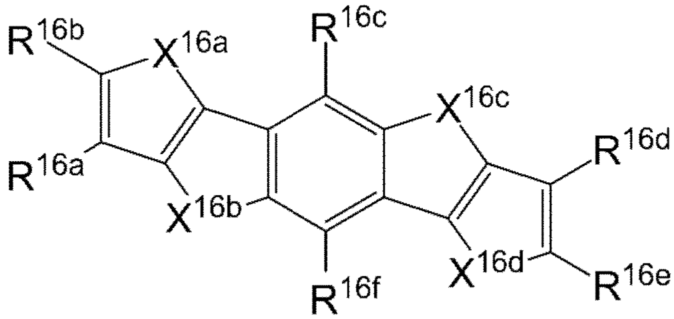

( 16 )

In Formula 16, $X^{16a}$ to $X^{16d}$ each independently represent a S atom, an O atom, a Se atom, or $NR^{16g}$. $R^{16a}$ to $R^{16g}$ each independently represent a hydrogen atom or a substituent, and at least one of $R^{16a}$, $R^{16b}$, $R^{16c}$, $R^{16d}$, $R^{16e}$, $R^{16f}$, or $R^{16g}$ represents a group represented by Formula W. Examples of the substituent include the substituent X described above. The definition of a group represented by Formula W is as described above.

$R^{16c}$ and $R^{16f}$ preferably represent a hydrogen atom, a halogen atom, or a group represented by Formula W (here, $L^W$ is a group represented by any one of Formulae L-3, L-5, L-7 to L-9, and L-12 to L-24). It is preferable that $R^{16a}$, $R^{16b}$, $R^{16d}$, $R^{16e}$, and $R^{16g}$ each independently represent a hydrogen atom or a substituent.

In Formula 16, $L^W$ is a group represented by any one of Formulae L-3, L-5, L-7 to L-9, and L-12 to L-24. In a case where $R^{16c}$ and $R^{16f}$ each independently represent a group represented by Formula W, $L^W$ is preferably a group represented by any one of Formulae L-3, L-5, L-13, L-17, and L-18.

In Formula 16, from the viewpoint of improving the carrier mobility, at least one of $X^{16a}$, $X^{16b}$, $X^{16c}$, or $X^{16d}$ is a S atom. It is preferable that $X^{16a}$ to $X^{16d}$ are the same linking groups. It is more preferable that all of $X^{16a}$ to $X^{16d}$ are S atoms.

It is preferable that at least one of $R^{16a}$ or $R^{16d}$ among $R^{16a}$ to $R^{16f}$ of Formula 16 represents a group represented by Formula W. It is more preferable that both of $R^{16a}$ and $R^{16d}$ represent a group represented by Formula W.

Furthermore, it is preferable that $R^{16c}$ and $R^{16f}$ represent a hydrogen atom.

The specific organic semiconductor preferably has an alkyl group, more preferably has an alkyl group having 6 to 20 carbon atoms, and even more preferably has an alkyl group having 7 to 14 carbon atoms, on a condensed polycyclic aromatic ring in the aforementioned condensed polycyclic aromatic group. If the above aspect is adopted, the mobility and the temporal stability of the obtained organic semiconductor are further improved.

The specific organic semiconductor preferably has one or more alkyl groups, more preferably has 2 to 4 alkyl groups, and even more preferably has 2 alkyl groups, on a condensed polycyclic aromatic ring in the aforementioned condensed polycyclic aromatic group. If the above aspect is adopted, the mobility and the temporal stability of the obtained organic semiconductor are further improved.

The molecular weight of the specific organic semiconductor is not particularly limited, but is preferably equal to or less than 3,000, more preferably equal to or less than 2,000, even more preferably equal to or less than 1,000, and particularly preferably equal to or less than 850. If the molecular weight is equal to or less than the aforementioned upper limit, the solubility in a solvent can be improved. In contrast, from the film quality stability of a thin film, the molecular weight is preferably equal to or greater than 300, more preferably equal to or greater than 350, and even more preferably equal to or greater than 400.

The method for synthesizing the specific organic semiconductor is not particularly limited, and the component A-1 can be synthesized with reference to known methods. Examples of methods for synthesizing the compounds represented by Formulae 1 to 16 include the methods disclosed in Journal of American Chemical Society, 116, 925 (1994), Journal of Chemical Society, 221 (1951), Org. Lett., 2001, 3, 3471, Macromolecules, 2010, 43, 6264, Tetrahedron, 2002, 58, 10197, JP2012-513459A, JP2011-46687A, Journal of Chemical Research. Miniprint, 3, 601-635 (1991), Bull. Chem. Soc. Japan, 64, 3682-3686 (1991), Tetrahedron Letters, 45, 2801-2803 (2004), EP2251342A, EP2301926A, EP2301921A, KR10-2012-0120886A, J. Org. Chem., 2011, 696, Org. Lett., 2001, 3, 3471, Macromolecules, 2010, 43, 6264, J. Org. Chem., 2013, 78, 7741, Chem. Eur. J., 2013, 19, 3721, Bull. Chem. Soc. Jpn., 1987, 60, 4187, J. Am. Chem. Soc., 2011, 133, 5024, Chem. Eur. J. 2013, 19, 3721, Macromolecules, 2010, 43, 6264-6267, J. Am. Chem.

Soc., 2012, 134, 16548-16550, and the like.

From the viewpoint of the mobility in an organic semiconductor, the specific organic semiconductor preferably contains at least one kind of compound represented by any one of Formulae 1 to 9, 14, and 15.

Specific preferred examples of the specific organic semiconductor will be shown below, but it goes without saying that the present invention is not limited thereto.

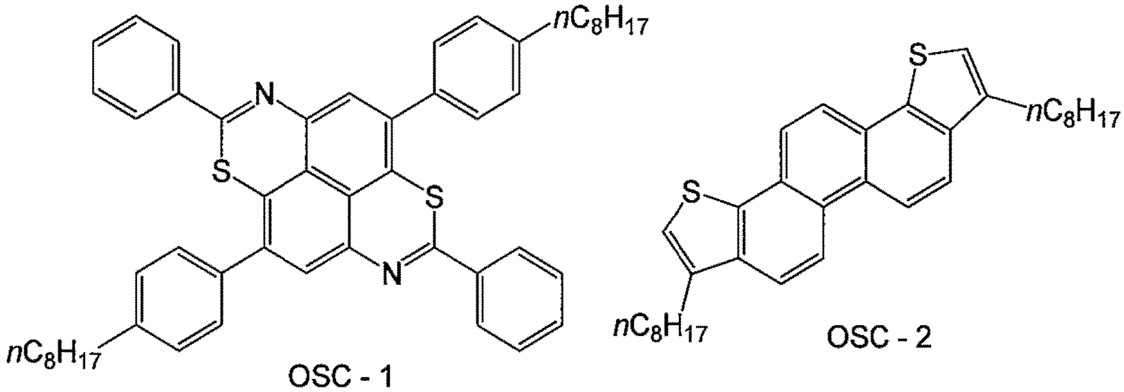

OSC - 1

OSC - 2

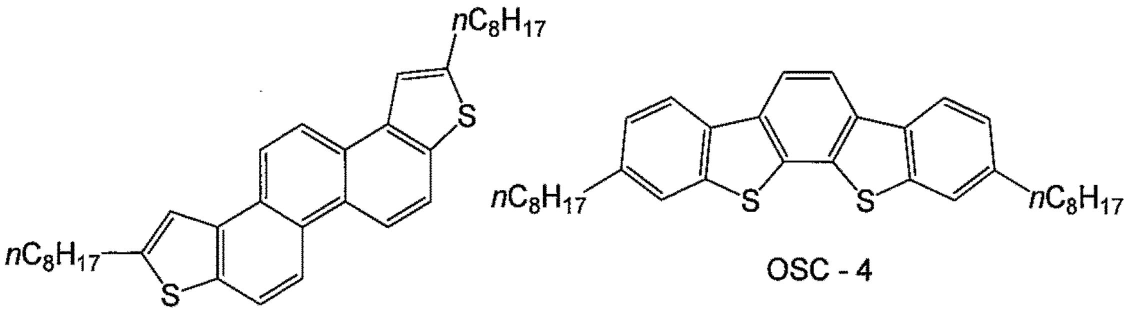

OSC - 3

OSC - 4

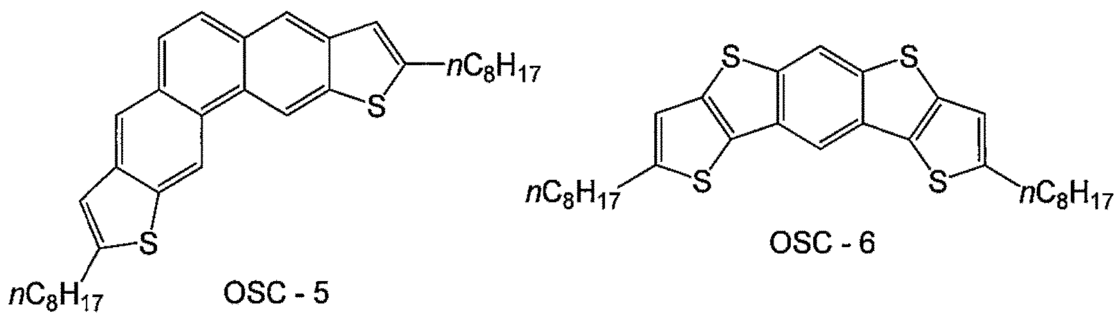

OSC - 5

OSC - 6

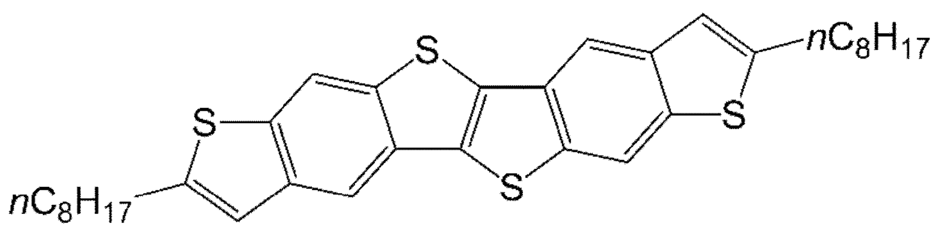

OSC - 7

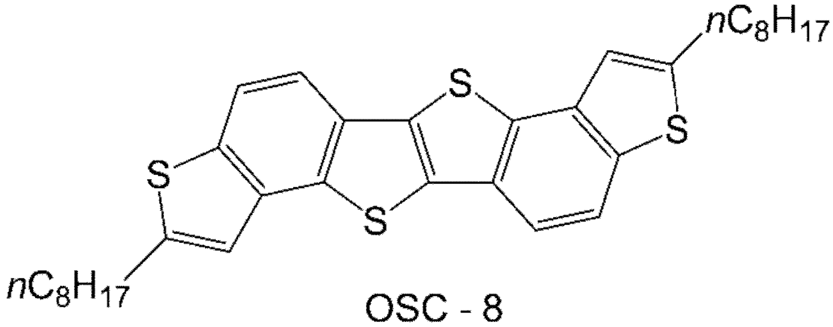

OSC - 8

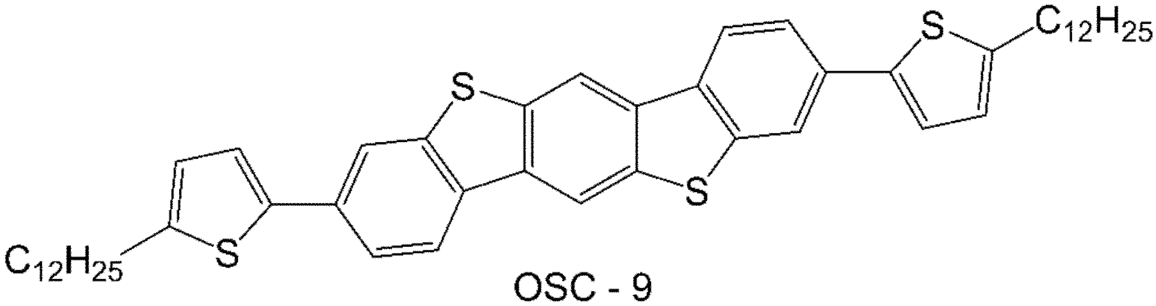

OSC - 9

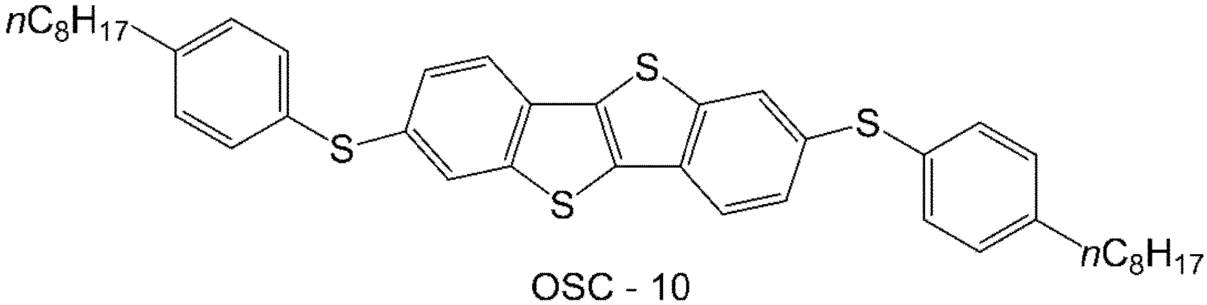

OSC - 10

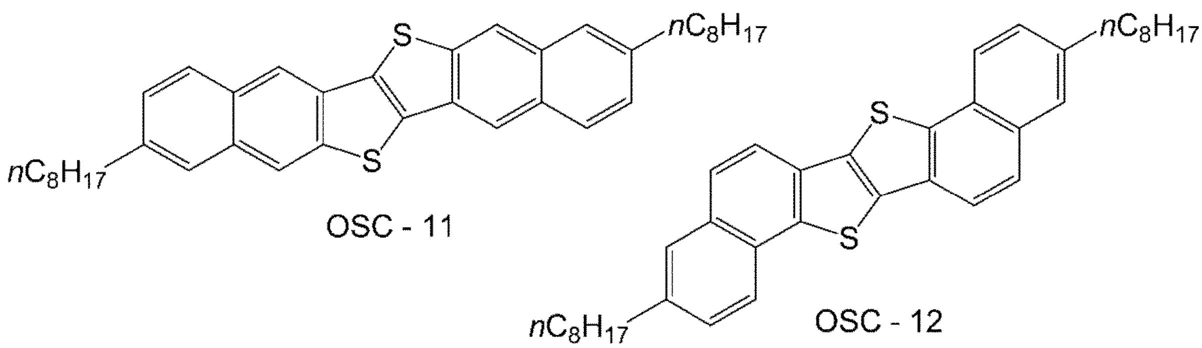

OSC - 11

OSC - 12

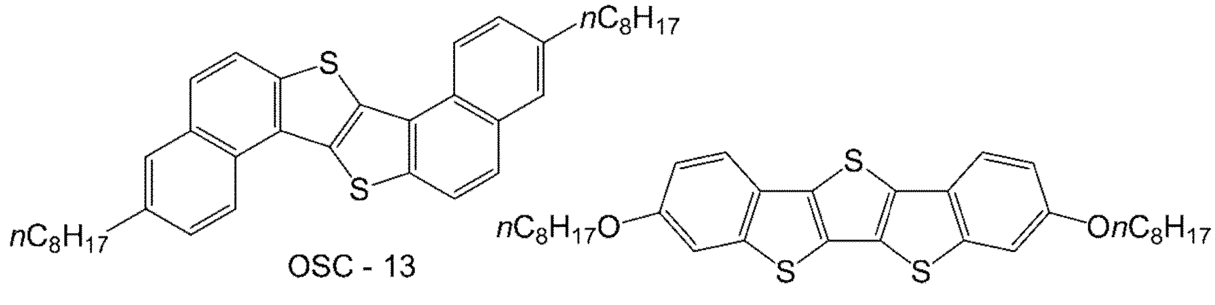

OSC - 13

OSC - 14

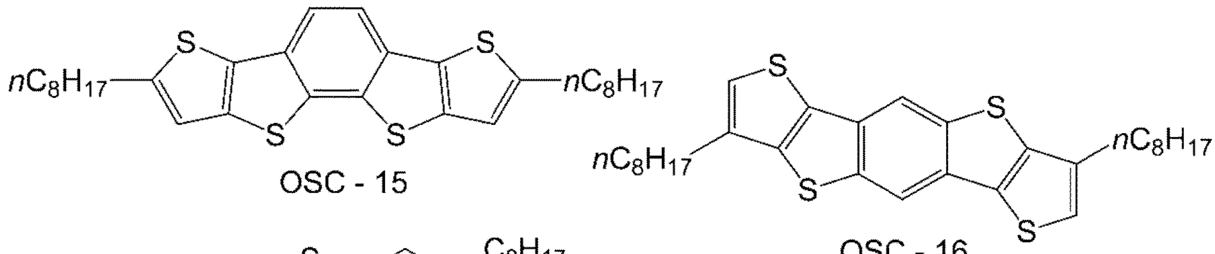

OSC - 15

OSC - 16

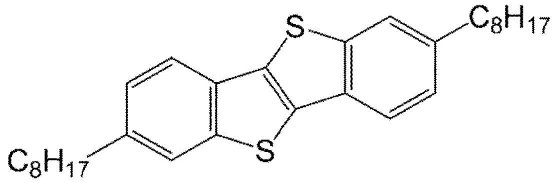

OSC - 17

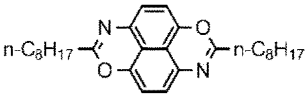

OSC-19

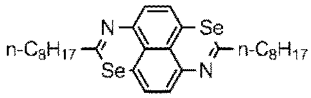

OSC-20

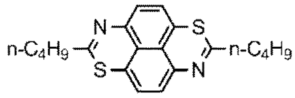

OSC-21

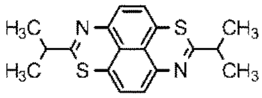

OSC-22

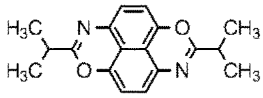

OSC-23

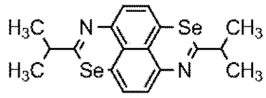

OSC-24

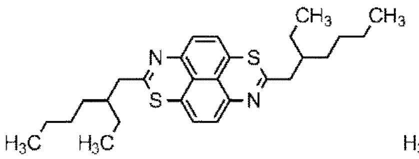

OSC-25

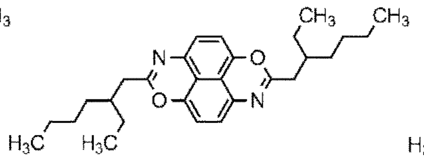

OSC-26

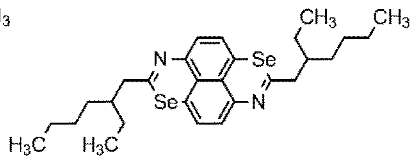

OSC-27

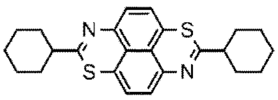

OSC-28

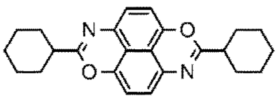

OSC-29

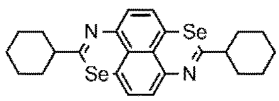

OSC-30

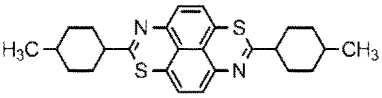

OSC-31

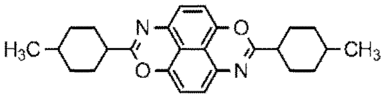

OSC-32

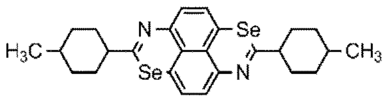

OSC-33

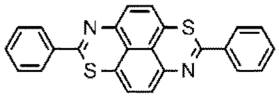

OSC-34

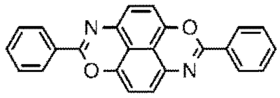

OSC-35

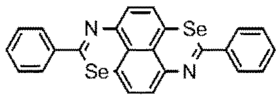

OSC-36

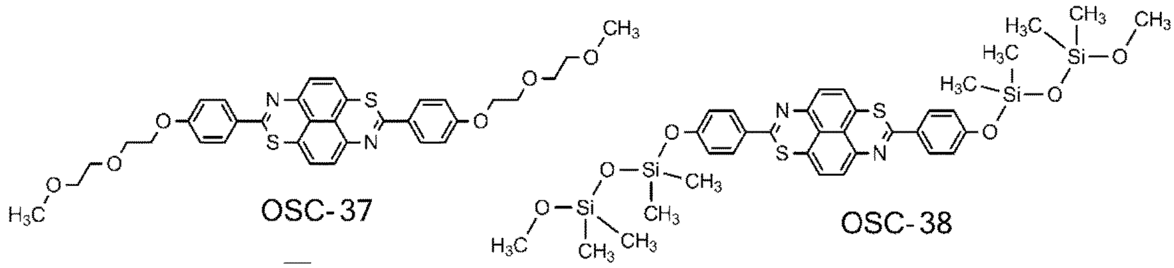

OSC-37

OSC-38

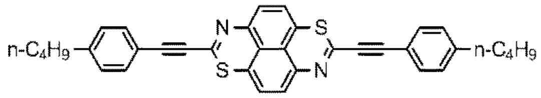

OSC-39

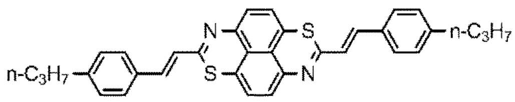

OSC-40

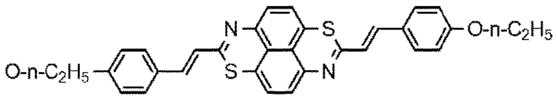

OSC-41

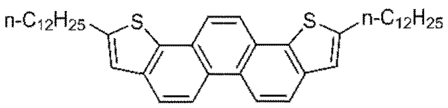

OSC-42

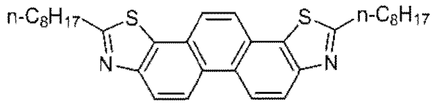

OSC-43

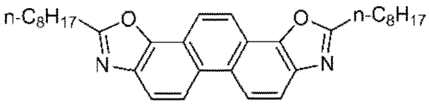

OSC-44

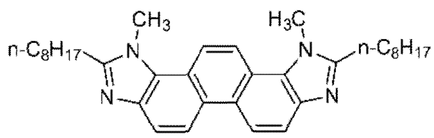

OSC-45

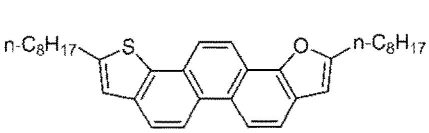

OSC-46

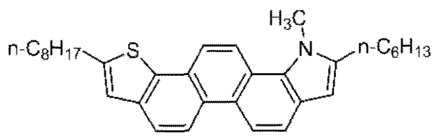

OSC-47

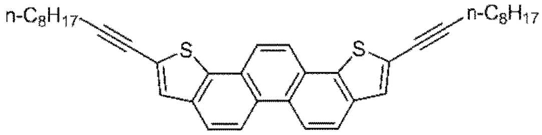

OSC-48

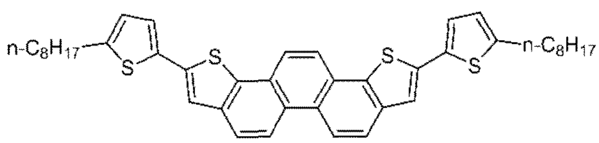

OSC-49

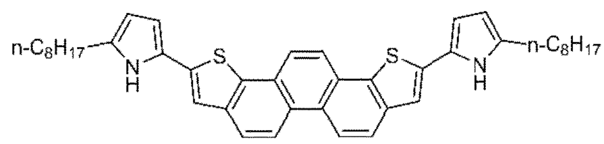

OSC-50

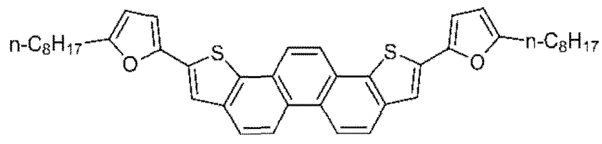

OSC-51

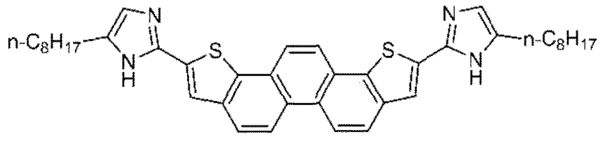

OSC-52

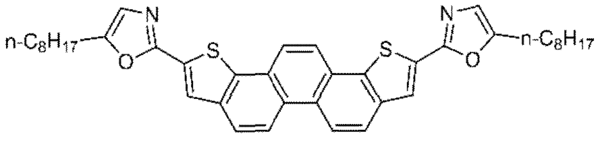

OSC-53

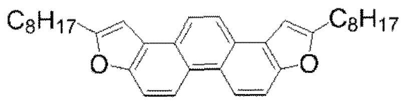

OSC-54

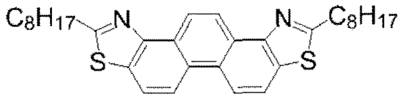

OSC-55

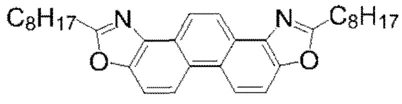

OSC-56

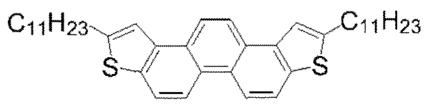

OSC-57

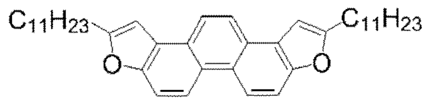

OSC-58

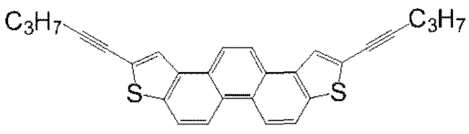

OSC-59

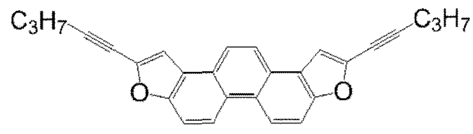

OSC-60

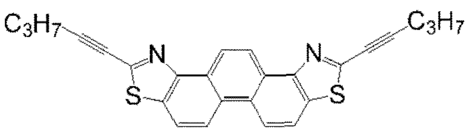

OSC-61

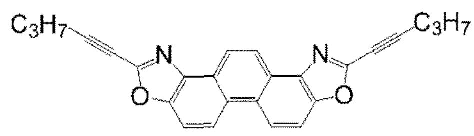

OSC-62

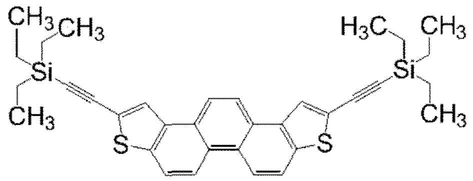

OSC-63

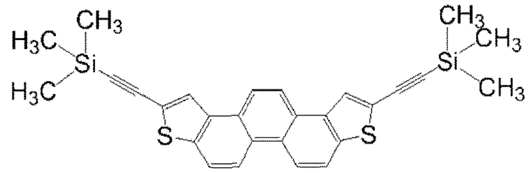

OSC-64

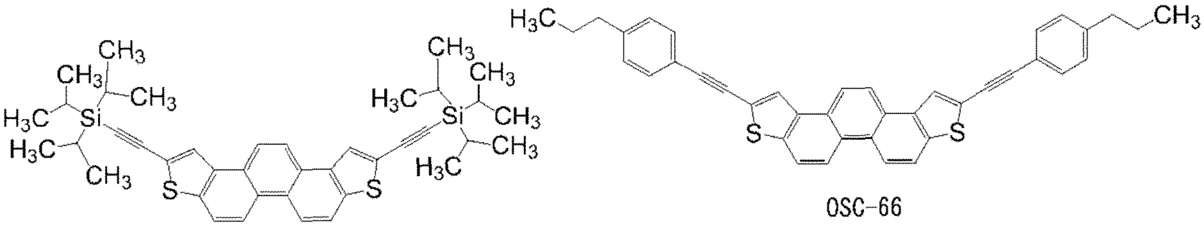

OSC-66

OSC-65

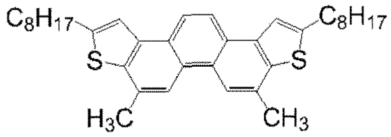

OSC-67

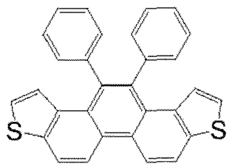

OSC-68

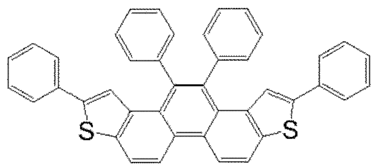

OSC-69

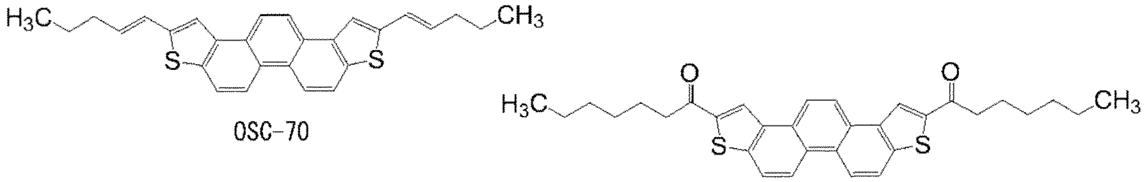

OSC-70

OSC-71

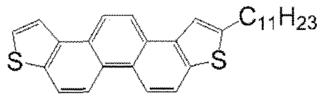

OSC-72

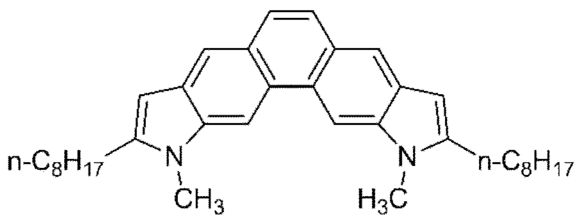

OSC-73

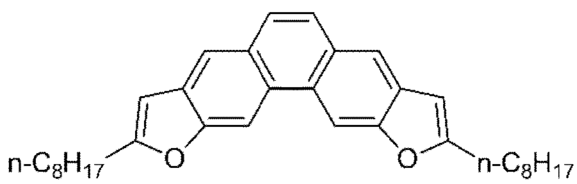

OSC-74

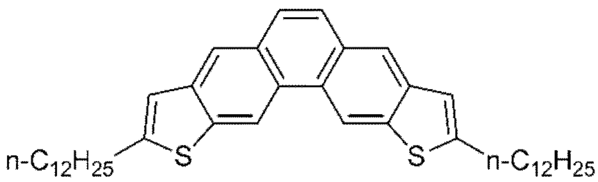

OSC-75

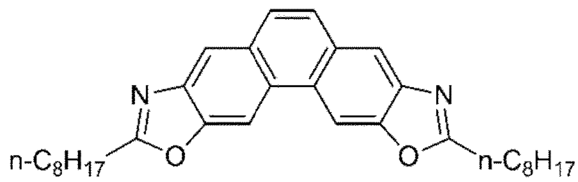

OSC-76

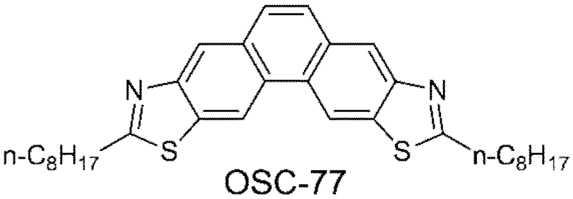

OSC-77

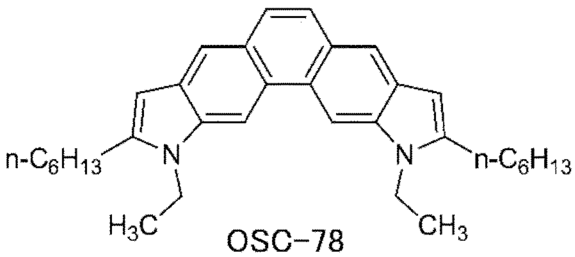

OSC-78

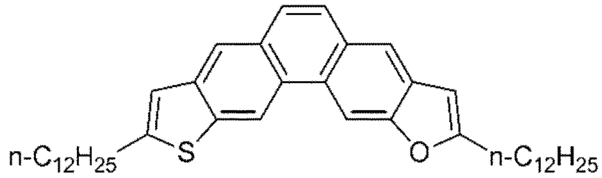

OSC-79

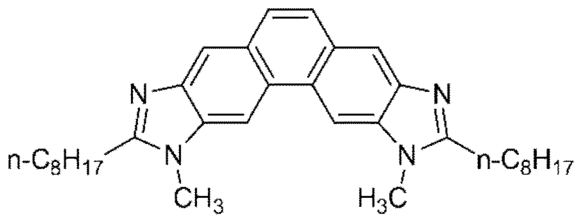

OSC-80

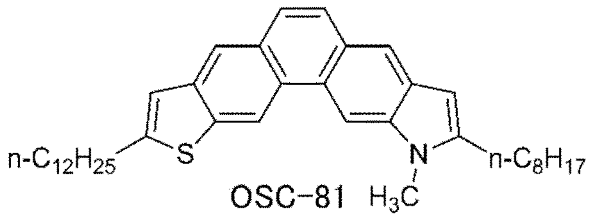

OSC-81

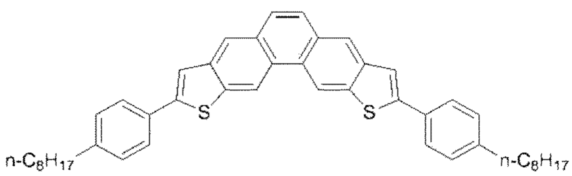

OSC-82

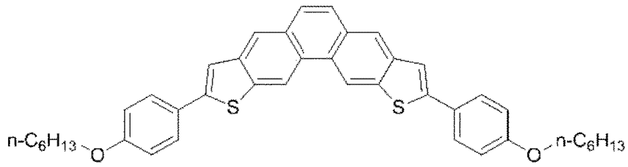

OSC-83

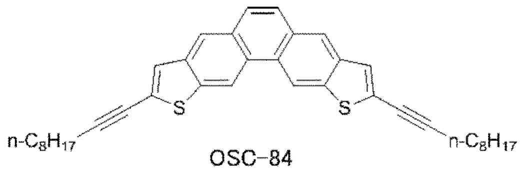

OSC-84

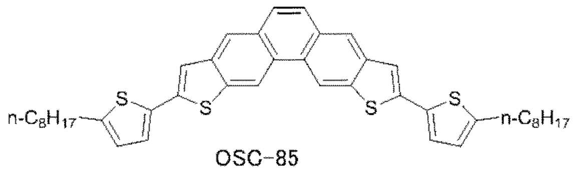

OSC-85

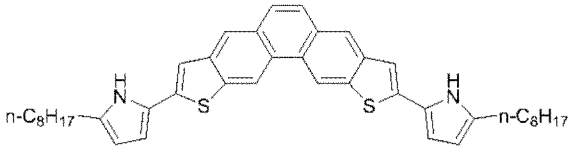

OSC-86

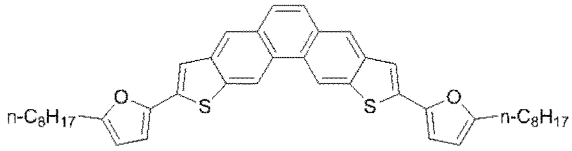

OSC-87

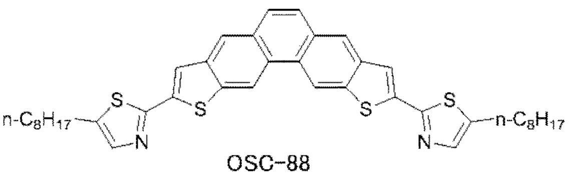

OSC-88

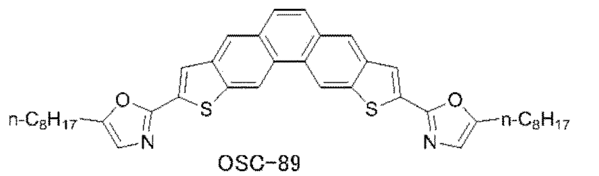

OSC-89

The content of the specific organic semiconductor in the organic semiconductor composition of the present invention is not particularly limited, but is, with respect to the total mass of the organic semiconductor composition, preferably 0.005% to 10% by mass, more preferably 0.01% to 5% by mass, and even more preferably 0.05% to 3% by mass.

<Binder polymer>

The organic semiconductor composition of the present invention preferably further contains a binder polymer.
The organic semiconductor of the present invention that will be described later may be an organic semiconductor element having the aforementioned organic semiconductor layer and a layer containing a binder polymer.
The type of binder polymer is not particularly limited, and a known binder polymer can be used.
Examples of the binder polymer include a polystyrene resin, an acryl resin, rubber, a thermoplastic elastomer.

Among these, as the binder polymer, a polymer compound having a benzene ring (polymer having a benzene ring-containing monomer unit) is preferable. The content of benzene ring-containing monomer unit is not particularly limited, but is preferably equal to or greater than 50 mol%, more preferably equal to or greater than 70 mol%, and even more preferably equal to or greater than 90 mol%, with respect to all of the monomer units. The upper limit is not particularly limited, but is, for example, 100 mol%.
Examples of the binder polymer include polystyrene, poly($\alpha$-methylstyrene), polyvinyl cinnamate, poly(4-vinylphenyl), poly(4-methylstyrene).
The weight-average molecular weight of the binder polymer is not particularly limited, but is preferably 1,000 to 2,000,000, more preferably 3,000 to 1,500,000, and even more preferably 100,000 to 1,000,000.
In a case where a solvent which will be described is used, it is preferable that the solubility of the binder polymer in the used solvent is higher than the solubility of the specific compound. If the aforementioned aspect is adopted, the mobility and the heat stability of the obtained organic semiconductor are further improved.
The content of the binder polymer in the organic semiconductor composition of the present invention is, with respect to a content of 100 parts by mass of the specific organic semiconductor, preferably 1 to 200 parts by mass, more preferably 10 to 150 parts by mass, and even more preferably 20 to 120 parts by mass. If the content is within the above range, the mobility and the temporal stability of the obtained organic semiconductor are further improved.

<Other components>

The organic semiconductor composition of the present invention may contain other component in addition to the specific organic semiconductor, the organic solvent A, the organic solvent B, and the specific surfactant.
As other components, known additives can be used.
In the organic semiconductor composition of the present invention, the content of other components used in addition to the specific organic semiconductor, the organic solvent A, the organic solvent B, the specific surfactant, and the binder polymer is preferably equal to or less than 10% by mass, more preferably equal to or less than 5% by mass, even more preferably equal to or less than 1% by mass, and particularly preferably equal to or less than 0.1% by mass. If the content is within the above range, film formability is improved, and the mobility and the temporal stability of the obtained organic semiconductor are further improved.
The method for manufacturing the organic semiconductor composition of the present invention is not particularly limited, and a known method can be adopted. For example, by sequentially or simultaneously adding a predetermined amount of the specific organic semiconductor, the specific surfactant, and, if necessary, other organic solvents, to the organic solvent A and the organic solvent B or to a mixed solvent of the organic solvents A and B, and appropriately performing a stirring treatment, a desired composition can be obtained.

(Organic semiconductor film and organic semiconductor element)

An organic semiconductor film may be manufactured using the organic semiconductor composition of the present invention.
An organic semiconductor element may have an organic semiconductor formed of the organic semiconductor composition of the present invention.
The method for manufacturing an organic semiconductor film or an organic semiconductor element by using the organic semiconductor composition of the present invention is not particularly limited, and a known method can be adopted. Examples thereof include a method for manufacturing an organic semiconductor film by applying the composition onto a predetermined substrate and performing a drying treatment if necessary.
The method of applying the composition onto a substrate is not particularly limited, and known methods can be adopted. Examples thereof include an ink jet printing method, a flexographic printing method, a bar coating method, a spin coating method, a knife coating method, and a doctor blade method. Among these, an ink jet printing method and a flexographic printing method are preferable.
Preferred examples of the flexographic printing method include an aspect in which a photosensitive resin plate is used as a flexographic printing plate. By printing the composition onto a substrate according to the aspect, a pattern can be easily formed.
Among the above methods, the method for manufacturing an organic semiconductor film and the method for manufacturing an organic semiconductor element preferably include a coating step of coating a substrate with the organic semiconductor composition of the present invention and a removing step of removing the organic solvent A and the organic solvent B from the composition with which the substrate is coated.
The drying treatment in the removing step is a treatment performed if necessary, and the optimal conditions thereof are appropriately selected according to the type of the specific organic semiconductor and the organic solvent used. In view of further improving the mobility and the temporal stability of the obtained organic semiconductor and

improving productivity, a heating temperature is preferably 30°C to 100°C and more preferably 40°C to 80°C, and a heating time is preferably 10 to 300 minutes and more preferably 30 to 180 minutes.

The film thickness of the formed organic semiconductor film is not particularly limited. From the viewpoint of the mobility and the temporal stability of the obtained organic semiconductor, the film thickness is preferably 10 to 500 nm and more preferably 30 to 200 nm.

The organic semiconductor film manufactured from the composition of the present invention can be suitably used in an organic semiconductor element, and can be particularly suitably used in an organic transistor (organic thin film transistor).

The organic semiconductor element is not particularly limited, but is preferably an organic semiconductor element having 2 to 5 terminals, and more preferably an organic semiconductor element having 2 or 3 terminals.

Furthermore, the organic semiconductor element is preferably an element which does not use a photoelectric function.

Examples of a 2-terminal element include a rectifier diode, a constant voltage diode, a PIN diode, a Schottky barrier diode, a surge protection diode, a diac, a varistor, and a tunnel diode.

Examples of a 3-terminal element include a bipolar transistor, a Darlington transistor, a field effect transistor, insulated gate bipolar transistor, a uni-junction transistor, a static induction transistor, a gate turn-off thyristor, a triac, and a static induction thyristor.

Among these, a rectifier diode and transistors are preferable, and a field effect transistor is more preferable.

Examples of the field effect transistor preferably include an organic thin film transistor.

An aspect of an organic thin film transistor will be described with reference to a drawing.

Fig. 1 is a schematic cross-sectional view of an aspect of an organic semiconductor element (organic thin film transistor (TFT)).

In Fig. 1, an organic thin film transistor 100 includes a substrate 10, a gate electrode 20 disposed on the substrate 10, a gate insulating film 30 covering the gate electrode 20, a source electrode 40 and a drain electrode 42 which contact a surface of the gate insulating film 30 that is on the side opposite to the gate electrode 20 side, an organic semiconductor film 50 covering a surface of the gate insulating film 30 between the source electrode 40 and the drain electrode 42, and a sealing layer 60 covering each member. The organic thin film transistor 100 is a bottom gate-bottom contact type organic thin film transistor.

In Fig. 1, the organic semiconductor film 50 corresponds to a film formed of the composition described above.

Hereinafter, the substrate, the gate electrode, the gate insulating film, the source electrode, the drain electrode, the organic semiconductor film, the sealing layer, and methods for forming each of these will be specifically described.

<Substrate>

The substrate plays a role of supporting the gate electrode, the source electrode, and the drain electrode, which will be described later.

The type of the substrate is not particularly limited, and examples thereof include a plastic substrate, a glass substrate, and a ceramic substrate. Among these, from the viewpoint of applicability to each device and costs, a glass substrate or a plastic substrate is preferable.

Examples of materials of the plastic substrate include a thermosetting resin (for example, an epoxy resin, a phenol resin, a polyimide resin, or a polyester resin (for example, polyethylene terephthalate (PET) or polyethylene naphthalate (PEN)) and a thermoplastic resin (for example, a phenoxy resin, a polyethersulfone, polysulfone, or polyphenylene sulfone).

Examples of materials of the ceramic substrate include alumina, aluminum nitride, zirconia, silicon, silicon nitride, and silicon carbide.

Examples of materials of the glass substrate include soda lime glass, potash glass, borosilicate glass, quartz glass, aluminosilicate glass, and lead glass.

<Gate electrode, source electrode, and drain electrode>

Examples of materials of the gate electrode, the source electrode, and the drain electrode include a metal such as gold (Au), silver, aluminum (Al), copper, chromium, nickel, cobalt, titanium, platinum, tantalum, magnesium, calcium, barium, or sodium; a conductive oxide such as $InO_2$, $SnO_2$, or indium tin oxide (ITO); a conductive polymer such as polyaniline, polypyrrole, polythiophene, polyacetylene, or polydiacetylene; a semiconductor such as silicon, germanium, or gallium arsenide; a carbon material such as fullerene, carbon nanotubes, or graphite. Among these, a metal is preferable, and silver and aluminum are more preferable.

The thickness of each of the gate electrode, the source electrode, and the drain electrode is not particularly limited, but is preferably 20 to 200 nm.

The method for forming the gate electrode, the source electrode, and the drain electrode is not particularly limited, but examples thereof include a method of vacuum vapor-depositing or sputtering an electrode material onto a substrate, a method of coating a substrate with a composition for forming an electrode, and a method of printing a composition for forming an electrode onto a substrate. Furthermore, in a case where the electrode is patterned, examples of the patterning method include a photolithography method; a printing method such as ink jet printing, screen printing, offset printing, or relief printing; and a mask vapor deposition method.

<Gate insulating film>

Examples of materials of the gate insulating film include a polymer such as polymethyl methacrylate, polystyrene, polyvinylphenol, polyimide, polycarbonate, polyester, polyvinylalcohol, polyvinyl acetate, polyurethane, polysulfone, polybenzoxazole, polysilsesquioxane, an epoxy resin, or a phenol resin; an oxide such as silicon dioxide, aluminum oxide, or titanium oxide; a nitride such as silicon nitride. Among these materials, in view of the compatibility with the organic semiconductor film, a polymer is preferable.
In a case where a polymer is used as the material of the gate insulating film, it is preferable to use a cross-linking agent (for example, melamine) in combination. If the cross-linking agent is used in combination, the polymer is cross-linked, and durability of the formed gate insulating film is improved.
The film thickness of the gate insulating film is not particularly limited, but is preferably 100 to 1,000 nm.
The method for forming the gate insulating film is not particularly limited, but examples thereof include a method of coating a substrate, on which the gate electrode is formed, with a composition for forming a gate insulating film, and a method of vapor-depositing or sputtering the material of the gate insulating film onto a substrate on which the gate electrode is formed. The method for coating the aforementioned substrate with the composition for forming a gate insulating film is not particularly limited, and it is possible to use a known method (a bar coating method, a spin coating method, a knife coating method, or a doctor blade method).
In a case where the gate insulating film is formed by coating the substrate with the composition for forming a gate insulating film, for the purpose of removing the solvent, causing cross-linking, the composition may be heated (baked) after coating.

<Organic semiconductor film>

The organic semiconductor film of the present invention is a film formed of the organic semiconductor composition of the present invention.
The method for forming the organic semiconductor film is not particularly limited. By applying the organic semiconductor composition of the present invention onto the source electrode, the drain electrode, and the gate insulating film and, if necessary, performing a drying treatment, a desired organic semiconductor film can be formed.

<Polymer layer>

The organic semiconductor element preferably has the aforementioned polymer layer between the layer containing the aforementioned organic semiconductor and the insulating film, and more preferably has the aforementioned polymer layer between the aforementioned organic semiconductor and the gate insulating film. The film thickness of the polymer layer is not particularly limited, but is preferably 20 to 500 nm. The polymer layer is not limited as long as it contains the aforementioned polymer, but it is preferable that the polymer layer is a layer consisting of the aforementioned polymer.
The method for forming the polymer layer is not particularly limited, and a known method (bar coating method, a spin coating method, a knife coating method, a doctor blade method, or an ink jet method) can be used.
In a case where the polymer layer is formed by coating using a composition for forming a polymer layer, for the purpose of removing the solvent, causing cross-linking, the composition may be heated (baked) after coating.

<Sealing layer>

From the viewpoint of durability, the organic semiconductor element preferably includes a sealing layer as an outermost layer. In the sealing layer, a known sealant can be used.
The thickness of the sealing layer is not particularly limited, but is preferably 0.2 to 10 μm.
The method for forming the sealing layer is not particularly limited, but examples thereof include a method of coating a substrate, on which the gate electrode, the gate insulating film, the source electrode, the drain electrode, and the organic semiconductor film are formed, and with a composition for forming a sealing layer. Specific examples of the method of coating the substrate with the composition for forming a sealing layer are the same as the examples of the

method of coating the substrate with the composition for forming a gate insulating film. In a case where the organic semiconductor film is formed by coating the substrate with the composition for forming a sealing layer, for the purpose of removing the solvent, causing cross-linking, the composition may be heated (baked) after coating.

Fig. 2 is a schematic cross-sectional view of another aspect of the organic semiconductor element (organic thin film transistor).

In Fig. 2, an organic thin film transistor 200 includes the substrate 10, the gate electrode 20 disposed on the substrate 10, the gate insulating film 30 covering the gate electrode 20, the organic semiconductor film 50 disposed on the gate insulating film 30, the source electrode 40 and the drain electrode 42 disposed on the organic semiconductor film 50, and the sealing layer 60 covering each member. Herein, the source electrode 40 and the drain electrode 42 are formed using the aforementioned composition of the present invention. The organic thin film transistor 200 is a top contact-type organic thin film transistor.

The substrate, the gate electrode, the gate insulating film, the source electrode, the drain electrode, the organic semiconductor film, and the sealing layer are as descried above.

In Figs. 1 and 2, the aspects of the bottom gate-bottom contact type organic thin film transistor and the bottom gate-top contact type organic thin film transistor were specifically described. However, the composition of the present invention can also be applied to a top gate-bottom contact type organic thin film transistor and a top gate-top contact type organic thin film transistor.

The aforementioned organic thin film transistor can be suitably used in electronic paper, a display device.

## Examples

Hereinafter, the present invention will be more specifically described based on examples. The materials and the amount thereof used, the proportion of the materials, the content and procedure of treatments, and the like described in the following examples can be appropriately changed within a scope that does not depart from the gist of the present invention. Accordingly, the scope of the present invention is not limited to the following specific examples. Herein, unless otherwise specified, "part" and "%" are based on mass. In addition, "wt%" represents % by mass.

(Examples 1 to 26 and Comparative Examples 1 to 6)

Based on the type and amount of each component described in Table 1, an organic semiconductor and a surfactant were dissolved in a predetermined mixed solvent, thereby preparing each of the organic semiconductor compositions of Examples 1 to 26 and Comparative Examples 1 to 6. Example 26 does not form part of the invention.

<Formation of TFT element>

A bottom gate-bottom contact TFT element was formed in the following manner.

Al which will become a gate electrode was vapor-deposited (thickness: 80 nm) onto a glass substrate (Eagle XG: manufactured by Corning). The Al was spin-coated with a composition for forming a gate insulating film (a propylene glycol monomethyl ether acetate (PGMEA) solution (solution concentration: 2% by mass) of polyvinylphenol/melamine = 1/1 (w/w)), followed by baking for 60 minutes at 150°C, thereby forming a gate insulating film. Au was vapor-deposited onto the insulating film through a mask, thereby forming a source electrode and a drain electrode having a channel length of 50 μm and a channel width of 200 μm. The electrodes were coated with a semiconductor composition by an ink jet method or a flexographic printing method, thereby forming an organic semiconductor layer and obtaining a bottom gate-bottom contact type organic semiconductor transistor (organic thin film transistor).

<Organic semiconductor layer: ink jet method>

The substrate on which the source and drain electrodes were formed was coated with the prepared organic semiconductor composition by an ink jet method. By using DPP 2831 (manufactured by Fujifilm Graphic Systems) as an ink jet device and a 10 pL head, a solid film was formed at a jetting frequency of 2 Hz and a dot pitch of 20 μm.

<Organic semiconductor layer: flexographic printing method>

The substrate on which the source and drain electrodes were formed was coated with the prepared organic semiconductor solution by a flexographic printing method. As a printing device, a flexographic printability tester F1 (manufactured by IGT Testing Systems K.K.) was used, and as a flexographic resin plate, AFP DSH 1.70% (manufactured by Asahi Kasei Corporation.)/solid image was used. Printing was performed at a transport rate of 0.4 m/sec under a pressure between the plate and the substrate of 60 N, and then the substrate was dried as it was for 2 hours at a

temperature 40°C, thereby preparing an organic semiconductor layer.

<Measurement of mobility>

By connecting each electrode of the obtained organic thin film transistor to each terminal of a manual prober connected to a semiconductor parameter analyzer (4155C manufactured by Agilent Technologies), the field effect transistor (FET) was evaluated. Specifically, by measuring the drain current-gate voltage (Id-Vg) characteristics, the field effect mobility ([$cm^2$/V.sec]) was calculated. According to the value of the mobility, the elements were ranked A to E.

A: equal to or less than 0.1 $cm^2$/Vs
B: equal to or greater than 0.05 $cm^2$/Vs and less than 0.1 $cm^2$/Vs
C: equal to or greater than 0.01 $cm^2$/Vs and less than 0.05 $cm^2$/Vs
D: equal to or greater than 0.005 $cm^2$/Vs and less than 0.01 $cm^2$/Vs
E: less than 0.005 $cm^2$/Vs

<Temporal stability>

The elements having undergone the measurement of mobility were evaluated again after 1 week, and ranked to A to E according to a mobility retention rate.

A: retention rate of equal to or higher than 80%
B: retention rate of equal to or higher than 60% and lower than 80%
C: retention rate of equal to or higher than 40% and lower than 60%
D: retention rate of equal to or higher than 20% and lower than 40%
E: retention rate of lower than 20%.

<SP value>

By using Hansen solubility parameters determined by the equation explained in A User's Handbook, Second Edition, C. M. Hansen (2007), Taylor and Francis Group, LLC (HSPiP manual) and "Hansen Solubility Parameter in Practice, HSPiP, 3rd edition" (software version 4.0.05), an SP value (unit: $MPa^{1/2}$) was calculated by the following equation.

$$(\text{SP value})^2 = (\delta Hd)^2 + (\delta Hp)^2 + (\delta Hh)^2$$

$H_d$: dispersion contribution
$H_p$: polar contribution
$H_h$: hydrogen bonding contribution

[Table 1]

| | Organic solvent A | Organic solvent B | ΔSP | Solvent mixing ratio (A:B) | Surfactant | Surfactant amount (wt%) | Organic semiconductor | Organic semiconductor amount (wt%) | Mobility | Temporal stability |
|---|---|---|---|---|---|---|---|---|---|---|
| Example 1 | Amylbenzene | 1 -Fluoronaphthalene | 2.8 | 2:3 | KF-410 | 0.01 | OSC-1 | 0.2 | A | A |
| Example 2 | Amylbenzene | 1 -Fluoronaphthalene | 2.8 | 2:3 | KF-410 | 0.01 | OSC-2 | 0.2 | A | A |
| Example 3 | Amylbenzene | 1 -Fluoronaphthalene | 2.8 | 2:3 | KF-410 | 0.01 | OSC-3 | 0.2 | A | A |
| Example 4 | Amylbenzene | 1 -Fluoronaphthalene | 2.8 | 2:3 | KF-410 | 0.01 | OSC-4 | 0.2 | A | A |
| Example 5 | Amylbenzene | 1 -Fluoronaphthalene | 2.8 | 2:3 | KF-410 | 0.01 | OSC-5 | 0.2 | A | A |
| Example 6 | Amylbenzene | 1 -Fluoronaphthalene | 2.8 | 2:3 | KF-410 | 0.01 | OSC-6 | 0.2 | A | A |
| Example 7 | Amylbenzene | 1 -Fluoronaphthalene | 2.8 | 2:3 | KF-410 | 0.01 | OSC-7 | 0.2 | A | A |
| Example 8 | Amylbenzene | 1 -Fluoronaphthalene | 2.8 | 2:3 | KF-410 | 0.01 | OSC-8 | 0.2 | A | A |
| Example 9 | Amylbenzene | 1 -Fluoronaphthalene | 2.8 | 2:3 | KF-410 | 0.01 | OSC-9 | 0.2 | A | A |
| Example 10 | Amylbenzene | 1 -Fluoronaphthalene | 2.8 | 2:3 | KF-410 | 0.01 | OSC-10 | 0.2 | B | A |
| Example 11 | Amylbenzene | 1 -Fluoronaphthalene | 2.8 | 2:3 | KF-410 | 0.01 | OSC-11 | 0.2 | A | B |
| Example 12 | Amylbenzene | 1 -Fluoronaphthalene | 2.8 | 2:3 | KF-410 | 0.01 | OSC-12 | 0.2 | B | A |
| Example 13 | Amylbenzene | 1 -Fluoronaphthalene | 2.8 | 2:3 | KF-410 | 0.01 | OSC-13 | 0.2 | B | A |
| Example 14 | Amylbenzene | 1 -Fluoronaphthalene | 2.8 | 2:3 | KF-410 | 0.01 | OSC-14 | 0.2 | B | A |

(continued)

| | Organic solvent A | Organic solvent B | ΔSP | Solvent mixing ratio (A:B) | Surfactant | Surfactant amount (wt%) | Organic semiconductor | Organic semiconductor amount (wt%) | Mobility | Temporal stability |
|---|---|---|---|---|---|---|---|---|---|---|
| Example 15 | Amylbenzene | 1 -Fluoronaphthalene | 2.8 | 2:3 | KF-410 | 0.01 | OSC-15 | 0.2 | A | A |
| Example 16 | Amylbenzene | 1 -Fluoronaphthalene | 2.8 | 2:3 | KF-410 | 0.01 | OSC-16 | 0.2 | A | B |
| Example 17 | Amylbenzene | 1 -Fluoronaphthalene | 2.8 | 2:3 | KF-410 | 0.01 | OSC-17 | 0.2 | A | B |
| Example 18 | Amylbenzene | 1 -Fluoronaphthalene | 2.8 | 2:3 | KF-410 | 0.01 | OSC-15 | 0.2 | A | A |
| Example 19 | Amylbenzene | 1,2-Dichlorobenzene | 3.0 | 2:3 | KF-410 | 0.01 | OSC-15 | 0.2 | B | A |
| Example 20 | Amylbenzene | Anisole | 2.1 | 2:3 | KF-410 | 0.01 | OSC-15 | 0.2 | B | A |
| Example 21 | cis-Decalin | Anisole | 2.8 | 2:3 | KF-410 | 0.01 | OSC-15 | 0.2 | B | A |
| Example 22 | Amylbenzene | 1 -Fluoronaphthalene | 2.8 | 1:2 | KF-410 | 0.01 | OSC-15 | 0.2 | A | A |
| Example 23 | Amylbenzene | 1 -Fluoronaphthalene | 2.8 | 3:2 | KF-410 | 0.01 | OSC-15 | 0.2 | B | A |
| Example 24 | Amylbenzene | 1 -Fluoronaphthalene | 2.8 | 2:1 | KF-410 | 0.01 | OSC-15 | 0.2 | B | A |
| Example 25 | Amylbenzene | 1 -Fluoronaphthalene | 2.8 | 2:3 | KF-96-100cs | 0.01 | OSC-15 | 0.2 | B | B |
| Example 26 (reference) | Amylbenzene | 1 -Fluoronaphthalene | 2.8 | 2:3 | KF-410 | 0.05 | OSC-15 | 0.2 | B | B |
| Comparative Example 1 | Amylbenzene | 1 -Fluoronaphthalene | 2.8 | 2:3 | KF-410 | 0.01 | OSC-18 | 0.2 | D | C |
| Comparative Example 2 | Amylbenzene | 1 -Fluoronaphthalene | 2.8 | 2:3 | N/A | - | OSC-15 | 0.2 | D | D |
| Comparative Example 3 | Amylbenzene | 1 -Fluoronaphthalene | 2.8 | 2:3 | KF-353 | 0.01 | OSC-15 | 0.2 | C | E |

(continued)

| | Organic solvent A | Organic solvent B | ΔSP | Solvent mixing ratio (A:B) | Surfactant | Surfactant amount (wt%) | Organic semiconductor | Organic semiconductor amount (wt%) | Mobility | Temporal stability |
|---|---|---|---|---|---|---|---|---|---|---|
| Comparative Example 4 | Tetralin | 1 -Fluoronaphthalene | 1.4 | 2:3 | KF-410 | 0.01 | OSC-15 | 0.2 | D | C |
| Comparative Example 5 | N/A | 1 -Fluoronaphthalene | - | - | KF-410 | 0.01 | OSC-15 | 0.2 | D | D |
| Comparative Example 6 | Amylbenzene | N/A | - | - | KF-410 | 0.01 | OSC-15 | 0.2 | E | D |

In Table 1 and the following Table 2, the unit of SP value and ΔSP is $MPa^{1/2}$. The details of each of the components described in Table 1 are as follows.

[Table 2]

| Solvent | SP value | Boiling point (°C) |
|---|---|---|
| cis-Decalin | 16.8 | 196 |
| Amylbenzene | 17.5 | 205 |
| Tetralin | 18.9 | 208 |
| Anisole | 19.6 | 154 |
| 1 -Fluoronaphthalene | 20.3 | 215 |
| 1,2-Dichlorobenzene | 20.5 | 181 |

cis-Decalin (D0009, manufactured by TOKYO CHEMICAL INDUSTRY CO., LTD.)

Amylbenzene (A0449, manufactured by TOKYO CHEMICAL INDUSTRY CO., LTD.)
Tetralin (T0107, manufactured by TOKYO CHEMICAL INDUSTRY CO., LTD.)
Anisole (A0492, manufactured by TOKYO CHEMICAL INDUSTRY CO., LTD.)
1-Fluoronaphthalene (F0212, manufactured by TOKYO CHEMICAL INDUSTRY CO., LTD.)
1,2-Diclorobenzene (D1116, manufactured by TOKYO CHEMICAL INDUSTRY CO., LTD.)

KF-410: surfactant having an organic siloxane moiety represented by $-O-SiR^1R^2-$ in which a portion of $R^1$ and $R^2$ is a methylstyryl group ($-CH_2-CH(CH_3)-C_6H_5$), manufactured by Shin-Etsu Chemical Co., Ltd.
KF-412: surfactant having an organic siloxane moiety represented by $-O-SiR^1R^2-$ in which a portion of $R^1$ and $R^2$ is a long-chain alkyl group, manufactured by Shin-Etsu Chemical Co., Ltd.
KF-96-100cs: surfactant having an organic siloxane moiety represented by $-O-SiR^1R^2-$ in which $R^1$ and $R^2$ each represent a methyl group, manufactured by Shin-Etsu Chemical Co., Ltd., Mw = 5,000 to 6,000
KF-353: polyether-modified surfactant, surfactant containing an organic siloxane moiety represented by $-O-SiR^1R^2-$ and having an ether bond in $R^1$ or $R^2$.
OSC-1 to 17 used in examples are the same compounds as OSC-1 to 17 described above.

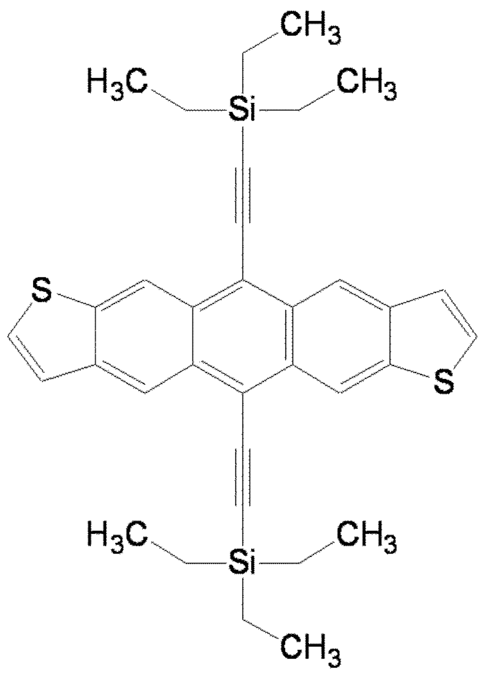

OSC - 18

The synthesis methods of the aforementioned organic semiconductors (OSC-1 to 18) and manufacturing sources thereof are as below.

OSC-1 was synthesized with reference to Journal of American Chemical Society, 116, 925 (1994), Journal of Chemical Society, 221 (1951).

OSC-2 was synthesized with reference to known documents (Org. Lett., 2001, 3, 3471, Macromolecules, 2010, 43, 6264, and Tetrahedron, 2002, 58, 10197).

OSC-3 was synthesized with reference to JP2012-513459A, JP2011-46687A, Journal of Chemical Research. miniprint, 3, 601-635 (1991), Bull. Chem. Soc. Japan, 64, 3682-3686 (1991), Tetrahedron Letters, 45, 2801-2803 (2004).

OSC-4 was synthesized with reference to EP2251342A, EP2301926A, EP2301921A, KR10-2012-0120886A.

OSC-5 was synthesized with reference to known documents (J. Org. Chem., 2011, 696, Org. Lett., 2001, 3, 3471, Macromolecules, 2010, 43, 6264, J. Org. Chem., 2013, 78, 7741, and Chem. Eur. J., 2013, 19, 3721).

OSC-6 was synthesized with reference to known documents (Bull. Chem. Soc. Japan., 1987, 60, 4187, J. Am. Chem. Soc. 2011, 133, 5024, and Chem. Eur. J. 2013, 19, 3721).

OSC-7 and OSC-8 were synthesized with reference to known documents (Macromolecules, 2010, 43, 6264-6267 and J. Am, Chem. Soc., 2012, 134, 16548-16550).

OSC-9 was synthesized with reference to document A (K. Muellen, Chem. Commun., 2008, 1548-1550.), document B (K. Takimiya, Org. Lett., 2007, 9, 4499-4502.), document C (Rao; Tilak, Journal of Scientific and Industrial Research, 1958, vol. 17 B, p. 260-265), and document D (Ghaisas; Tilak, Journal of Scientific and Industrial Research, 1955, vol. 14 B, p. 11).

OSC-10 to OSC-13 were synthesized with reference to a known document (Journal of American Chemical Society, 129, 15732 (2007)).

OSC-14 was synthesized based on the method described in WO2005/087780A.

OSC-15 was synthesized based on the method described in JP2009-190999A.

OSC-16 was synthesized based on the method described in JP2012-206953A.

As OSC-17, C8BTBT (manufactured by Sigma-Aldrich Co. LLC.) was used.

As OSC-18, 5,11-bis(triethylsilylethynyl)anthradithiophene (manufactured by Sigma-Aldrich Co. LLC.) was used.

Explanation of References

10: substrate
20: gate electrode
30: gate insulating film
40: source electrode
42: drain electrode
50: organic semiconductor film
60: sealing layer
100, 200: organic thin film transistor

## Claims

**1.** An organic semiconductor composition comprising:

an organic semiconductor which has a condensed polycyclic aromatic group having 4 or more rings, among which at least two rings have at least one atom selected from the group consisting of a sulfur atom, a nitrogen atom, a selenium atom, and an oxygen atom, and has at least one structure selected from the group consisting of a benzene ring, a naphthalene ring, and a phenanthrene ring as a partial structure in the condensed polycyclic aromatic group;
an organic solvent A; and
an organic solvent B;
wherein in a case where a Hansen solubility parameter (SP) value of the organic solvent A is denoted by SP(A) and an SP value of the organic solvent B is denoted by SP(B), SP(B) - SP(A) $\geq$ 2 $MPa^{1/2}$ is satisfied,
**characterized in that** the organic semiconductor composition further comprises a surfactant having an organic siloxane moiety represented by $-O-SiR^1R^2-$, wherein a content of the surfactant is 0.1 to 10 parts by mass with respect to a content of 100 parts by mass of the organic semiconductor;

and $R^1$ and $R^2$ each independently represent a monovalent hydrocarbon group not containing an ether bond.

2. The organic semiconductor composition according to claim 1, wherein at least one of $R^1$ or $R^2$ is a linear, branched, or cyclic alkyl group having 2 to 18 carbon atoms, or a linear, branched, or cyclic alkenyl group having 2 to 18 carbon atoms.

3. The organic semiconductor composition according to claim 1 or 2, wherein a content of the organic solvent A is 20% to 100% by volume with respect to a content of 100% by volume of the organic solvent B.

4. The organic semiconductor composition according to any one of claims 1 to 3, wherein a boiling point bp(A) of the organic solvent A and a boiling point bp(B) of the organic solvent B satisfy bp(A) < bp(B).

5. The organic semiconductor composition according to any one of claims 1 to 4,

wherein the organic semiconductor contains at least one kind of compound represented by any one of Formulae 1 to 16,

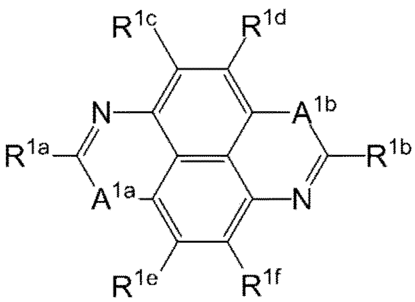
(1)

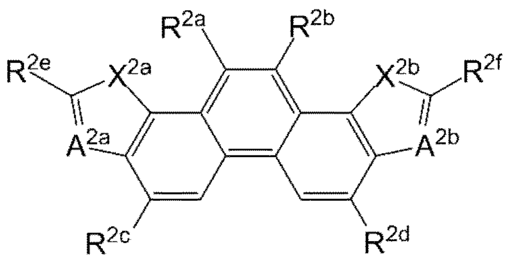
(2)

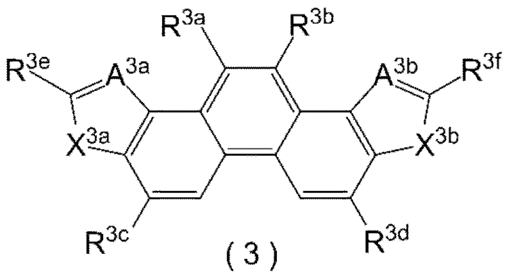
(3)

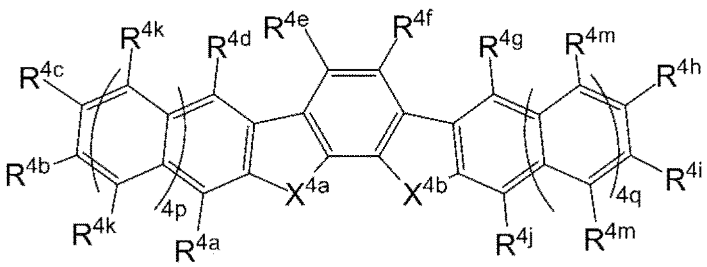
(4)

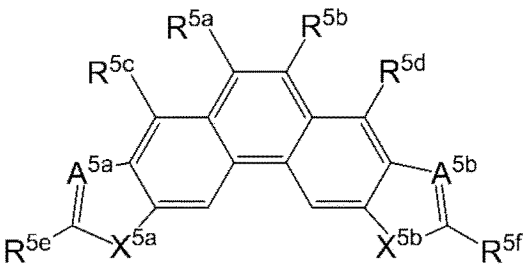
(5)

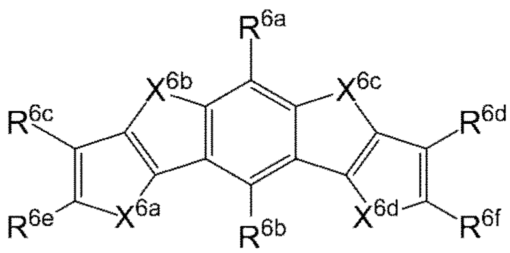
(6)

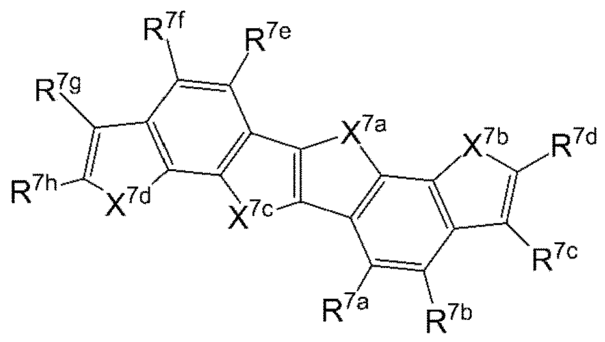

( 7 )

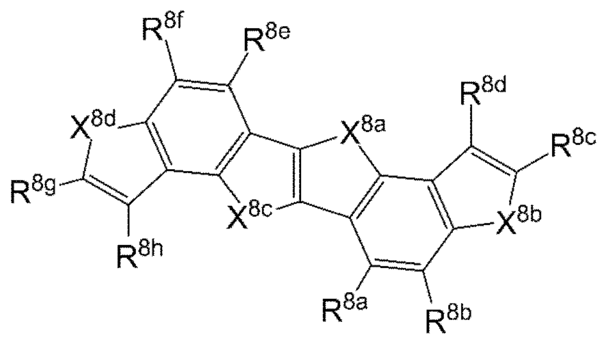

( 8 )

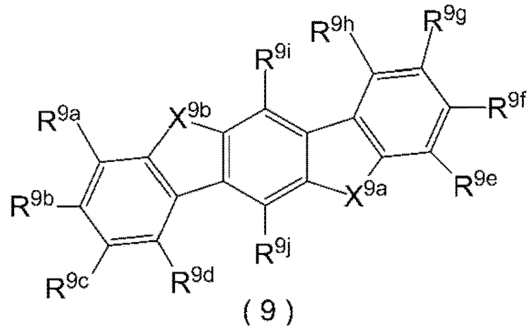

( 9 )

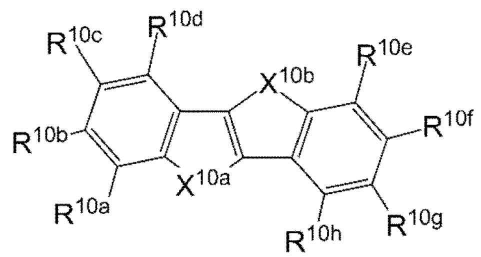

( 10 )

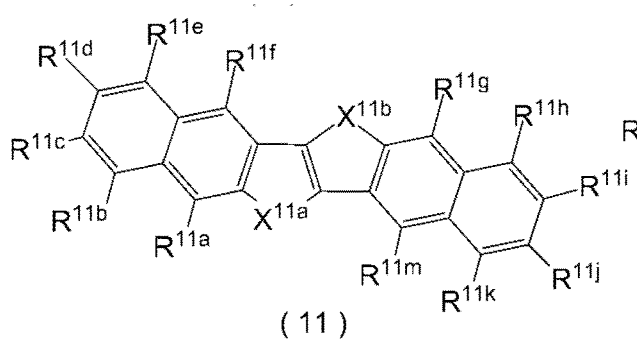

( 11 )

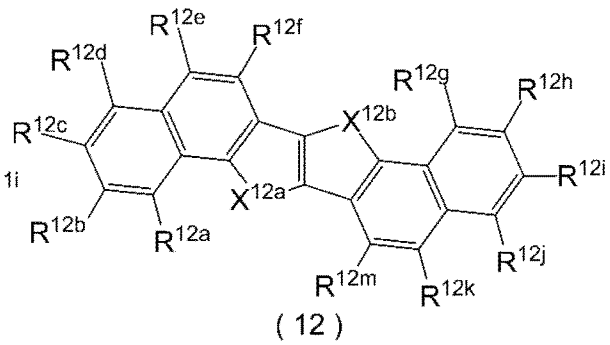

( 12 )

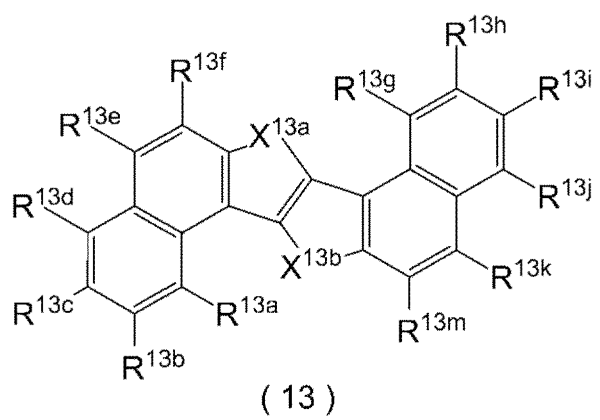

( 13 )

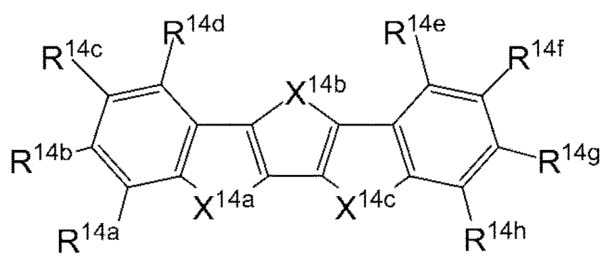

( 14 )

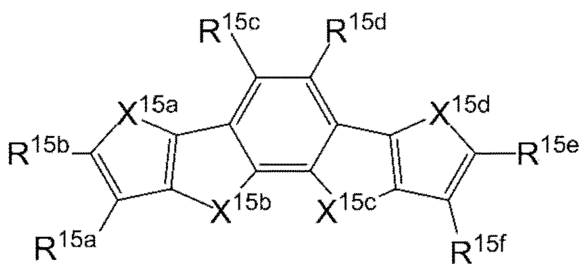

( 15 )

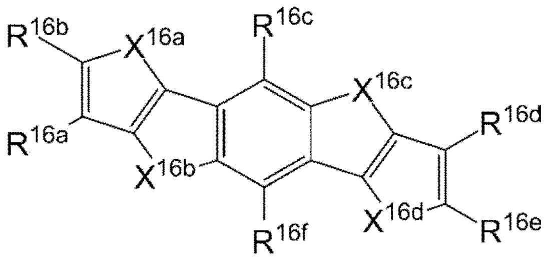

( 16 )

in Formula 1, $A^{1a}$ and $A^{1b}$ each independently represent a S atom, an O atom, or a Se atom, $R^{1a}$ to $R^{1f}$ each independently represent a hydrogen atom or a substituent, and at least one of $R^{1a}$, $R^{1b}$, $R^{1c}$, $R^{1d}$, $R^{1e}$, or $R^{1f}$ is a group represented by the following Formula W, $-L^{W}-R^{W}$ (W)

in Formula W, $L^{W}$ represents a divalent linking group which is represented by any one of the following Formulae L-1 to L-25 or a divalent linking group in which two or more divalent linking groups represented by any one of the following Formulae L-1 to L-25 are bonded to each other, and $R^{W}$ represents an alkyl group, a cyano group, a vinyl group, an ethynyl group, an oxyethylene group, an oligo-oxyethylene group in which a repetition number v of an oxyethylene unit is equal to or greater than 2, a siloxane group, an oligosiloxane group having two or more silicon atoms, or a trialkylsilyl group,

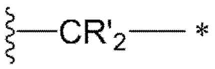

( L - 1 )

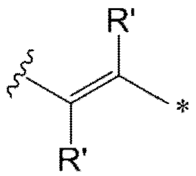

( L - 2 )

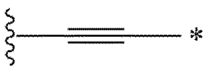

( L - 3 )

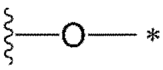

( L - 4 )

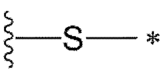

( L - 5 )

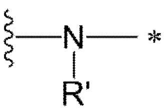

( L - 6 )

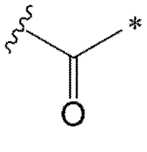

( L - 7 )

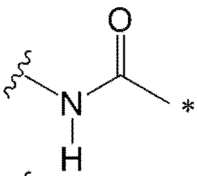

( L - 11 )

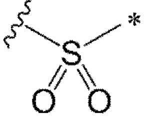

( L - 12 )

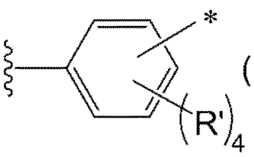

( L - 13 )

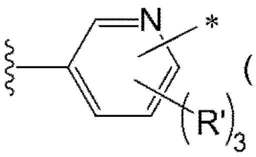

( L - 14 )

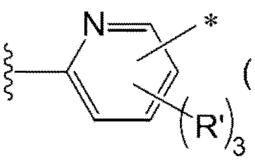

( L - 15 )

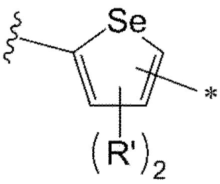

( L - 19 )

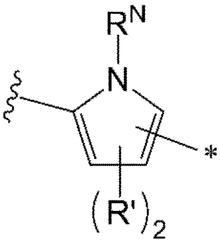

( L - 20 )

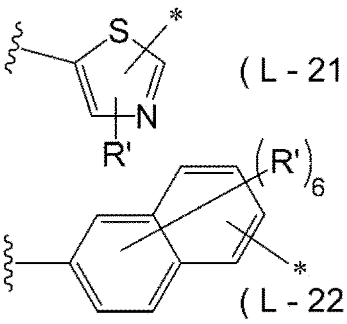

( L - 21 )

( L - 22 )

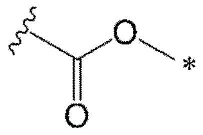 (L - 8)

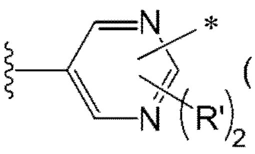 (L - 16)

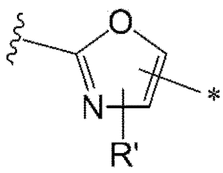 (L - 23)

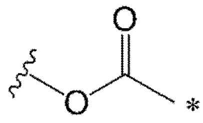 (L - 9)

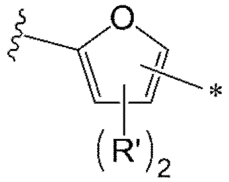 (L - 17)

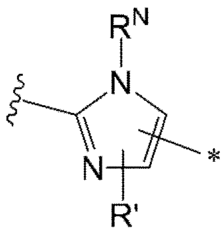 (L - 24)

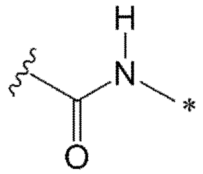 (L - 10)

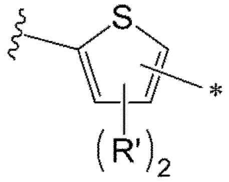 (L - 18)

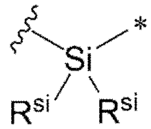 (L - 25)

in Formulae L-1 to L-25, * represents a bonding position for $R^w$, the portion of a wavy line represents the other bonding position, R' in Formulae L-1, L-2, L-6, and L-13 to L-24 each independently represents a hydrogen atom or a substituent, $R^N$ in Formulae L-20 and L-24 represents a hydrogen atom or a substituent, and $R^{si}$ in Formula L-25 each independently represents a hydrogen atom, an alkyl group, an alkenyl group, or an alkynyl group,

in Formula 2, $X^{2a}$ and $X^{2b}$ each independently represent $NR^{2i}$, an O atom, or a S atom, $A^{2a}$ represents $CR^{2g}$ or a N atom, $A^{2b}$ represents $CR^{2h}$ or a N atom, $R^{2i}$ represents a hydrogen atom, an alkyl group, an alkenyl group, an alkynyl group, or an acyl group, $R^{2a}$ to $R^{2h}$ each independently represent a hydrogen atom or a substituent, and at least one of $R^{2a}$, $R^{2b}$, $R^{2c}$, $R^{2d}$, $R^{2e}$, $R^{2f}$, $R^{2g}$, or $R^{2h}$ is a group represented by Formula W,

in Formula 3, $X^{3a}$ and $X^{3b}$ each independently represent a S atom, an O atom, or $NR^{3g}$, and $A^{3a}$ and $A^{3b}$ each independently represent $CR^{3h}$ or a N atom. $R^{3a}$ to $R^{3h}$ each independently represent a hydrogen atom or a substituent, and at least one of $R^{3a}$, $R^{3b}$, $R^{3c}$, $R^{3d}$, $R^{3e}$, $R^{3f}$, $R^{3g}$, or $R^{3h}$ is a group represented by Formula W,

in Formula 4, $X^{4a}$ and $X^{4b}$ each independently represent an O atom, a S atom, or a Se atom, 4p and 4q each independently represent an integer of 0 to 2, $R^{4a}$ to $R^{4j}$, $R^{4k}$, and $R^{4m}$ each independently represent a hydrogen atom, a halogen atom, or a group represented by Formula W, at least one of $R^{4a}$, $R^{4b}$, $R^{4c}$, $R^{4d}$, $R^{4e}$, $R^{4f}$, $R^{4g}$, $R^{4h}$, $R^{4i}$, $R^{4j}$, $R^{4k}$, or $R^{4m}$ is a group represented by Formula W. Here, in a case where at least one of $R^{4e}$ or $R^{4f}$ is a group represented by Formula W, $L^w$ in Formula W represented by $R^{4e}$ and $R^{4f}$ is a divalent linking group represented by Formula L-2 or L-3,

in Formula 5, $X^{5a}$ and $X^{5b}$ each independently represent $NR^{5i}$, an O atom, or a S atom, $A^{5a}$ represents $CR^{5g}$ or a N atom, $A^{5b}$ represents $CR^{5h}$ or a N atom, $R^{5i}$ represents a hydrogen atom, an alkyl group, an alkenyl group, an alkynyl group, an acyl group, an aryl group, or a heteroaryl group, $R^{5a}$ to $R^{5h}$ each independently represent a hydrogen atom or a substituent, and at least one of $R^{5a}$, $R^{5b}$, $R^{5c}$, $R^{5d}$, $R^{5e}$, $R^{5f}$ $R^{5g}$, or $R^{5h}$ is a group represented by Formula W,

in Formula 6, $X^{6a}$ to $X^{6d}$ each independently represent $NR^{6g}$, an O atom, or a S atom, $R^{6g}$ represents a hydrogen atom, an alkyl group, an alkenyl group, an alkynyl group, an acyl group, an aryl group, or a heteroaryl group, $R^{6a}$ to $R^{6f}$ each independently represent a hydrogen atom or a substituent, and at least one of $R^{6a}$, $R^{6b}$, $R^{6c}$, $R^{6d}$, $R^{6e}$, or $R^{6f}$ is a group represented by Formula W,

in Formula 7, $X^{7a}$ and $X^{7c}$ each independently represent a S atom, an O atom, a Se atom, or $NR^{7i}$, $X^{7b}$ and $X^{7d}$ each independently represent a S atom, an O atom, or a Se atom, $R^{7a}$ to $R^{7i}$ each independently represent a hydrogen atom or a substituent, and at least one of $R^{7a}$, $R^{7b}$, $R^{7c}$, $R^{7d}$, $R^{7e}$, $R^{7f}$, $R^{7g}$, $R^{7h}$, or $R^{7i}$ is a group represented by Formula W,

in Formula 8, $X^{8a}$ and $X^{8c}$ each independently represent a S atom, an O atom, a Se atom, or $NR^{8i}$, $X^{8b}$ and $X^{8d}$ each independently represent a S atom, an O atom, or a Se atom, $R^{8a}$ to $R^{8i}$ each independently represent a hydrogen atom or a substituent, and at least one of $R^{8a}$, $R^{8b}$, $R^{8c}$, $R^{8d}$, $R^{8e}$, $R^{8f}$, $R^{8g}$, $R^{8h}$, or $R^{8i}$ is a group represented by Formula W,

in Formula 9, $X^{9a}$ and $X^{9b}$ each independently represent an O atom, a S atom, or a Se atom, $R^{9c}$, $R^{9d}$, and $R^{9g}$ to $R^{9j}$ each independently represent a hydrogen atom, a halogen atom, or a group represented by Formula W, and $R^{9a}$, $R^{9b}$, $R^{ge}$, and $R^{9f}$ each independently represent a hydrogen atom or a substituent,

in Formula 10, $R^{10a}$ to $R^{10h}$ each independently represent a hydrogen atom or a substituent, at least one of

$R^{10a}$, $R^{10b}$, $R^{10c}$, $R^{10d}$, $R^{10e}$, $R^{10f}$ $R^{10g}$ or $R^{10h}$ represents a substituent represented by Formula W, $X^{10a}$ and $X^{10b}$ each independently represent a S atom, an O atom, a Se atom, or $NR^{10i}$, and $R^{10i}$ each independently represents a hydrogen atom or a group represented by Formula W,
in Formula 11, $X^{11a}$ and $X^{11b}$ each independently represent a S atom, an O atom, a Se atom, or $NR^{11n}$, $R^{11a}$ to $R^{11k}$, $R^{11m}$, and $R^{11n}$ each independently represent a hydrogen atom or a substituent, and at least one of $R^{11a}$, $R^{11b}$, $R^{11c}$, $R^{11d}$, $R^{11e}$, $R^{11f}$, $R^{11g}$, $R^{11h}$, $R^{11i}$, $R^{11j}$, $R^{11k}$, $R^{11m}$, or $R^{11n}$ is a group represented by Formula W,
in Formula 12, $X^{12a}$ and $X^{12b}$ each independently represent a S atom, an O atom, a Se atom, or $NR^{12n}$, $R^{12a}$ to $R^{12k}$, $R^{12m}$, and $R^{12n}$ each independently represent a hydrogen atom or a substituent, and at least one of $R^{12a}$, $R^{12b}$, $R^{12c}$, $R^{12d}$, $R^{12e}$, $R^{12f}$, $R^{12g}$, $R^{12h}$, $R^{12i}$, $R^{12j}$, $R^{12k}$, $R^{12m}$, or $R^{12n}$ is a group represented by Formula W.
in Formula 13, $X^{13a}$ and $X^{13b}$ each independently represent a S atom, an O atom, a Se atom, or $NR^{13n}$, $R^{13a}$ to $R^{13k}$, $R^{13m}$, and $R^{13n}$ each independently represent a hydrogen atom or a substituent, and at least one of $R^{13a}$, $R^{13b}$, $R^{13c}$, $R^{13d}$, $R^{13e}$, $R^{13f}$, $R^{13g}$, $R^{13h}$, $R^{13i}$, $R^{13j}$, R $R^{13m}$, or $R^{13n}$ is a group represented by Formula W,
in Formula 14, $X^{14a}$ to $X^{14c}$ each independently represent a S atom, an O atom, a Se atom or $NR^{14i}$, $R^{14a}$ to $R^{14i}$ each independently represent a hydrogen atom or a substituent, and at least one of $R^{14a}$, $R^{14b}$, $R^{14c}$, $R^{14d}$, $R^{14e}$, $R^{14f}$, $R^{14g}$, $R^{14h}$, or $R^{14i}$ is a group represented by Formula W,
in Formula 15, $X^{15a}$ to $X^{15d}$ each independently represent a S atom, an O atom, a Se atom, or $NR^{15g}$, $R^{15a}$ to $R^{15g}$ each independently represent a hydrogen atom or a substituent, and at least one of $R^{15a}$, $R^{15b}$, $R^{15c}$, $R^{15d}$, $R^{15e}$, $R^{15f}$, or $R^{15g}$ is a group represented by Formula W, and
in Formula 16, $X^{16a}$ to $X^{16d}$ each independently represent a S atom, an O atom, a Se atom, or $NR^{16g}$, $R^{16a}$ to $R^{16g}$ each independently represent a hydrogen atom or a substituent, and at least one of $R^{16a}$, $R^{16b}$, $R^{16c}$, $R^{16d}$, $R^{16e}$, $R^{16f}$, or $R^{16g}$ is a group represented by Formula W.

**6.** The organic semiconductor composition according to any one of claims 1 to 5,
wherein the organic solvent A is hexane, octane, nonane, decane, propylcyclohexane, toluene, xylene, mesitylene, ethylbenzene, decalin, tetralin, or amylbenzene.

**7.** The organic semiconductor composition according to claim 6,
wherein the organic solvent A is cis-decalin, tetralin, or amylbenzene.

**8.** The organic semiconductor composition according to any one of claims 1 to 7,
wherein the organic solvent B is dichloromethane, chloroform, tetrachloromethane, dichloroethane, trichloroethane, tetrachloroethane, chlorobenzene, dichlorobenzene, chlorotoluene, chloronaphthalene, fluoronaphthalene, difluoronaphthalene, dibutylether, tetrahydrofuran, dioxane, anisole, tert-butylanisole, or 2-methoxynaphthalene.

**9.** The organic semiconductor composition according to claim 8,
wherein the organic solvent B is 1,2-dichlorobenzene, 1-fluoronaphthalene, or anisole.

## Patentansprüche

**1.** Organische Halbleiterzusammensetzung, umfassend:

einen organischen Halbleiter, der eine kondensierte polycyclische aromatische Gruppe mit 4 oder mehr Ringen aufweist, wovon mindestens zwei Ringe mindestens ein Atom aufweisen, das ausgewählt ist aus der Gruppe bestehend aus einem Schwefelatom, einem Stickstoffatom, einem Selenatom und einem Sauerstoffatom, und der als eine Teilstruktur in der kondensierten polycyclischen aromatischen Gruppe mindestens eine Struktur aufweist, die ausgewählt ist aus der Gruppe bestehend aus einem Benzolring, einem Naphthalinring und einem Phenanthrenring;
ein organisches Lösungsmittel A; und
ein organisches Lösungsmittel B;
wobei, wenn der der Hansen-Löslichkeitsparameter (SP)-Wert des organischen Lösungsmittels A als SP(A) bezeichnet wird und der SP-Wert des organischen Lösungsmittels B als SP(B) bezeichnet wird, SP(B) - SP(A) $\geq 2\ MPa^{1/2}$ erfüllt ist,
**dadurch gekennzeichnet, dass** die organische Halbleiterzusammensetzung ferner ein Tensid umfasst, das eine durch $-O-SiR^1R^2-$ dargestellte organische Siloxaneinheit aufweist, worin die Menge des Tensids, bezogen auf 100 Masseteile des organischen Halbleiters, 0,1 bis 10 Masseteile beträgt;
und $R^1$ und $R^2$ jeweils unabhängig eine monovalente Kohlenwasserstoffgruppe darstellen, die keine Etherbindung enthält.

2. Organische Halbleiterzusammensetzung gemäß Anspruch 1, worin zumindest eines von $R^1$ oder $R^2$ eine lineare, verzweigte oder cyclische Alkylgruppe mit 2 bis 18 Kohlenstoffatomen oder eine lineare oder verzweigte oder cyclische Alkenylgruppe mit 2 bis 18 Kohlenstoffatomen ist.

3. Organische Halbleiterzusammensetzung gemäß Anspruch 1 oder 2, worin die Menge des organischen Lösungsmittels A 20 bis 100 Vol.-% beträgt, bezogen auf eine Menge von 100 Vol.-% des organischen Lösungsmittels B.

4. Organische Halbleiterzusammensetzung gemäß irgendeinem der Ansprüche 1 bis 3, worin der Siedepunkt bp(A) des organischen Lösungsmittels A und der Siedepunkt bp(B) des organischen Lösungsmittel (B) bp(A) < bp(B) erfüllen.

5. Organische Halbleiterzusammensetzung gemäß irgendeinem der Ansprüche 1 bis 4, worin der organische Halbleiter mindestens eine Art von Verbindung enthält, dargestellt durch irgendeine der Formeln 1 bis 16:

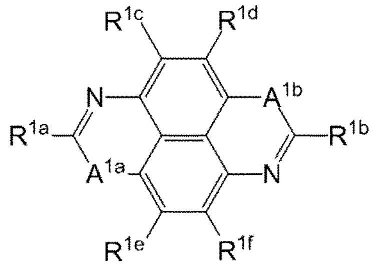
(1)

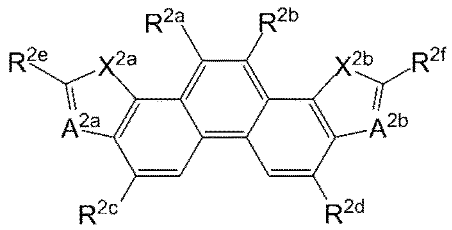
(2)

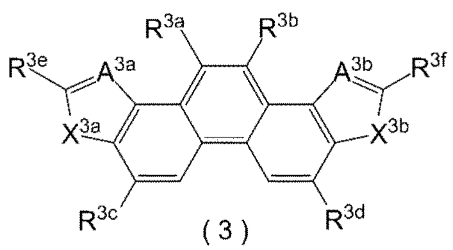
(3)

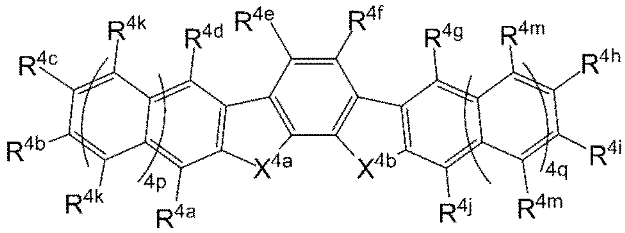
(4)

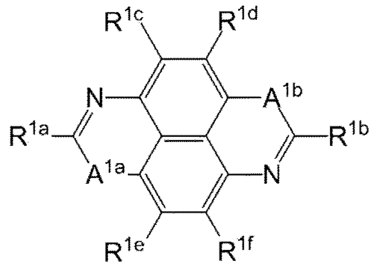
(1)

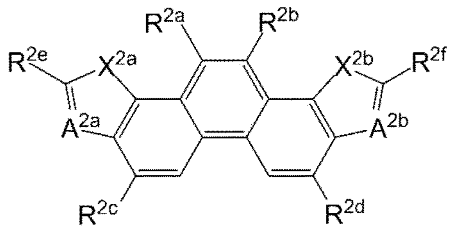
(2)

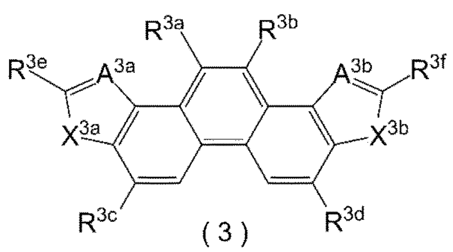
(3)

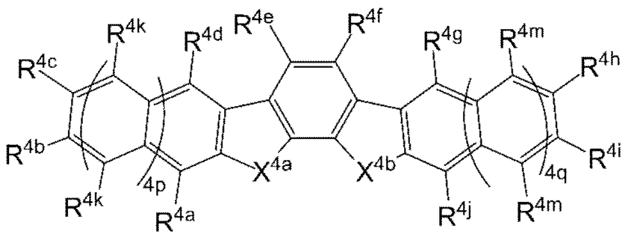
(4)

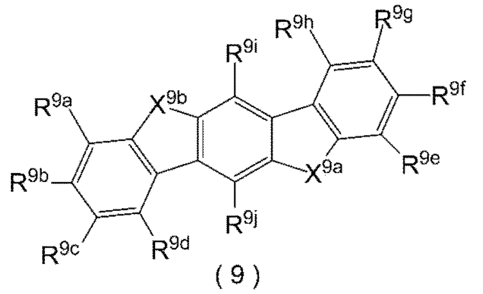

( 9 )

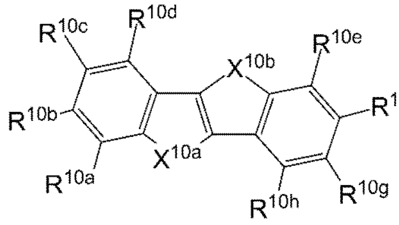

( 10 )

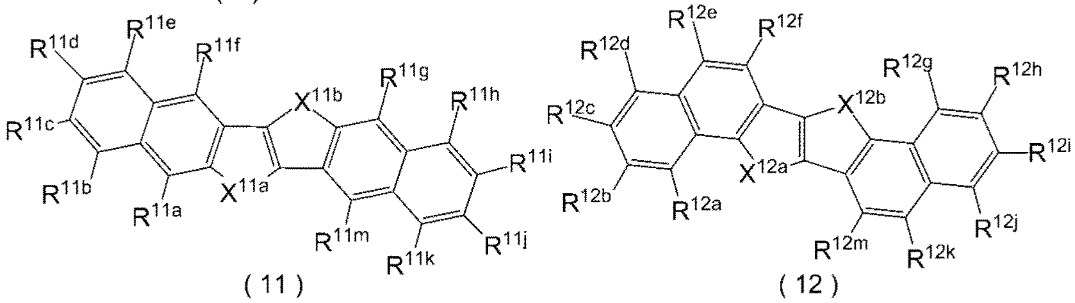

( 11 ) ( 12 )

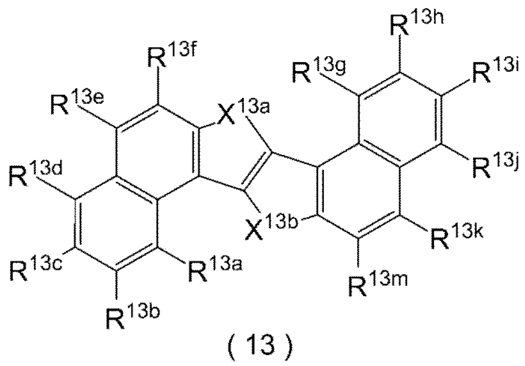

( 13 )

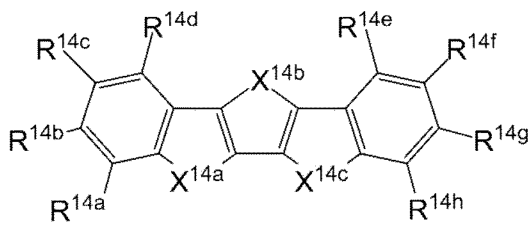

( 14 )

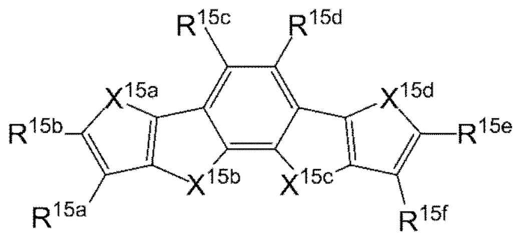

( 15 )

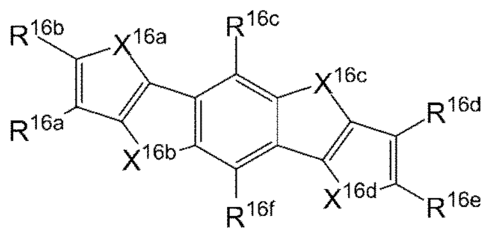

( 16 )

worin in Formel 1 $A^{1a}$ und $A^{1b}$ jeweils unabhängig ein S-Atom, ein O-Atom oder ein Se-Atom darstellen, $R^{1a}$ bis $R^{1f}$ jeweils unabhängig ein Wasserstoffatom oder einen Substituenten darstellen, und mindestens eines von $R^{1a}$, $R^{1b}$, $R^{1c}$, $R^{1d}$, $R^{1e}$ oder $R^{1f}$ eine durch die folgende Formel W dargestellte Gruppe ist:

$$-L^W-R^W \qquad (W)$$

worin, in der Formel W, $L^w$ eine divalente Verknüpfungsgruppe, die durch irgendeine der folgenden Formeln L-1 bis L-25 dargestellt ist, oder eine divalente Verknüpfungsgruppe, worin zwei oder mehr der durch irgendeine der folgenden Formeln L-1 bis L-25 dargestellten Verknüpfungsgruppen aneinander gebunden sind, darstellt, und $R^W$ eine Alkylgruppe, eine Cyanogruppe, eine Vinylgruppe, eine Ethinylgruppe, eine Oxyethylengruppe, eine Oligo-Oxyethylengruppe, worin die Widerholungsanzahl v einer Oxyethyleneinheit gleich oder größer als 2 ist, eine Siloxangruppe, eine Oligosiloxangruppe mit zwei oder mehr Siliciumatomen, oder eine Trialkylsilylgruppe ist

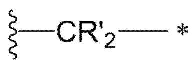 (L - 1)

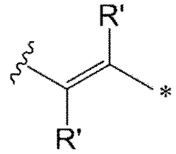 (L - 2)

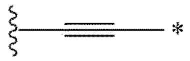 (L - 3)

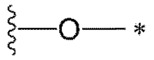 (L - 4)

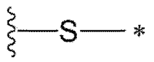 (L - 5)

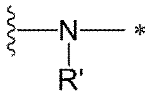 (L - 6)

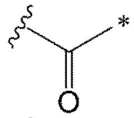 (L - 7)

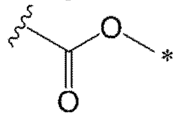 (L - 8)

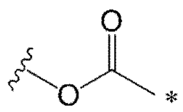 (L - 9)

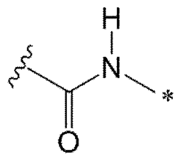 (L - 10)

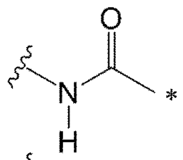 (L - 11)

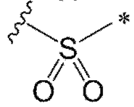 (L - 12)

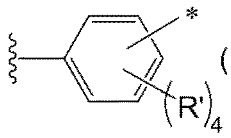 (L - 13)

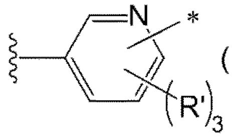 (L - 14)

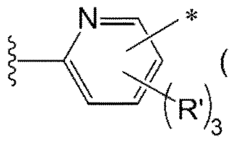 (L - 15)

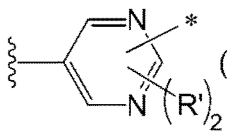 (L - 16)

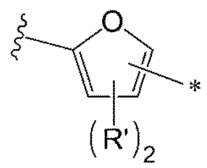 (L - 17)

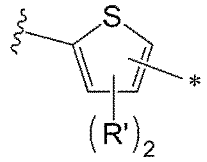 (L - 18)

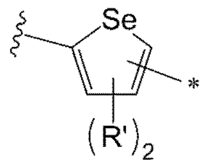 (L - 19)

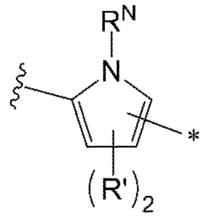 (L - 20)

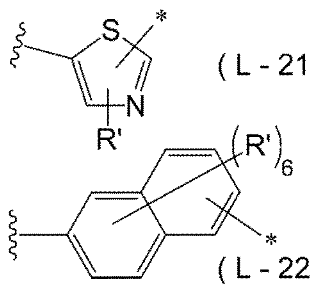 (L - 21) (L - 22)

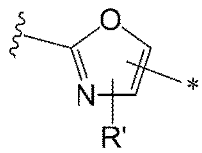 (L - 23)

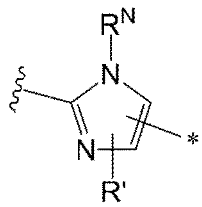 (L - 24)

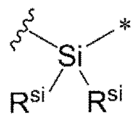 (L - 25)

worin in den Formeln L-1 bis L-25 * eine Bindungsposition für $R^W$ darstellt, der Teil einer gewellten Linie die andere Bindungsposition darstellt, R' in den Formeln L-1, L-2, L-6 und L-13 bis L-24 jeweils unabhängig ein Wasserstoffatom oder einen Substituenten darstellt, $R^N$ in den Formeln L-20 und L-24 ein Wasserstoffatom oder einen Substituenten darstellt, und $R^{si}$ in Formel L-25 jeweils unabhängig ein Wasserstoffatom, eine Alkylgruppe, eine Alkenylgruppe oder eine Alkinylgruppe darstellt,

in der Formel 2 $X^{2a}$ und $X^{2b}$ jeweils unabhängig $NR^{2i}$, ein O-Atom oder ein S-Atom darstellen, $A^{2a}$ $CR^{2g}$ oder ein N-Atom darstellt, $A^{2b}$ $CR^{2h}$ oder ein N-Atom darstellt, $R^{2i}$ ein Wasserstoffatom, eine Alkylgruppe, eine Alkenylgruppe, eine Alkinylgruppe oder eine Acylgruppe darstellt, $R^{2a}$ bis $R^{2h}$ jeweils unabhängig ein Wasserstoffatom oder einen Substituenten darstellen, und mindestens eines von $R^{2a}$, $R^{2b}$, $R^{2c}$, $R^{2d}$, $R^{2e}$, $R^{2f}$, $R^{2g}$ oder $R^{2h}$ eine durch die Formel W dargestellte Gruppe ist,

in der Formel 3 $X^{3a}$ und $X^{3b}$ jeweils unabhängig ein S-Atom, ein O-Atom oder $NR^{3g}$ darstellen, und $A^3$ und $A^{3b}$ jeweils unabhängig $CR^{3h}$ oder ein N-Atom darstellen, $R^{3a}$ bis $R^{3h}$ jeweils unabhängig ein Wasserstoffatom oder einen Substituenten darstellen, und zumindest eines von $R^{3a}$, $R^{3b}$, $R^{3c}$, $R^{3d}$, $R^{3e}$, $R^{3f}$, $R^{3g}$ oder $R^{3h}$ eine durch die Formel W dargestellte Gruppe ist,

in der Formel 4 $X^{4a}$ und $X^{4b}$ jeweils unabhängig ein O-Atom, ein S-Atom oder ein Se-Atom darstellen, 4p und 4q jeweils unabhängig eine ganze Zahl von 0 bis 2 darstellen, $R^{4a}$ bis $R^{4j}$, $R^{4k}$ und $R^{4m}$ jeweils unabhängig ein Wasserstoffatom, ein Halogenatom oder eine durch die Formel W dargestellte Gruppe darstellen, zumindest

eines von $R^{4a}$, $R^{4b}$, $R^{4c}$, $R^{4d}$, $R^{4e}$, $R^{4f}$, $R^{4g}$, $R^{4h}$, $R^{4i}$, $R^{4j}$, $R^{4k}$, $R^{41}$ oder $R^{4m}$ eine durch die Formel W dargestellte Gruppe ist, worin hier in dem Fall, dass mindestens eines von $R^{4c}$ oder $R^{4f}$ eine durch die Formel W dargestellte Gruppe ist, $L^{w}$ in der durch $R^{4c}$ und $R^{4f}$ dargestellten Formel W eine divalente Verknüpfungsgruppe ist, die durch die Formel L-2 oder L-3 dargestellt wird,

in der Formel 5 $X^{5a}$ und $X^{5b}$ jeweils unabhängig $NR^{5i}$, ein O-Atom oder ein S-Atom darstellen, $A^{5a}$ $CR^{5g}$ oder ein N-Atom darstellt, $A^{5b}$ $CR^{5h}$ oder ein N-Atom darstellt, $R^{5i}$ ein Wasserstoffatom, eine Alkylgruppe, eine Alkenylgruppe, eine Alkinylgruppe, eine Acylgruppe, eine Arylgruppe oder eine Heteroarylgruppe darstellt, $R^{5a}$ bis $R^{5h}$ jeweils unabhängig ein Wasserstoffatom, einen Substituenten darstellen, und mindestens eines von $R^{5a}$, $R^{5b}$, $R^{5c}$, $R^{5d}$, $R^{5e}$, $R^{5f}$, $R^{5g}$ oder $R^{5h}$ eine durch die Formel W dargestellte Gruppe ist,

in der Formel 6 $X^{6a}$ bis $X^{6d}$ jeweils unabhängig $NR^{6g}$, ein O-Atom oder ein S-Atom darstellen, $R^{6g}$ ein Wasserstoffatom, eine Alkylgruppe, eine Alkenylgruppe, eine Alkinylgruppe, eine Acylgruppe, eine Arylgruppe oder eine Heteroarylgruppe darstellt, $R^{6a}$ bis $R^{6f}$ jeweils unabhängig ein Wasserstoffatom oder einen Substituenten darstellen und mindestens eines von $R^{6a}$, $R^{6b}$, $R^{6c}$, $R^{6d}$, $R^{6e}$ oder $R^{6f}$ eine durch die Formel W dargestellte Gruppe ist,

in der Formel 7 $X^{7a}$ und $x^{7c}$ jeweils unabhängig ein S-Atom, ein O-Atom, ein Se-Atom oder $NR^{7i}$ darstellen, $X^{7b}$ und $X^{7d}$ jeweils unabhängig ein S-Atom, ein O-Atom oder ein Se-Atom darstellen, $R^{7a}$ bis $R^{7i}$ jeweils unabhängig ein Wasserstoffatom oder einen Substituenten darstellen, und mindestens eines von $R^{7a}$, $R^{7b}$, $R^{7c}$, $R^{7d}$, $R^{7e}$, $R^{7f}$, $R^{7g}$, $R^{7h}$ oder $R^{7i}$ eine durch die Formel W dargestellte Gruppe ist,

in der Formel 8 $X^{8a}$ und $X^{8c}$ jeweils unabhängig ein S-Atom, ein O-Atom, ein Se-Atom oder ein $NR^{8i}$ darstellen, $X^{8b}$ und $X^{8d}$ jeweils unabhängig ein S-Atom, ein O-Atom oder ein Se-Atom darstellen, $R^{8a}$ bis $R^{8i}$ jeweils unabhängig ein Wasserstoffatom oder einen Substituenten darstellen, und mindestens eines von $R^{8a}$, $R^{8b}$, $R^{8c}$, $R^{8d}$, $R^{8e}$, $R^{8f}$, $R^{8g}$, $R^{8h}$ oder $R^{8i}$ eine durch die Formel W dargestellte Gruppe ist,

in der Formel 9 $X^{9a}$ und $X^{9b}$ jeweils unabhängig ein O-Atom, ein S-Atom oder ein Se-Atom darstellen, $R^{9c}$, $R^{9d}$ und $R^{9g}$ bis $R^{9j}$ jeweils unabhängig ein Wasserstoffatom, ein Halogenatom oder eine durch die Formel W dargestellte Gruppe darstellen, und $R^{9a}$, $R^{9b}$, $R^{9e}$ und $R^{9f}$ jeweils unabhängig ein Wasserstoffatom oder einen Substituenten darstellen,

in der Formel 10 $R^{10a}$ bis $R^{10h}$ jeweils unabhängig ein Wasserstoffatom oder einen Substituenten darstellen, mindestens eines von $R^{10a}$, $R^{10b}$, $R^{10c}$, $R^{10d}$, $R^{10e}$, $R^{10f}$, $R^{10g}$ oder $R^{10h}$ einen durch die Formel W dargestellten Substituenten darstellen, $R^{10a}$ und $R^{10b}$ jeweils unabhängig ein S-Atom, ein O-Atom, ein Se-Atom oder $NR^{10i}$ darstellen und $R^{10i}$ jeweils unabhängig ein Wasserstoffatom oder eine durch die Formel W dargestellte Gruppe darstellt,

in der Formel 11 $X^{11a}$ und $X^{11b}$ jeweils unabhängig ein S-Atom, ein O-Atom, ein Se-Atom oder ein $NR^{11n}$ darstellen, $R^{11a}$, $R^{11k}$, $R^{11m}$ und $R^{11n}$ jeweils unabhängig ein Wasserstoffatom oder einen Substituenten darstellen, und zumindest eines von $R^{11a}$, $R^{11b}$, $R^{11c}$, $R^{11d}$, $R^{11e}$, $R^{11f}$ $R^{11g}$, $R^{11h}$, $R^{11i}$, $R^{11j}$, $R^{11k}$, $R^{11m}$ oder $R^{11n}$ eine durch die Formel W dargestellte Gruppe ist,

in der Formel 12 $X^{12a}$ und $X^{12b}$ jeweils unabhängig ein S-Atom, ein O-Atom, ein Se-Atom oder ein $NR^{12a}$ darstellen, $R^{12a}$ bis $R^{12k}$, $R^{12m}$ und $R^{12n}$ jeweils unabhängig ein Wasserstoffatom oder einen Substituenten darstellen, und zumindest eines von $R^{12a}$, $R^{12b}$, $R^{12c}$, $R^{12d}$, $R^{12e}$, $R^{12f}$, $R^{12g}$, $R^{12h}$, $R^{12i}$, $R^{12j}$, $R^{12k}$, $R^{12m}$ oder $R^{12n}$ eine durch die Formel W dargestellte Gruppe ist,

in der Formel 13 $X^{13a}$ und $X^{13b}$ jeweils unabhängig ein S-Atom, ein O-Atom, ein Se-Atom oder $NR^{13n}$ darstellen, $R^{13a}$ bis $R^{13k}$, $R^{13m}$ und $R^{13n}$ jeweils unabhängig ein Wasserstoffatom oder einen Substituenten darstellen, und zumindest eines von $R^{13a}$, $R^{13b}$, $R^{13c}$, $R^{13d}$, $R^{13e}$, $R^{13f}$, $R^{13g}$, $R^{13h}$, $R^{13i}$, $R^{13j}$, $R^{13k}$, $R^{13m}$ oder $R^{13n}$ eine durch die Formel W dargestellte Gruppe ist,

in der Formel 14 $X^{14a}$ bis $X^{14c}$ jeweils unabhängig ein S-Atom, ein O-Atom, ein Se-Atom oder $NR^{14i}$ darstellen, $R^{14a}$ bis $R^{14i}$ jeweils unabhängig ein Wasserstoffatom oder einen Substituenten darstellen, und zumindest eines von $R^{14a}$, $R^{14b}$, $R^{14c}$, $R^{14d}$, $R^{14e}$, $R^{14f}$, $R^{14g}$, $R^{14h}$ oder $R^{14i}$ eine durch die Formel W dargestellte Gruppe ist,

in der Formel 15 $X^{15a}$ bis $X^{15d}$ jeweils unabhängig ein S-Atom, ein O-Atom, ein Se-Atom oder $NR^{15g}$ darstellen, $R^{15a}$ bis $R^{15g}$ jeweils unabhängig ein Wasserstoffatom oder einen Substituenten darstellen, und zumindest eines von $R^{15a}$, $R^{15b}$, $R^{15c}$, $R^{15d}$, $R^{15e}$, $R^{15f}$ oder $R^{15g}$ eine durch die Formel W dargestellte Gruppe ist,

in der Formel 16 $X^{16a}$ bis $X^{16d}$ jeweils unabhängig ein S-Atom, ein O-Atom, ein Se-Atom oder $NR^{16g}$ darstellen, $R^{16a}$ bis $R^{16g}$ jeweils unabhängig ein Wasserstoffatom oder einen Substituenten darstellen, und zumindest eines von $R^{16a}$, $R^{16b}$, $R^{16c}$, $R^{16d}$, $R^{16e}$, $R^{16f}$ oder $R^{16g}$ eine durch die Formel W dargestellte Gruppe ist.

**6.** Organische Halbleiterzusammensetzung gemäß irgendeinem der Ansprüche 1 bis 5, worin das organische Lösungsmittel A Hexan, Octan, Nonan, Decan, Propylcyclohexan, Toluol, Xylol, Mesitylen, Ethylbenzol, Decalin, Tetralin oder Amylbenzol ist.

**7.** Organische Halbleiterzusammensetzung gemäß Anspruch 6, worin das organische Lösungsmittel A cis-Decalin,

Tetralin oder Amylbenzol ist.

8. Organische Halbleiterzusammensetzung gemäß irgendeinem der Ansprüche 1 bis 7, worin das organische Lösungsmittel B Dichloromethan, Chloroform, Tetrachlormethan, Dichlorethan, Trichlorethan, Tetrachlorethan, Chlorbenzol, Dichlorbenzol, Chlortoluol, Chlornaphthalin, Fluornaphthalin, Difluornaphthalin, Dibutylether, Tetrahydrofuran, Dioxan, Anisol, tert-Butylanisol oder 2-Methoxynaphthalin ist.

9. Organische Halbleiterzusammensetzung gemäß Anspruch 8, worin das organische Lösungsmittel B 1,2-Dichlorbenzol, 1-Fluornaphthalin oder Anisol ist.

## Revendications

1. Composition à semi-conducteur organique comprenant :

   un semi-conducteur organique qui présente un groupe aromatique polycyclique condensé présentant 4 cycles ou plus, parmi lesquels au moins deux cycles présentent au moins un atome choisi dans le groupe consistant en un atome de soufre, un atome d'azote, un atome de sélénium et un atome de Oxygène, et présente au moins une structure choisie dans le groupe consistant en un cycle benzène, d'un cycle naphtalène et un cycle phénanthrène en tant que structure partielle dans le groupe aromatique polycyclique condensé ;
   un solvant organique A ; et
   un solvant organique B ;
   dans laquelle dans un cas où une valeur de paramètre de solubilité Hansen (SP) du solvant organique A est désignée par SP(A) et une valeur SP du solvant organique B est désignée par SP(B), $SP(B) - SP(A) \geq 2\ MPa^{1/2}$ est satisfaite,
   **caractérisée en ce que** la composition à semi-conducteur organique comprend en outre un tensioactif présentant une fraction siloxane organique représentée par $-O-SiR^1R^2-$, dans laquelle une teneur du tensioactif est de 0,1 à 10 parties en masse par rapport à une teneur de 100 parties en masse du semi-conducteur organique ;
   et $R^1$ et $R^2$ représentent chacun indépendamment un groupe hydrocarboné monovalent ne contenant pas de liaison éther.

2. Composition à semi-conducteur organique selon la revendication 1,
   dans laquelle au moins l'un de $R^1$ ou $R^2$ est un groupe alkyle linéaire, ramifié ou cyclique présentant de 2 à 18 atomes de carbone, ou un groupe alcényle linéaire, ramifié ou cyclique présentant de 2 à 18 atomes de carbone.

3. Composition à semi-conducteur organique selon la revendication 1 ou 2,
   dans laquelle une teneur du solvant organique A est de 20 % à 100 % en volume par rapport à une teneur de 100 % en volume du solvant organique B.

4. Composition à semi-conducteur organique selon l'une quelconque des revendications 1 à 3,
   dans laquelle un point d'ébullition bp(A) du solvant organique A et un point d'ébullition bp(B) du solvant organique B satisfont bp(A) < bp(B).

5. Composition à semi-conducteur organique selon l'une quelconque des revendications 1 à 4,

   dans laquelle le semi-conducteur organique contient au moins un type de composé représenté par l'une quelconque des formules 1 à 16,

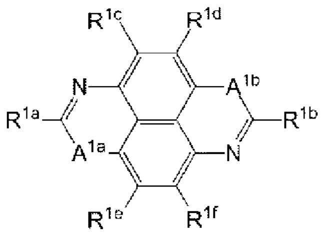

(1)

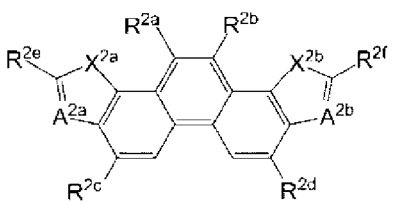

(2)

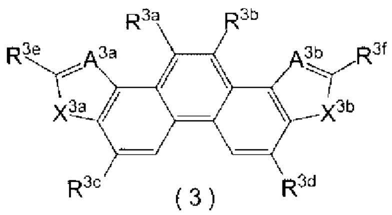

( 3 )

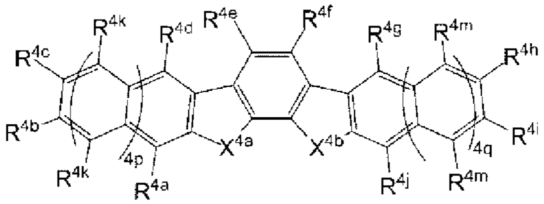

( 4 )

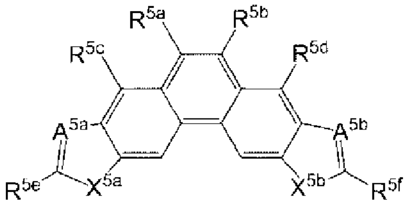

( 5 )

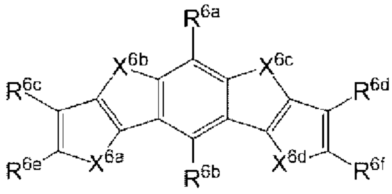

( 6 )

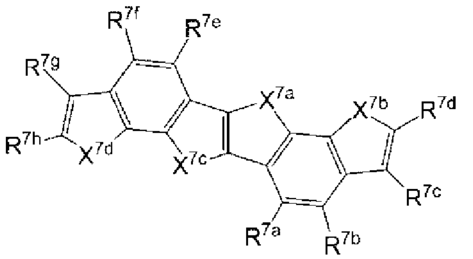

( 7 )

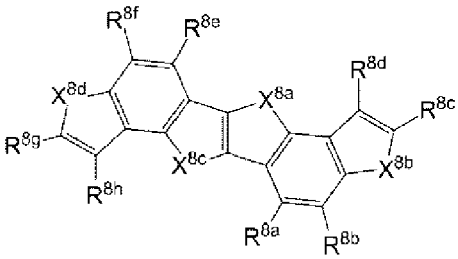

( 8 )

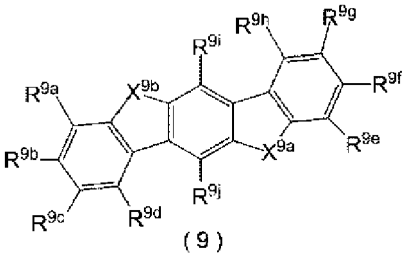

( 9 )

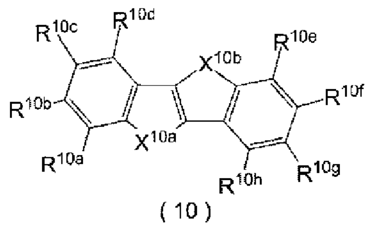

( 10 )

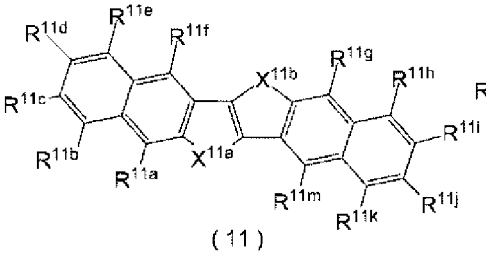

( 11 )

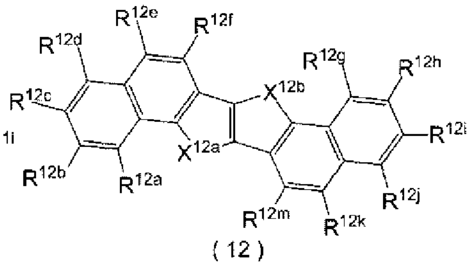

( 12 )

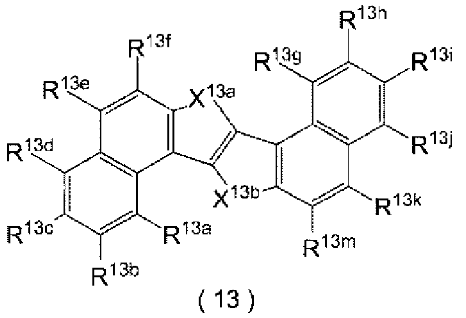

( 13 )

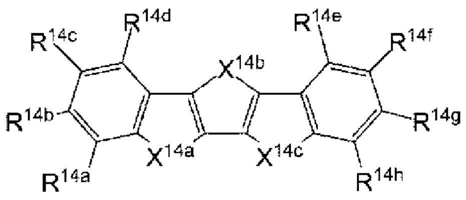

( 14 )

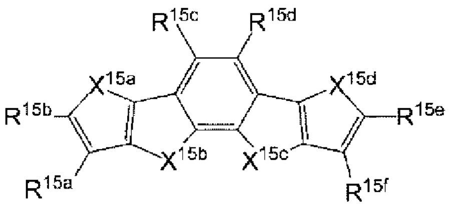

( 15 )

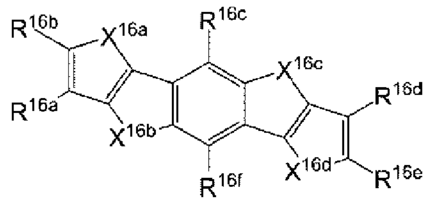

( 16 )

dans la formule 1, $A^{1a}$ et $A^{1b}$ représentent chacun indépendamment un atome de S, un atome de O ou un atome de Se, $R^{1a}$ à $R^{1f}$ représentent chacun indépendamment un atome d'hydrogène ou un substituant, et au moins un parmi $R^{1a}$, $R^{1b}$, $R^{1c}$, $R^{1d}$, $R^{1e}$, ou $R^{1f}$ est un groupe représenté par la formule W suivante,

$$-L^{W}-R^{W} \qquad (W)$$

dans la formule W, $L^W$ représente un groupe de liaison divalent qui est représenté par l'une quelconque des formules L-1 à L-25 suivantes ou un groupe de liaison divalent dans laquelle deux groupes de liaison divalents ou plus représentés par l'une quelconque des formules L- 1 à L-25 suivantes sont liés les uns aux autres, et $R^W$ représente un groupe alkyle, un groupe cyano, un groupe vinyle, un groupe éthynyle, un groupe oxyéthylène, un groupe oligo-oxyéthylène dans laquelle un nombre de répétition v d'un motif oxyéthylène est égal ou supérieur à 2, un groupe siloxane, un groupe oligosiloxane présentant deux atomes de silicium ou plus, ou un groupe trialkylsilyle,

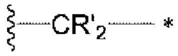

( L - 1 )

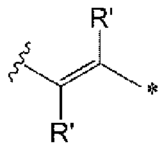

( L - 2 )

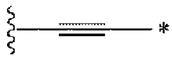

( L - 3 )

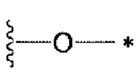

( L - 4 )

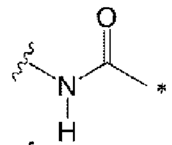

( L - 11 )

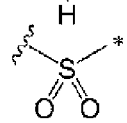

( L - 12 )

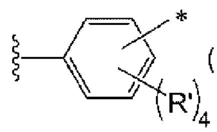

( L - 13 )

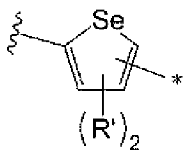

( L - 19 )

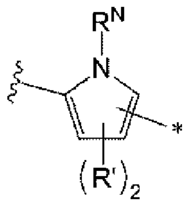

( L - 20 )

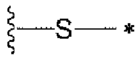 (L-5)

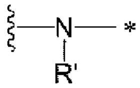 (L-6)

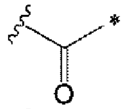 (L-7)

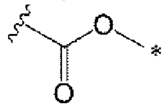 (L-8)

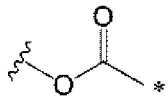 (L-9)

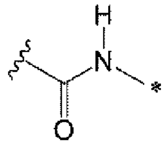 (L-10)

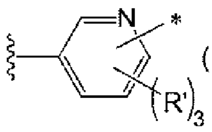 (L-14)

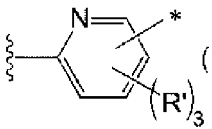 (L-15)

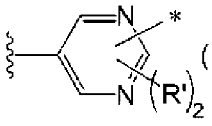 (L-16)

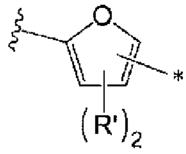 (L-17)

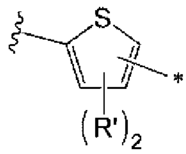 (L-18)

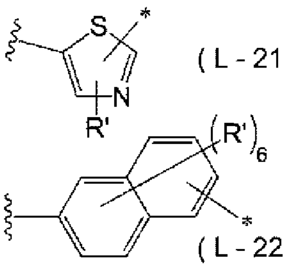 (L-21) (L-22)

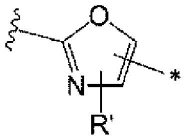 (L-23)

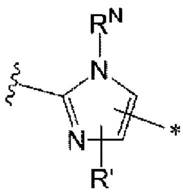 (L-24)

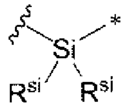 (L-25)

dans les formules L-1 à L-25, * représente une position de liaison pour $R^w$, la partie d'une ligne ondulée représente l'autre position de liaison, chaque R' dans les formules L-1, L-2, L-6 et L-13 à L-24 représente indépendamment un atome d'hydrogène ou un substituant, $R^N$ dans les formules L-20 et L-24 représente un atome d'hydrogène ou un substituant, et chaque $R^{Si}$ dans la formule L-25 représente indépendamment un atome d'hydrogène, un groupe alkyle, un groupe alcényle, ou un groupe alcynyle,

dans la Formule 2, $X^{2a}$ et $X^{2b}$ représentent chacun indépendamment $NR^{2i}$, un atome de O ou un atome de S, $A^{2a}$ représente $CR^{2g}$ ou un atome de N, $A^{2b}$ représente $CR^{2h}$ ou un atome de N, $R^{2i}$ représente un atome d'hydrogène, un groupe alkyle, un groupe alcényle, un groupe alcynyle ou un groupe acyle, $R^{2a}$ à $R^{2h}$ représentent chacun indépendamment un atome d'hydrogène ou un substituant, et au moins un parmi $R^{2a}$, $R^{2b}$, $R^{2c}$, $R^{2d}$, $R^{2c}$, $R^{2f}$, $R^{2g}$ ou $R^{2h}$ est un groupe représenté par la formule W,

dans la Formule 3, $X^{3a}$ et $X^{3b}$ représentent chacun indépendamment un atome de S, un atome de O ou $NR^{3g}$, et $A^{3a}$ et $A^{3b}$ représentent chacun indépendamment $CR^{3h}$ ou un atome de N. $R^{3a}$ à $R^{3h}$ représentent chacun indépendamment un atome d'hydrogène ou un substituant, et au moins un parmi $R^{3a}$, $R^{3b}$, $R^{3c}$, $R^{3d}$, $R^{3c}$, $R^{3f}$, $R^{3g}$ ou $R^{3h}$ est un groupe représenté par la formule W,

dans la Formule 4, $X^{4a}$ et $X^{4b}$ représentent chacun indépendamment un atome de O, un atome de S ou un atome de Se, 4p et 4q représentent chacun indépendamment un nombre entier de 0 à 2, $R^{4a}$ à $R^{4j}$, $R^{4k}$ et $R^{4m}$ représentent chacun indépendamment un atome d'hydrogène, un atome d'halogène ou un groupe représenté par la formule W, au moins un parmi $R^{4a}$, $R^{4b}$, $R^{4c}$, $R^{4d}$, $R^{4c}$, $R^{4f}$, $R4^{g}$, $R^{4h}$, $R^{4'}$, $R^{4j}$, $R^{4k}$ ou $R^{4m}$ est un groupe représenté par la formule W. Ici, dans un cas où au moins un parmi $R^{4e}$ ou $R^{4f}$ est un groupe représenté par la formule W, $L^w$ dans la formule W représenté par $R^{4e}$ et $R^{4f}$ est un groupe de liaison divalent représenté par la formule L-2 ou L-3,

dans la formule 5, $X^{5a}$ et $X^{5b}$ représentent chacun indépendamment $NR^{5i}$, un atome de O ou un atome de S, $A^{5a}$ représente $CR^{5g}$ ou un atome de N, $A^{5b}$ représente $CR^{5h}$ ou un atome de N, $R^{5i}$ représente un atome d'hydrogène, un groupe alkyle, un groupe alcényle, un groupe alcynyle, un groupe acyle, un groupe aryle ou un groupe hétéroaryle, $R^{5a}$ à $R^{5h}$ représentent chacun indépendamment un atome d'hydrogène ou un substituant, et au moins un parmi $R^{5a}$, $R^{5b}$, $R^{5c}$, $R^{5d}$, $R^{5c}$, $R^{5f}$, $R^{5g}$, ou $R^{5h}$ est un groupe représenté par la formule W,

dans la formule 6, $X^{6a}$ à $X^{6d}$ représentent chacun indépendamment $NR^{6g}$, un atome de O ou un atome de S, $R^{6g}$ représente un atome d'hydrogène, un groupe alkyle, un groupe alcényle, un groupe alcynyle, un groupe acyle, un groupe aryle ou un groupe hétéroaryle, $R^{6a}$ à $R^{6f}$ représentent chacun indépendamment un atome d'hydrogène ou un substituant, et au moins un parmi $R^{6a}$, $R^{6b}$, $R^{6c}$, $R^{6d}$, $R^{6e}$ ou $R^{6f}$ est un groupe représenté par la formule W,

dans la Formule 7, $X^{7a}$ et $X^{7c}$ représentent chacun indépendamment un atome de S, un atome de O, un atome de Se, ou $NR^{7i}$, $X^{7b}$ et $X^{7d}$ représentent chacun indépendamment un atome de S, un atome de O ou un atome

de Se, $R^{7A}$ à $R^{7i}$ représentent chacun indépendamment un atome d'hydrogène ou un substituant, et au moins un parmi $R^{7a}$, $R^{7b}$, $R^{7c}$, $R^{7d}$, $R^{7e}$, $R^{7f}$, $R^{7g}$, $R^{7h}$ ou $R^{7i}$ est un groupe représenté par la formule W,

dans la Formule 8, $X^{8a}$ et $X^{8c}$ représentent chacun indépendamment un atome de S, un atome de O, un atome de Se, ou $NR^{8i}$, $X^{8b}$ et $X^{8d}$ représentent chacun indépendamment un atome de S, un atome de O ou un atome de Se, $R^{8a}$ à $R^{8i}$ représentent chacun indépendamment un atome d'hydrogène ou un substituant, et au moins un parmi $R^{8a}$, $R^{8b}$, $R^{8C}$, $R^{8d}$, $R^{8c}$, $R^{8f}$, $R^{8g}$, $R^{8h}$ ou $R^{8i}$ est un groupe représenté par la formule W,

dans la Formule 9, $X^{9a}$ et $X^{9b}$ représentent chacun indépendamment un atome de O, un atome de S, ou un atome de Se,

$R^{9c}$, $R^{9d}$ et $R^{9g}$ à $R^{9j}$ représentent chacun indépendamment un atome d'hydrogène, un atome d'halogène ou un groupe représenté par la formule W, et $R^{9a}$, $R^{9b}$, $R^{9e}$ et $R^{9f}$ représentent chacun indépendamment un atome d'hydrogène ou un substituant,

dans la formule 10, $R^{10a}$ à $R^{10h}$ représentent chacun indépendamment un atome d'hydrogène ou un substituant, au moins un parmi $R^{10a}$, $R^{10b}$, $R^{10c}$, $R^{10d}$, $R^{10e}$, $R^{10f}$, $R^{10g}$ ou $R^{10h}$ représente un substituant représenté par la formule W, $X^{10a}$ et $X^{10b}$ chacun indépendamment représentent un atome de S, un atome de O, un atome de Se ou $NR^{10i}$, et $R^{10i}$ représente chacun indépendamment un atome d'hydrogène ou un groupe représenté par la formule W,

dans la formule 11, $X^{11a}$ et $X^{11b}$ représentent chacun indépendamment un atome de S, un atome de O, un atome de Se ou $NR^{11n}$, $R^{11a}$ à $R^{11k}$, $R^{11m}$ et $R^{11n}$ représentent chacun indépendamment un atome d'hydrogène ou un substituant, et au moins un parmi $R^{11a}$, $R^{11b}$, $R^{11c}$, $R^{11d}$, $R^{11e}$, $R^{11f}$, $R^{11g}$, $R^{11h}$, $R^{111}$, $R^{11j}$, $R^{11k}$, $R^{11m}$ ou $R^{11n}$ est un groupe représenté par la formule W,

dans la formule 12, $X^{12a}$ et $X^{12b}$ représentent chacun indépendamment un atome de S, un atome de O, un atome de Se, ou $NR^{12n}$, $R^{12a}$ à $R^{12k}$, $R^{12m}$ et $R^{12n}$ représentent chacun indépendamment un atome d'hydrogène ou un substituant, et au moins un parmi $R^{12a}$, $R^{12b,}$ $R^{12c}$, $R^{12d,}$ $R^{12e,}$ $R^{12f}$, $R^{12g,}$ $R^{12h,}$ $R^{12i,}$ $R^{12j,}$ $R^{12k}$, $R^{12m}$ ou $R^{12n}$ est un groupe représenté par la Formule W.

dans la formule 13, $X^{13a}$ et $X^{13b}$ représentent chacun indépendamment un atome de S, un atome de O, un atome de Se, ou $NR^{13n}$, $R^{13a}$ à $R^{13k}$, $R^{13m}$ et $R^{13n}$ représentent chacun indépendamment un atome d'hydrogène ou un substituant, et au moins un parmi $R^{13a}$ , $R^{13b}$, $R^{13c}$, $R^{13d}$, $R^{13e}$, $R^{13f}$, $R^{13g}$, $R^{13h}$, $R^{13i}$, $R^{13j}$ $R^{13k}$, $R^{13m}$ ou $R^{13n}$ est un groupe représenté par la formule W,

dans la formule 14, $X^{14a}$ à $X^{14c}$ représentent chacun indépendamment un atome de S, un atome de O, un atome de Se ou $NR^{14i}$, $R^{14a}$ à $R^{14i}$ représentent chacun indépendamment un atome d'hydrogène ou un substituant, et au moins un parmi $R^{14a}$, $R^{14b}$, $R^{14c}$, $R^{14d}$, $R^{14e}$, $R^{14f}$, $R^{14g}$, $R^{14h}$ ou $R^{14i}$ est un groupe représenté par la formule W,

dans la formule 15, $X^{15a}$ à $X^{15d}$ représentent chacun indépendamment un atome de S, un atome de O, un atome de Se ou $NR^{15g}$, $R^{15a}$ à $R^{15g}$ représentent chacun indépendamment un atome d'hydrogène ou un substituant, et au moins un parmi $R^{15a}$, $R^{15b}$, $R^{15c}$, $R^{15d}$, $R^{15e}$, $R^{15f}$ ou $R^{15g}$ est un groupe représenté par la formule W, et

dans la formule 16, $X^{16a}$ à $X^{16d}$ représentent chacun indépendamment un atome de S, un atome de O, un atome de Se ou $NR^{16g}$, $R^{16a}$ à $R^{16g}$ représentent chacun indépendamment un atome d'hydrogène ou un substituant, et au moins un parmi $R^{16a}$, $R^{16b}$, $R^{16c}$, $R^{16d}$, $R^{16e}$, $R^{16f}$ ou $R^{16g}$ est un groupe représenté par la formule W.

**6.** Composition à semi-conducteur organique selon l'une quelconque des revendications 1 à 5,
dans laquelle le solvant organique A est l'hexane, l'octane, le nonane, le décane, le propylcyclohexane, le toluène, le xylène, le mésitylène, l'éthylbenzène, la décaline, la tétraline ou l'amylbenzène.

**7.** Composition à semi-conducteur organique selon la revendication 6,
dans laquelle le solvant organique A est la cis-décaline, la tétraline ou l'amylbenzène.

**8.** Composition à semi-conducteur organique selon l'une quelconque des revendications 1 à 7,
dans laquelle le solvant organique B est le dichlorométhane, le chloroforme, le tétrachlorométhane, le dichloroéthane, le trichloroéthane, le tétrachloroéthane, le chlorobenzène, le dichlorobenzène, le chlorotoluène, le chloronaphtalène, le fluoronaphthalène, le difluoronaphtalène, le dibutyléther, le tétrahydrofurane, le dioxane, l'anisole, le tert-butylanisole ou le 2-méthoxynaphtalène.

**9.** Composition à semi-conducteur organique selon la revendication 8,
dans laquelle le solvant organique B est le 1,2-dichlorobenzène, le 1-fluoronaphtalène ou l'anisole.

FIG. 1

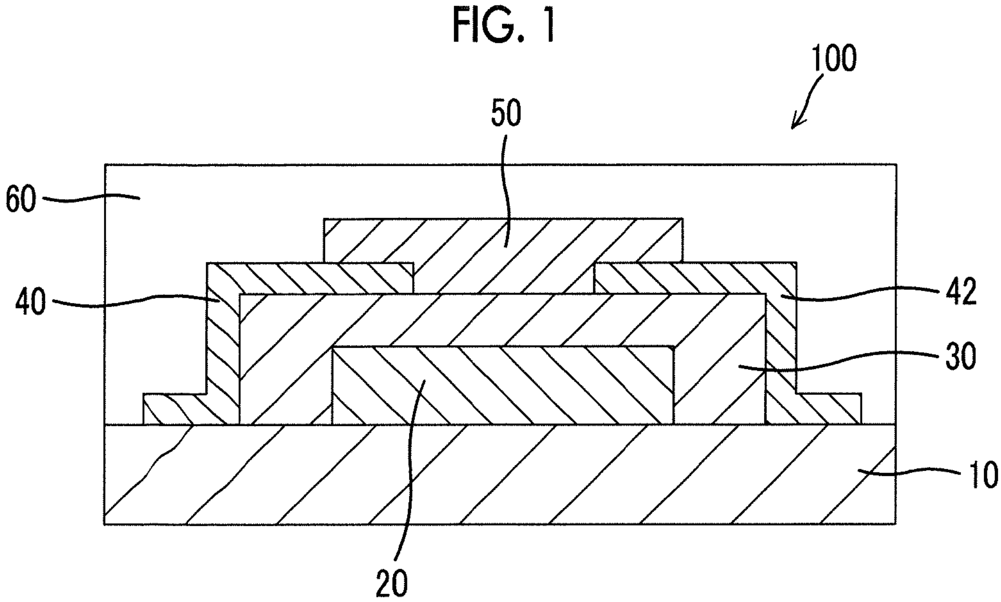


FIG. 2

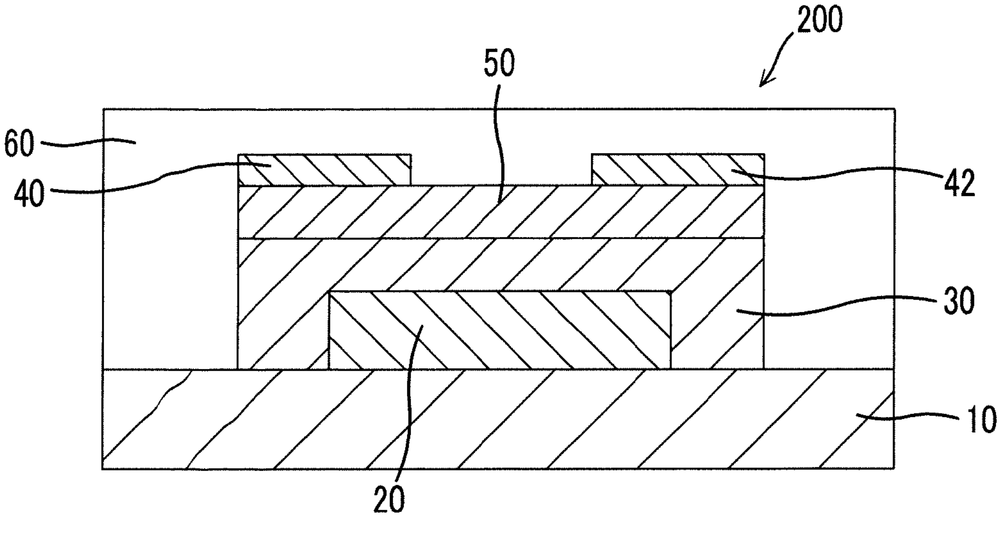

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2005514726 A
- WO 2014136436 A1
- JP 2012513459 A
- JP 2011046687 A
- EP 2251342 A
- EP 2301926 A
- EP 2301921 A
- KR 1020120120886 A
- WO 2005087780 A
- JP 2009190999 A
- JP 2012206953 A


### Non-patent literature cited in the description


- **C. M. HANSEN.** A User's Handbook, Second Edition. Taylor and Francis Group, LLC, 2007
- Hansen Solubility Parameter in Practice, HSPiP
- *Journal of American Chemical Society,* 1994, vol. 116, 925
- *Journal of Chemical Society,* 1951, 221
- *Org. Lett.,* 2001, vol. 3, 3471
- *Macromolecules,* 2010, vol. 43, 6264
- *Tetrahedron,* 2002, vol. 58, 10197
- *Journal of Chemical Research. Miniprint,* 1991, vol. 3, 601-635
- *Bull. Chem. Soc. Japan,* 1991, vol. 64, 3682-3686
- *Tetrahedron Letters,* 2004, vol. 45, 2801-2803
- *J. Org. Chem.,* 2011, 696
- *J. Org. Chem.,* 2013, vol. 78, 7741
- *Chem. Eur. J.,* 2013, vol. 19, 3721
- *Bull. Chem. Soc. Jpn.,* 1987, vol. 60, 4187
- *J. Am. Chem. Soc.,* 2011, vol. 133, 5024
- *Macromolecules,* 2010, vol. 43, 6264-6267
- *J. Am. Chem. Soc.,* 2012, vol. 134, 16548-16550
- **C. M. HANSEN.** A User's Handbook. Taylor and Francis Group, LLC, 2007
- *Journal of Chemical Research,* 1991, vol. 3, 601-635
- *Bull. Chem. Soc. Japan,* 1987, vol. 60, 4187
- *J. Am, Chem. Soc.,* 2012, vol. 134, 16548-16550
- **K. MUELLEN.** *Chem. Commun.,* 2008, 1548-1550
- **K. TAKIMIYA.** *Org. Lett.,* 2007, vol. 9, 4499-4502
- **RAO; TILAK.** *Journal of Scientific and Industrial Research,* 1958, vol. 17 B, 260-265
- **GHAISAS; TILAK.** *Journal of Scientific and Industrial Research,* 1955, vol. 14 B, 11
- *Journal of American Chemical Society,* 2007, vol. 129, 15732